# EUROPÄISCHE PATENTSCHRIFT

(11) **EP 1 619 515 B1**
(45) Veröffentlichungstag und Bekanntmachung des Hinweises auf die Patenterteilung: **21.04.2010**
(21) Anmeldenummer: 05106944.1
(22) Anmeldetag: 19.01.2001
(51) Int. Cl.: G01R 35/00, H03M 1/06

(54) **Vorrichtung und Verfahren zur Kompensation von Fehlern in einer Referenzspannung**
Apparatus and method for compensation of errors in a reference voltage
Appareil et procédé pour la compensation d'erreurs d'une tension de référence

(30) Priorität: 04.02.2000 DE 10004996
(43) Veröffentlichungstag der Anmeldung: 25.01.2006
(62) Teilanmeldung aus: 01909504.1
(73) Patentinhaber: Infineon Technologies AG, 81669 München (DE)
(72) Erfinder: Engl, Bernhard, 83071 Stephanskirchen (DE)
(74) Vertreter: Jannig, Peter

(56) Entgegenhaltungen:
- EP-A- 0 729 233
- US-A- 5 821 795
- PATENT ABSTRACTS OF JAPAN Bd. 009, Nr. 010 (E-290), 17. Januar 1985 (1985-01-17) & JP 59 160317 A (YOKOGAWA HOKUSHIN DENKI KK), 11. September 1984 (1984-09-11)
- PATENT ABSTRACTS OF JAPAN Bd. 014, Nr. 230 (P-1048), 16. Mai 1990 (1990-05-16) & JP 02 055346 A (MITA IND CO LTD), 23. Februar 1990 (1990-02-23)

## Beschreibung

Die vorliegende Erfindung betrifft eine Vorrichtung gemäß dem Oberbegriff des Anspruchs 1 und ein Verfahren gemäß dem Oberbegriff des Anspruchs 6.

Es sind bereits diverse Vorrichtungen und Verfahren dieser Art bekannt; eine kleine Auswahl der Dokumente, die sich mit solchen Vorrichtungen und Verfahren befassen, sind dem beiliegenden Literaturverzeichnis entnehmbar.

Ein Beispiel bei dem der Offset eines Komparators in einem AD Umsetzen kompensiert wird und bei dem eine Widerstandstelle die Referenzspannungen liefert wird in EP 729 233 offenbart.

Die bekannten Vorrichtungen und Verfahren weisen den Nachteil auf, daß sie nur mit sehr großem Aufwand zu realisieren sind, und/oder daß sie nicht so schnell und/oder genau arbeiten wie es in vielen Fällen wünschenswert wäre.

Der vorliegenden Erfindung liegt daher die Aufgabe zugrunde, eine Vorrichtung gemäß dem Oberbegriff des Anspruchs 1 und ein Verfahren gemäß dem Oberbegriff des Anspruchs 6 zu finden, welche einfach realisierbar sind und dennoch eine schnelle und genaue Kompensation von Fehlern ermöglicht.

Diese Aufgabe wird erfindungsgemäß durch die in Anspruch 1 beanspruchte Vorrichtung und das in Anspruch 6 beanspruchte Verfahren gelöst.

Vorteilhafte Weiterbildungen der Erfindung sind den Unteransprüchen, der folgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: einen Ausschnitt eines bekannten, nach dem Folding-Prinzip arbeitenden Analog/Digital-Wandlers (nach dem Folding-Prinzip arbeitende Analog/Digital-Wandlers werden im folgenden als Faltungswandler oder Folding-ADCs bezeichnet),
- Figur 2: einen Ausschnitt einer Ausbildung eines erfindungsgemäßen Faltungswandlers,
- Figur 3: eine Darstellung zur Erklärung der Wirkungsweise eines ersten Mittels von Fig. 2 mit entsprechenden Signalen,
- Figur 4: ein Schaltbild einer Ausbildung des ersten Mittels,
- Figuren 5a bis 7: Schaltbilder von Differenzverstärkern mit zweiten Mitteln von Fig. 2,
- Figur 8: ein Schaltbild eines dritten Mittels von Fig. 2,
- Figur 9: ein Schaltbild zur Erklärung eines analogen Selbstkalibrierverfahrens,
- Figur 10: ein Schaltbild des dritten Mittels im Falle einer digitalen Speicherung der Kalibrierwerte,
- Figuren 11 bis 19: Schaltbilder von weiteren Ausbildungen des ersten Mittels,
- Figuren 20a bis 20c: Schaltbilder zur Erläuterung der Wirkungen der ersten Mittel,
- Figur 21: eine Schaltung zur Erklärung der Kalibrierung einzelner Stromquellen,
- Figur 22: eine weitere Ausbildung Figur 21,
- Figur 23: eine Schaltung mit Abtastschaltern zwischen den Stufen für einen Pipeline-Betrieb,
- Figur 24: eine bekannte Verstärkerstufe, genauer gesagt ein differentieller Breitbandverstärker,
- Figur 25: eine Auswahl von Gruppen, Signalverarbeitungsketten, und Signalverarbeitungsbäumen, die aus solchen Verstärkerstufen gebildet werden können,
- Figur 26: ein Prinzipschaltbild zur Darstellung der erfindungsgemäßen Vorrichtung,
- Figur 27: eine beispielhafte Ausführung einer kalibrierbaren Verstärkerstufe, die für sie zuständige Teile der Speichereinheit mit enthält,
- Figur 28: einen Ausschnitt aus einem ADC, der auf der kalibrierbaren Verstärkerstufe nach Figur 27 aufbaut,
- Figur 29: ein einfaches Beispiel der schaltungstechnischen Realisierung erster Mittel mit Transferschaltern,
- Figur 30: ein einfaches Beispiel der schaltungstechnischen Realisierung zweiter Mittel,
- Figur 31: ein einfaches Beispiel der schaltungstechnischen Realisierung dritter Mittel,
- Figur 32: ein weiteres Beispiel der schaltungstechnischen Realisierung erster Mittel, bei der sich diese ersten Mittel in einer der zu kalibrierenden Stufe vorangehenden Stufe befinden, so daß keine Transferschalter zwischen aufeinanderfolgenden Stufen erforderlich sind,
- Figur 33: ein für Folding-ADCs geeignetes Beispiel des Einsatzes zweiter Mittel in einem zweistufigen Verstärker,
- Figur 34: ein für Folding - ADCs besonders geeignetes Beispiel der schaltungstechnischen Realisierung zweiter Mittel, das auch bei einem einstufigen Faltungsverstärker funktioniert,
- Figur 35: ein erfinderisches Grundprinzip und Ausführungsbeispiel der schaltungstechnischen Realisierung zweiter Mittel mit besonders guter Gleichtaktunterdrükkung,
- Figur 36: ein Beispiel für zweite Mittel zur Einstellung eines Frequenzganges
- Figur 37: ein besonders vorteilhaftes Beispiel der Realisierung dritter Mittel, bei der die kapazitive Belastung von Knoten der Verstärkerstufe im Normalbetrieb minimiert ist,
- Figur 38: eine offsetkompensierbare Variante der dritten Mittel,
- Figur 39: die zu ihrem Betrieb benötigte Zusatzschaltung zur Offsetkompensation
- Figur 40: eine Ausführung des Speicherregisters mit einer nachgeschalteten kombinatorischen Logik, bei der ein besonders schnelles Wechseln zwischen Normalbetrieb und Kalibrationsbetrieb möglich ist,
- Figur 41: die Eingangsstufe eines ADC,
- Figur 42a und 42b: Blockschaltbilder einer Vorrichtung zur Eliminierung von Fehlern in einer Referenzspannungsteilerkette,
- Figur 43: den Aufbau der in der Figur 42b gezeigten Differenzverstärker,
- Figuren 44a und 44b: weitere Ausführungsformen einer Vorrichtung zur Eliminierung von Fehlern in einer Referenzspannungsteilerkette,
- Figur 45: den Aufbau einer bekannten Sample-und-Hold-Stufe,
- Figur 46: den Aufbau einer Anordnung, die als Sample-und-Hold-Stufe und zur Erzeugung von für die Referenzspannungsteilerkette-Kalibrierung benötigten Kalibrationssignalen verwendbar ist,
- Figur 47: den Ablauf einer unter Verwendung der Anordnung gemäß Figur 46 erfolgenden Referenzspannungsteilerketten-Kalibrierung,
- Figur 48: eine Darstellung von sich während der Referenzspannungsteilerkette-Kalibrierung einstellenden Signalverläufen,
- Figur 49: ein Blockschaltbild einer Anordnung, durch welche sich das in den Figuren 47 und 48 gezeigte Verfahren realisieren läßt,
- Figur 50: eine mehrere Differenzverstärker und eine diesen vorgeschaltete Sample-und-Hold-Stufe enthaltende bekannte Eingangsstufe für schnelle ADCs,
- Figur 51a: eine Anordnung mit einem ersten Ausführungsbeispiel einer Vorrichtung zur Kompensation von in einer Sample-und-Hold-Stufe enthaltenen Fehlern,
- Figur 51b: eine Anordnung mit einer für andere Differenzverstärker vorgesehenen Vorrichtung zur Kompensation von in einer Sample-und-Hold-Stufe enthaltenen Fehlern,
- Figur 52: den Aufbau eines der in Figur 51b gezeigten Differenzverstärker,
- Figur 53a: eine Anordnung mit einem zweiten Ausführungsbeispiel einer Vorrichtung zur Kompensation von in einer Sample-und-Hold-Stufe enthaltenen Fehlern,
- Figur 53b: eine Anordnung mit einer für andere Differenzverstärker vorgesehenen Vorrichtung zur Kompensation von in einer Sample-und-Hold-Stufe enthaltenen Fehlern,
- Figur 54a: eine Anordnung mit einer Vorrichtung zur Kompensation von in einer Sample-und-Hold-Stufe enthaltenen Fehlern, wobei zwei verschiedene Referenzspannungsteilerketten verwendet werden,
- Figur 54b: eine Anordnung mit einer für andere Differenzverstärker vorgesehenen Vorrichtung zur Kompensation von in einer Sample-und-Hold-Stufe enthaltenen Fehlern, und
- Figur 55: eine mögliche Realisierung des Mittels zur Stellung der Offsetspannung eines Differenzverstärkers.

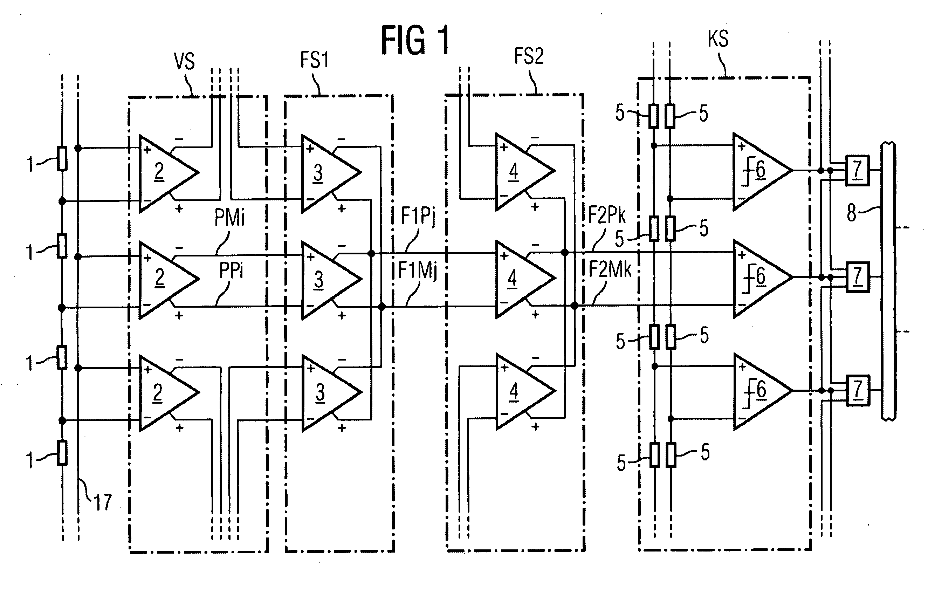

Die Erfindung wird zunächst unter Bezugnahme auf die Figuren 1 bis 23 anhand eines nach dem Folding-Prinzip arbeitenden Analog/Digitalwandlers beschrieben; nach dem Folding-Prinzip arbeitende Analog/Digitalwandler werden im folgenden der Einfachheit halber als Faltungswandler oder Folding - ADCs bezeichnet. Der Einsatz der erfindungsgemäßen Vorrichtungen und Verfahren in Folding-ADCs oder in anderen schnellen ADCs, beispielsweise in Flash-ADCs, erweist sich als besonders vorteilhaft, weil diese eine sehr große Anzahl von Verstärkerstufen aufweisen.

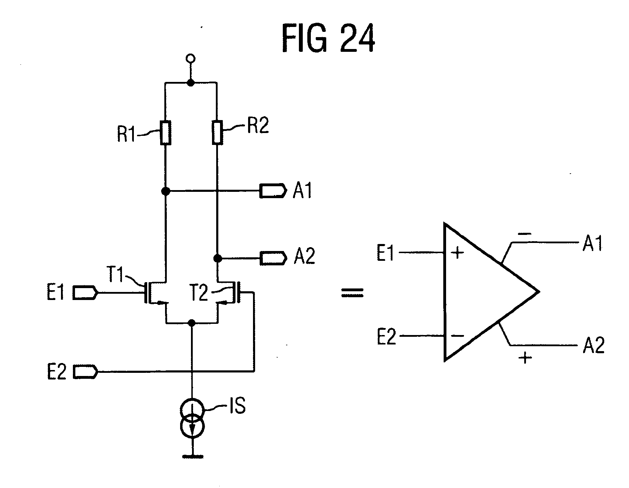

Danach werden die erfindungsgemäßen Vorrichtungen und Verfahren unter Angabe weiterer vorteilhafter Weiterbildungen und unter Angabe weiterer Einsatzmöglichkeiten unter Bezugnahme auf die Figuren 24 bis 55 in allgemeinerer Form erläutert.

Die Figuren 1 bis 23 und die darauf bezugnehmende Beschreibung betreffen eine Vorrichtung und ein Verfahren zur Kalibrierung eines Folding - ADC, wobei unter Kalibrierung beispielsweise die Minimierung von Fehlern durch statistische Schwankungen der Bauteileparameter (Mismatch) sowie von Fehlern durch integrale oder differentielle Nichtlinearität (INL bzw. DNL) bedeutet.

Folding - ADCs finden eine breites Anwendungsfeld, das von der Geschwindigkeit meist zwischen sogenannten Subranging - ADCs und Flash - ADCs angesiedelt ist. Ersten brauchbaren Folding - ADCs, die in bipolaren Prozessen realisiert wurden [1], folgten bald in CMOS - Prozessen realisierte Folding-ADCs [2]. MOSFETs haben jedoch den Nachteil, daß sie eine sehr viel größere Offsetspannung aufweisen als Bipolartransisistoren gleicher Fläche. In zeitgemäßen CMOS - Prozessen rechnet man mit Matchingkonstanten von ca. 5 mV/µm, was bedeutet, daß ein MOSFET mit 25 µm² Gatefläche eine 3 sigma Offsetspannung vom 3 mV hat. Dies folgt aus Vos(3s) = 3 * 5 mV/µm : SQRT(25µm²), d.h. die Gatefläche wächst quadratisch um die Offsetspannung linear zu senken. Dieser dem Fachmann als Pelgrom'sches Gesetz bekannte Sachverhalt stellt eine erhebliche Beschränkung für die mit CMOS - Folding - ADCs erreichbare Auflösung (Zahl der Bits), Geschwindigkeit und Reduktion des Stromverbrauchs dar. Obwohl die von Bult [3], [4] erstmals bei CMOS - Folding - ADCs eingeführte Averagingtechnik, die auf [5] zurückgeht, ein wichtiger Meilenstein war, um in CMOS hochauflösende Folding - ADCs (hier 10 Bit) mit vertretbarem Flächen- und Stromverbrauch zu realisieren, ist für das wirtschaftliche Erreichen noch größerer Auflösungen ein Lösungsansatz wünschenswert, bei dem der Offset der MOSFETs nicht über eine große Gatefläche, sondern durch aktive Maßnahmen reduziert wird, beispielsweise mittels einer Schaltung, die den Offset kompensiert.

Solche Schaltungen sind dem Stand der Technik schon lange bekannt und werden vor allem bei Operationsverstärkern eingesetzt. Da diese Schaltungen in der Regel auf Rückkopplung basieren, und deswegen ein dominanter Pol in der Übertragungsfunktion der Offsetkompensationsschleife notwendig ist, der ihre Stabilität garantiert, ist dieses Konzept bei Folding - ADCs nicht ohne weiteres anwendbar, da deren Verarbeitungsstufen in der Regel als breitbandige Differenzverstärker ausgelegt werden und ohne Rückkopplung arbeiten. Aus dem Stand der Technik bekannte sogenannte Autozero - Techniken für Komparatoren [6] lassen sich wegen der erheblich größeren Verstärkung der Foldingstufen nicht auf diese anwenden, da hierbei eine Stabilität schwieriger zu erzielen ist. Eine weitere Komplikation ergibt sich aus der Eigenschaft der Architektur von Folding - ADCs, daß der Signalpfad vom Eingang des ADC aus betrachtet zunächst divergiert (wie beim Flash - ADC), dann aber in den Foldingstufen wieder konvergiert, so daß deren offsetbehaftete MOSFET - Differentialpaare nicht einem eindeutigen Signalpfad zugeordnet werden können, sondern einer Vielzahl von Signalpfaden, von denen im Falle von Averaging [3] sogar noch mehrere gleichzeitig aktiv sind und sich gegenseitig beeinflussen. Zudem befinden sich in einem Folding - ADC nicht nur offsetbehaftete Differentialpaare, sondern weitere Komponenten, wie beispielsweise Widerstände und Stromquellen, die ebenfalls einem Matchingfehler unterliegen, und sowohl Offset- als auch Verstärkungsfehler hervorrufen können, so daß diese Fehlerquellen oft ebenfalls einer Kompensation unterworfen werden müssen. Ein Prozeß, bei dem alle Fehlerquellen des ADCs auf systematische Weise kompensiert werden, wird in der Literatur gerne als "Selbstkalibrierung" bezeichnet, und diese ist für Flash-, Subranging-, Pipeline-, Sukzessive Approximations - ADCs usw. sehr reichhaltig (z.B. [7]...[10]).

Für Folding - ADCs findet sich bisher jedoch kein brauchbares Selbstkalibrierungsverfahren, vermutlich weil die Lösung dieser Aufgabe auf Grund der oben erwähnten Faktoren bisher nicht gelang. In der Literatur bekannte Folding - ADCs höherer Auflösung, z.B. [11], flüchten daher in die Verwendung von BiCMOS - Prozessen, um auf Grund der dort verfügbaren Bipolartransistoren das Offsetproblem zu entschärfen. Mehr als 12 Bit nominelle Auflösung erzielt [11] aber nicht, so daß es auch im Falle der Verwendung eines solchen BiCMOS - Prozesses, und nicht nur bei reinem CMOS, für den Konstrukteur sehr nützlich wäre, über ein brauchbares Verfahren zur Selbstkalibrierung zu verfügen, welches ganz allgemein auf Folding - ADCs vielfältigster Architekturen angewandt werden kann.

Die vorliegende Erfindung beruht im wesentlichen darin, daß eine Selbstkalibrierung bzw. eine geregelte Kalibrierung eines Faltungs-Analog/Digitalwandlers durch erste Mittel zur Sensibilisierung, Inhibitierung und Freischaltung von Signalpfaden durch den Faltungswandler, durch zweite Mittel zur Erzeugung eines Gleichgewichtszustands der die ersten Mittel enthaltenden Stufen; durch dritte Mittel zum Abfragen von Zuständen in diesen Stufen und durch vierte Mittel zum Bilden von Steuersignalen in Abhängigkeit der abgefragten Zustände erfolgt.

Der bisherige Stand der Technik ist beispielhaft in Figur 1 dargestellt. Es handelt sich um einen Ausschnitt aus einem Folding - ADC mit kaskadierter Faltung, d.h. die Faltung geschieht in mehr als einer Faltungsstufe. Hiermit soll die Brauchbarkeit der Erfindung auch für diesen schwierigeren Fall dargestellt werden, zumal die meisten modernen Folding - ADCs kaskadierte Faltung verwenden. Eine Referenzkette 1 führt auf Vorverstärker 2 einer Vorverstärkerstufe VS, deren Ausgänge PPi und PMi auf eine erste Faltungsstufe FS1 mit Differenzverstärkern 3 führen. Die Ausgänge F1Pj und F1Mj der ersten Faltungsstufe führen auf eine zweite Faltungsstufe FS2 mit Differenzverstärkern 4, deren Ausgänge F2Pk und F2Mk auf eine Komparatorstufe mit Interpolator 5 und nachfolgenden Komparatoren 6 führen, die von sogenannten Bubblegates 7, die Logikschaltungen zum Ersetzen von Bits mit dem Wert "0" innerhalb von Bitfolgen mit den Werten "1" darstellen und zur Korrektur des gefalteten Thermometercodes dienen, gefolgt werden, welche auf einen ROM oder Encoder 8 wirken, so daß an dessen Ausgang niederwertige Bits des quantisierten Eingangswerts herauskommen. Die Funktions- und Wirkungsweise dieser Teile an sich sowie ihr schaltungstechnischer Aufbau kann als dem Fachmann bekannt vorausgesetzt werden und findet sich im Detail beschrieben in der einschlägigen Literatur [1]...[5], [11]. Einige häufigere Variationen der dargestellten Grundschaltung wären der Einbau eines zusätzlichen Interpolators nach der ersten Faltungsstufe [11] oder eines Averagingnetzwerks [3]. Die Erfindung ist für alle diese Fälle brauchbar und selbstverständlich auch für einfache Architekturen mit nur einer Faltungsstufe, oder solchen Architekturen, bei denen die Vorverstärker mit der Faltungsstufe kombiniert sind. In letzterem Fall ist die Kombination Vorverstärker/Faltungsstufe als Faltungsstufe im Sinne der Erfindung anzusehen und mit den erfindungsgemäßen Mitteln für Faltungsstufen auszustatten.

Zu dieser und den folgenden Darstellungen ist anzumerken, daß die mit 2, 3, 4 bezeichneten Elemente in der Regel als breitbandiger symmetrischer Differenzverstärker bestehend aus einem Differentialpaar, einer Fußstromquelle und einem Paar Lastelemente, meist Widerstände, aber auch aktive Schaltungen [3], aufgebaut sind, der das Eingangssignal invertiert. Im Falle der Foldingstufen ist jeder zweite derartige Verstärker mit vertauschten Ausgängen angeschlossen. Dies erschwert die Zuordnung der richtigen Polaritäten zu den differentiellen Signalen Pmi, PPi, F1Pj, F1Mj, F2Pk, F2Mk, usw. Für die bildhafte Darstellung ist die Polarität der Signalnamen aber eher eine Konvention des Konstrukteurs und daher für die Offenbarung der Erfindung unbedeutend.

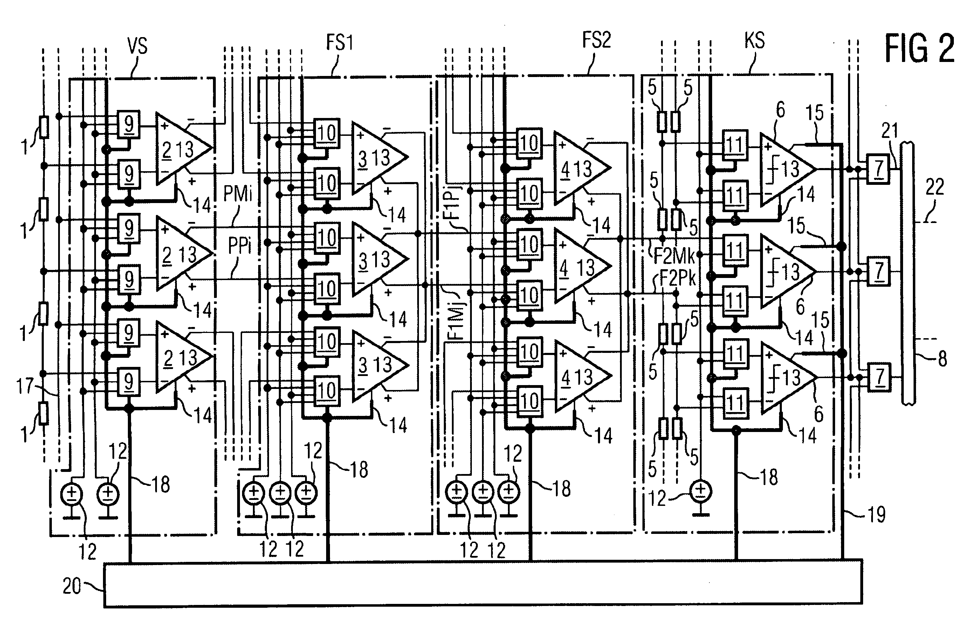

In Figur 2 ist ein bevorzugtes Ausführungsbeispiel der erfindungsgemäßen Vorrichtung in einem Faltungswandler ausschnittsweise dargestellt. Es liegt hierbei dieselbe Grundschaltung wie in Figur 1 vor, die durch erste bis vierte Mittel 9,10,11; 13; 15 und 20 ergänzt ist.

Die ersten Mittel 9, 10, 11 erlauben es, die Eingänge von Schaltungsstufen innerhalb des Folding - ADC von ihren normalen Quellen zu lösen und auf Hilfspotentiale 12 zu legen, die den Mitteln zugeführt werden. Diese Hilfspotentiale sind so gewählt, daß die Schaltungsstufen bestimmte Arbeitspunkte annehmen können, was bei der Beschreibung des Selbstkalibrierungsverfahrens später erläutert wird.

Die Hilfspotentiale werden im Figur 2 zwar durch Spannungsquellen dargestellt, können aber an beliebigen Punkten innerhalb der Schaltung auf beliebige Weise entnommen werden, solange damit die erfindungsgemäßen Wirkungen der ersten Mittel erzielt werden. Diese Variationen werden später beispielhaft dargestellt. Insbesondere ergibt sich für die mögliche Realisierung der auf die erste Stufe wirkenden ersten Mittel 9 eine Vielzahl von Varianten.

Die ersten Mittel 10, die am Eingang von Foldingstufen vorgesehen werden, weisen mindestens vier Betriebszustände oder Wirkungen auf. Bei anderen Typen von ADCs, die nicht auf dem Foldingprinzip basieren, genügen für korrespondierende erste Mittel gewöhnlich zwei Betriebszustände, einer für den Normalbetrieb, und einer für die Selbstkalibrierung.

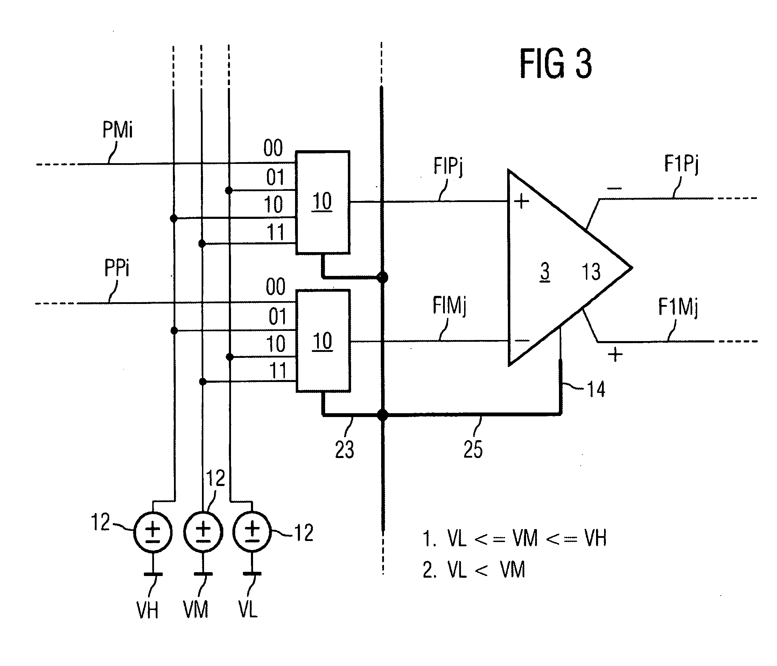

Die vier Betriebszustände bzw. Wirkungen im Falle des Faltungswandlers und die zugeordneten Hilfspotentiale sind beispielhaft in Figur 3 dargestellt. Im ersten Betriebszustand "00" sind die Eingänge FIPj und FIMj des Blocks 3, der ein Bestandteil der ersten Faltungsstufe ist, mit den von den Vorverstärkern kommenden Signalen PPi und PMi verbunden, was für den Normalbetrieb nötig ist. Die anderen drei Betriebszustände sind für das Selbstkalibrierungsverfahren notwendig. Im zweiten Betriebszustand "01" ist FIPj mit VL und FIMj mit VH verbunden, so daß sich eine negative Aussteuerung des in Block 3 befindlichen Differenzverstärkers ergibt. Im dritten Betriebszustand "10" ist FIPj mit VH und FIMj mit VL verbunden, so daß sich eine positive Aussteuerung des in Block 3 befindlichen Differenzverstärkers ergibt. Diese letzten beiden Betriebszustände dienen dazu, während des Selbstkalibrierungsverfahrens die gerade nicht zu kalibrierenden Schaltungsteile derart in definierte Zustände zu bringen, daß sie den Signalpfad, der von den zu kalibrierenden Schaltungsteilen ausgeht, nicht schädlich beeinflussen können. Am Anfang des Signalpfades wird der Zustand "11" benutzt, in der FIPj und FIMj mit dem gleichen Potential verbunden sind, so daß ein Gleichgewichtszustand hergestellt wird, der vermöge der zweiten Mittel auf Soll gebracht werden kann. Dieses gleiche Potential ist hier VM, welches über den vierten Eingang der ersten Mittel zugeführt wird. Ein solcher vierter Eingang ist aber z. B. dann nicht notwendig, wenn die Gleichtaktunterdrückung von Block 3 gut genug ist, so daß in der vierten Stellung der ersten Mittel statt VM eine der beiden Hilfsspannungen VH oder VL genutzt werden kann, um einen Gleichgewichtszustand einzustellen. Die Kennzeichen der ersten Mittel sind daher in den vier verschiedenen Betriebszuständen oder Wirkungen auf die von ihnen beeinflußte Stufe zu sehen, und nicht in ihrer Eingangsanzahl. Daß das Hilfspotential VM auch entfallen und durch VL oder VH ersetzt werden kann, ergibt sich auch aus den in Figur 3 angeschriebenen Relationen.

Die zweiten Mittel 13 innerhalb der Schaltungsstufen mit ersten Mitteln erlauben es, über Steuereingänge 14 den Gleichgewichtszustand innerhalb der Schaltungsstufen zu verstellen.

Das Vorhandensein der zweiten Mittel innerhalb eines Symbols wird dadurch dargestellt, daß eine kleinere Zahl "13" neben der größeren Typennummer des Symbols 2, 3, 4 oder 6 steht. Doch auch ohne explizite Darstellung der Zahl "13" ist davon auszugehen, daß alle Symbole, deren Eingänge mit ersten Mitteln 9,10, 11 verbunden sind, über erfindungsgemäße zweite Mittel verfügen. Diese Konvention erlaubt es, in späteren Darstellungen die "13" wegzulassen, um diese nicht unnötig mit Details zu überfrachten. Einige besonders vorteilhafte schaltungstechnische Realisierungen dieser zweiten Mittel werden später dargestellt.

Die dritten Mittel 15 an oder in den Komparatoren erlauben es, den Zustand des Komparators auswerten zu können, ohne daß diese Information durch die dem Komparator nachfolgende Logik verfälscht wird. Diese dritten Mittel können Zusatzausgänge am Komparator sein, oder Mittel zur direkten Beobachtung einzelner Komparatorausgänge, wie z.B. ein aus Tristate-Treibern bestehender Multiplexer, der einzelne Komparatorausgänge auswählt, und auf Sammelleitungen führt. Abhängig davon, ob das erfindungsgemäße Selbstkalibrierungsverfahren mit digitalen oder analogen Stellgliedern innerhalb der zweiten Mittel ausgeführt wird, ergeben sich unterschiedliche Ausgestaltungen der dritten Mittel, von denen einige besonders vorteilhafte Beispiele später dargestellt werden. Nicht bildlich dargestellt wird die im Falle einer digitalen Realisierung des Kalibrierungsverfahrens mögliche Realisierung der dritten Mittel, bei denen die Signale 19 innerhalb der den Komparatoren nachfolgenden Logik, z.B. an Knoten 21, oder am Ausgang des ROMs oder Encoders, z.B. an Knoten 22, abgenommen werden. Diese Variante setzt voraus, daß die besagte Logik zusätzliche Verknüpfungen aufweist, die die Beeinflussung der vom Selbstkalibrierungsverfahren an 19 beobachteten Signale durch nicht angewählte Komparatoren vermeidet. Diese zusätzlichen Verknüpfungen haben aber den Nachteil, daß diese damit komplexer und daher langsamer wird. Die Anordnung der dritten Mittel an den Komparatoren ist die beste Lösung, da sich auf diese Weise die bestmögliche Gesamtgenauigkeit der Selbstkalibrierung ergibt, und der geringste Aufwand entsteht. Es wäre zwar denkbar, jeder kalibrierbaren Stufe dritte Mittel zuzuordnen, was aber den Nachteil hätte, daß dann die dritten Mittel zuerst selbst kalibriert werden müßten, um die erforderliche Genauigkeit zu erreichen.

Die vierten Mittel 20, steuern das erfindungsgemäße Selbstkalibrierungsverfahren, indem sie die ersten und zweiten Mittel über Steuerleitungen 18 stellen und die Wirkung der Stellmaßnahmen über Signalleitungen 19 empfangen und auswerten. Wie später dargestellt wird, weisen diese vierten Mittel ein digitales Steuerwerk auf, welches den Ablauf des erfindungsgemäßen Kalibrierungsverfahrens steuert, und weitere variantenspezifische Hilfsmittel, die jeweils technisch hierzu notwendig sind.

Abhängig von den an den Folding - ADC gestellten Anforderungen sind die ersten und zweiten Mittel entweder nur bei den Vorverstärkern - geringe Anforderungen - vorzusehen, oder bei den Vorverstärkern und der ersten Faltungsstufe, oder bei den Vorverstärkern und der ersten und zweiten Faltungsstufe, oder bei allen Stufen einschließlich der Komparatoren - höchste Anforderungen -, denn wenn die Fehler von nachfolgenden Stufen auch ohne diese Mittel gering genug wären, um die Anforderungen des Folding - ADC zu erfüllen, muß der mit ihnen verbundene Mehraufwand nicht getrieben werden. Diese Möglichkeit, die erfindungsgemäßen Mittel nur in den dem Eingang am nächsten liegenden Stufen einzuführen, und ab einer bestimmten Stufe diese wegzulassen, ergibt sich aus der Tatsache, daß die Stufen in der Regel so ausgelegt werden, daß sie das Signal verstärken, so daß beispielsweise Offsetfehler nachfolgender Stufen sich um den Faktor der Verstärkung der vorangegangenen Stufen reduziert auswirken. Von dieser Tatsache wird auch bei der Auslegung von rein auf Matching basierenden Folding - ADCs ohne Selbstkalibrierung Gebrauch gemacht, so daß kein Zwang besteht, die erfindungsgemäßen Mittel in jedem Fall in jeder Stufe einführen zu müssen. Es ist bspw. auch denkbar, die erfindungsgemäßen Mittel nur bei den Vorverstärkern und bei den Komparatoren vorzusehen.

Folding - ADCs gibt es auch mit einstufigem Aufbau der Faltungsstufe [1], mit Kombination der Vorverstärker mit der Faltung, usw., mit kaskadierter Faltung mit mehr als zwei Faltungsstufen, ohne und mit Interpolator, ohne und mit Averagingnetzwerk, etc., und in allen Fällen kann die Erfindung ohne Weiteres eingesetzt werden.

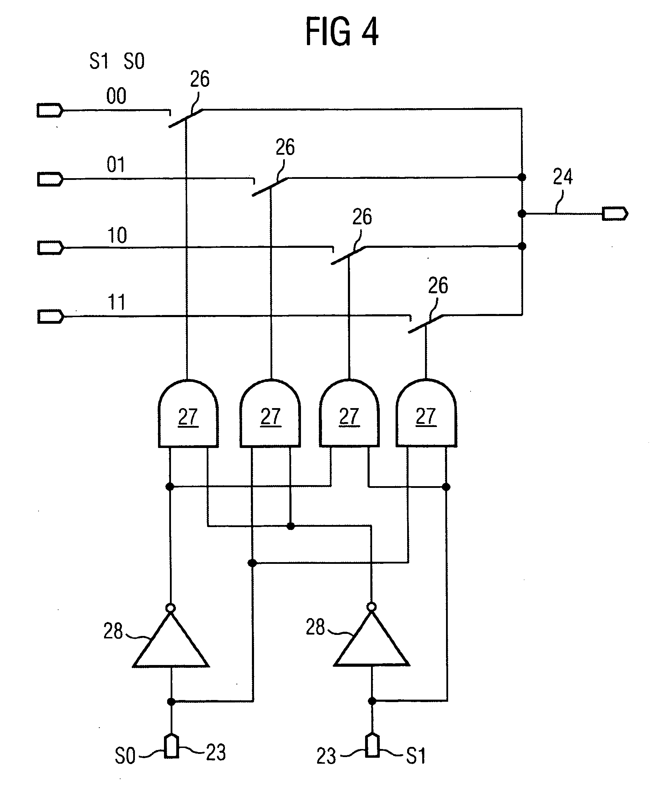

Beispielhafte Realisierungen der erfindungsgemäßen Mittel sind in den Figuren 4 bis 10 dargestellt.

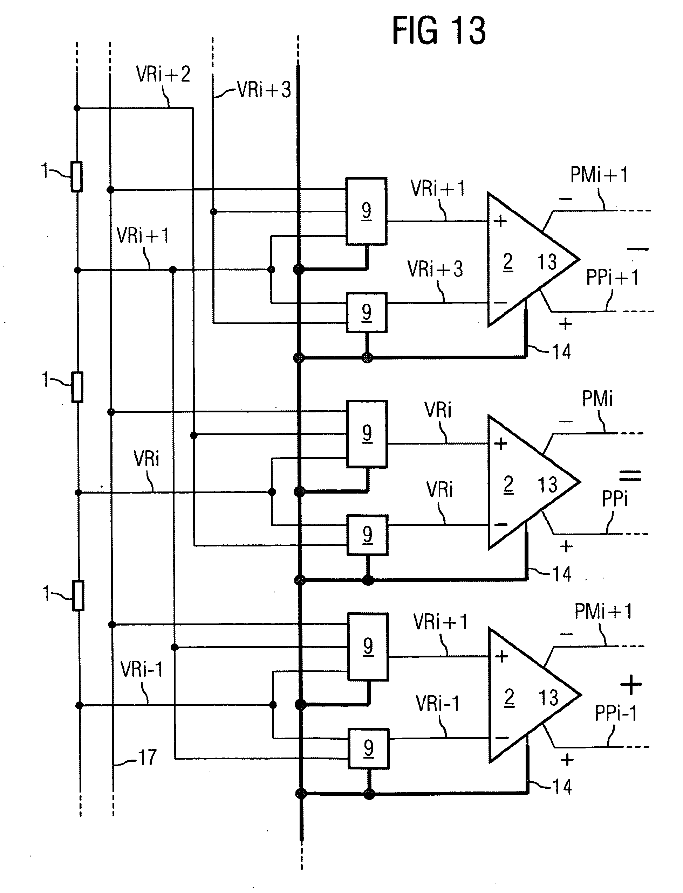

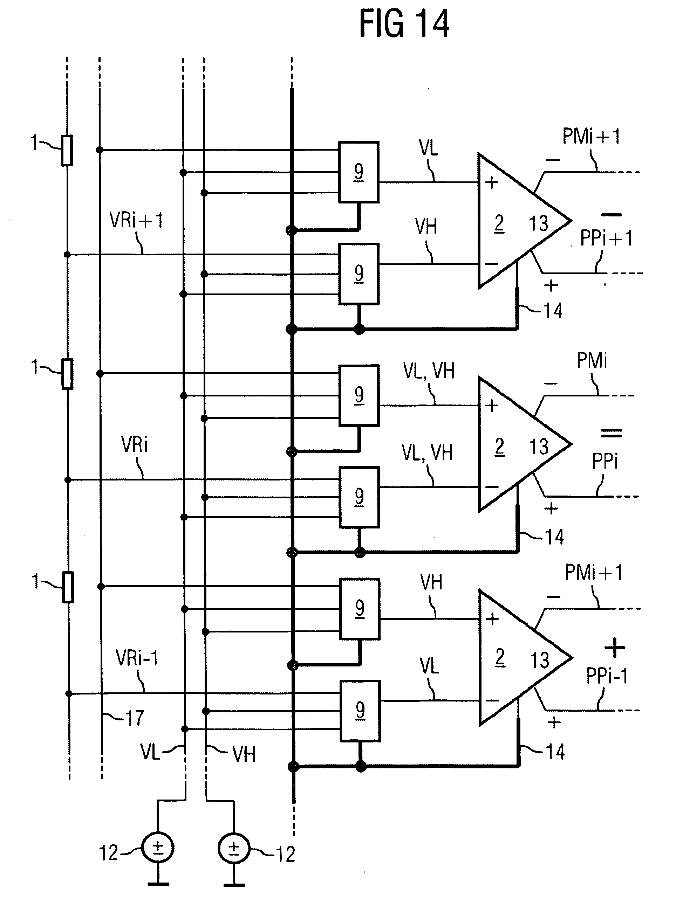

Figur 4 zeigt eine beispielhafte Realisierung der ersten Mittel für Faltungsstufen. Über digitale Steuereingänge 23, bezeichnet mit S0 und S1, wird eine der vier Wirkungen ausgewählt und über den aus Und - Gattern 27 und Invertern 28 bestehenden Dekoder dekodiert. Die Ausgänge des Dekoders sind mit steuerbaren Schaltern 26 verbunden, so daß für jede Wirkung einer der vier Eingänge dieses beispielhaften ersten Mittels auf den Ausgang 24 geschaltet wird. Wie schon weiter oben erwähnt wurde, besteht das Kennzeichen der ersten Mittel aus den erwähnten mindestens vier stellbaren Wirkungen, so daß auch weniger Eingänge und steuerbare Schalter genügen würden. Ein hierbei nützliches Prinzip wird später am Beispiel der ersten Mittel für die erste Stufe in den Figuren 13 und 14 gezeigt. Nach diesem Prinzip kann das erste Mittel aus Figur 4 mit weniger als vier Eingängen oder mit mehr als vier Wirkungen, z.B. zu weiteren Zwecken für den Produktionstest, realisiert werden.

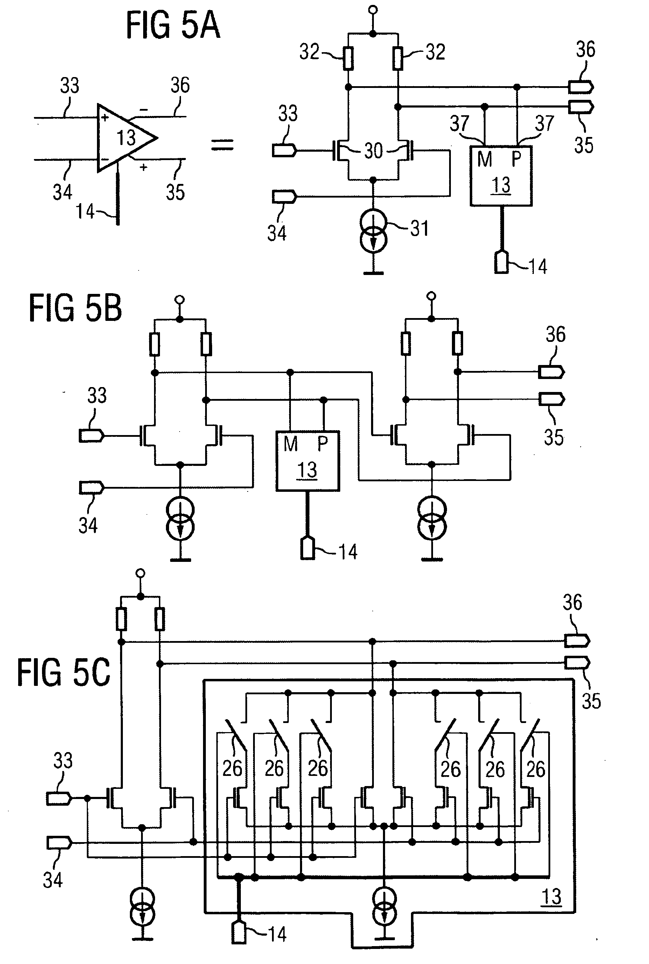

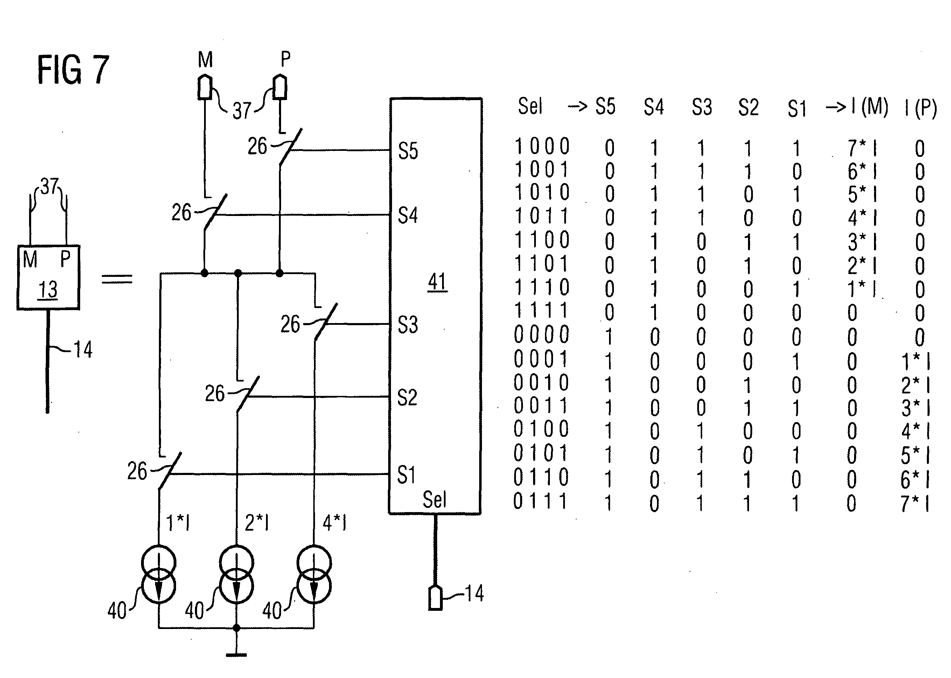

Die Figuren 5a bis 5c zeigen jeweils beispielhaft eine typische innere Schaltung von mit den erfindungsgemäßen zweiten Mitteln 13 ausgerüsteten Vorverstärkern 2 und Faltungsstufen 3, 4. Die Eingänge 33 und 34 der Vorverstärker nach Figur 5a führen auf ein Differentialpaar 30 mit Fußstromquelle 31. Die Ausgänge des Differentialpaars führen auf Lastelemente 32. Als Lastelemente kommen Widerstände wie in diesen Figuren dargestellt oder aktive Schaltungen (z.B. [3]) in Frage. Die gemeinsamen Knoten der Ausgänge des Differentialpaars und der Lastelemente führen auf die Ausgänge der Stufe 35, 36. Die zweiten Mittel 13 sind mit ihren Ausgängen 37 ebenfalls an diesen mit den Ausgängen 35, 36 angeschlossenen Knoten verbunden. Ihre Funktion besteht darin, gesteuert von den Eingängen 14 an den Ausgängen 37 einen stellbaren Strom aus den angeschlossenen Knoten herauszuziehen. Über die Lastelemente wirkt dieser Strom als Verschiebung des Gleichgewichtszustandes der Stufe, d.h. ihr Gleichgewichtszustand kann über die Eingänge 14 gestellt werden. Da im Falle von Faltungsstufen mehrere dieser Grundschaltungen an den Ausgängen parallel geschaltet sind, ist es erforderlich, die zweiten Mittel in diesem Fall nicht direkt an den Ausgängen wirken zu lassen. Figur 5b zeigt eine für Faltungsstufen besonders geeignete Schaltung, die den Vorteil hat, daß der Stellvorgang der zweiten Mittel keinen Einfluß auf den Gesamtstrom durch die an den Ausgängen 35, 36 angeschlossenen Lastelemente hat, so daß sich die Möglichkeit einer vereinfachten Realisierung der zweiten Mittel ergibt, die später in Figur 7 dargestellt wird. Typische Varianten dieser beispielhaften Grundschaltungen wären neben der bereits erwähnten Verwendung aktiver Schaltungen als Lastelemente auch der Einbau von Kaskoden am Ausgang der Differentialpaare, oder für niedrige Versorgungsspannungen eine Faltung der Schaltungsstruktur, wie sie als "Folded Cascode" an sich bekannt ist, etc., doch es sind auch Lösungen möglich, die das zweite Mittel nicht als eigenen Block enthalten, sondern mit der Grundschaltung verschmelzen. Figur 5c zeigt ein solches Beispiel, bei dem das zweite Mittel durch ein über steuerbare Schalter 26 digital skalierbares Differentialpaar realisiert wird.

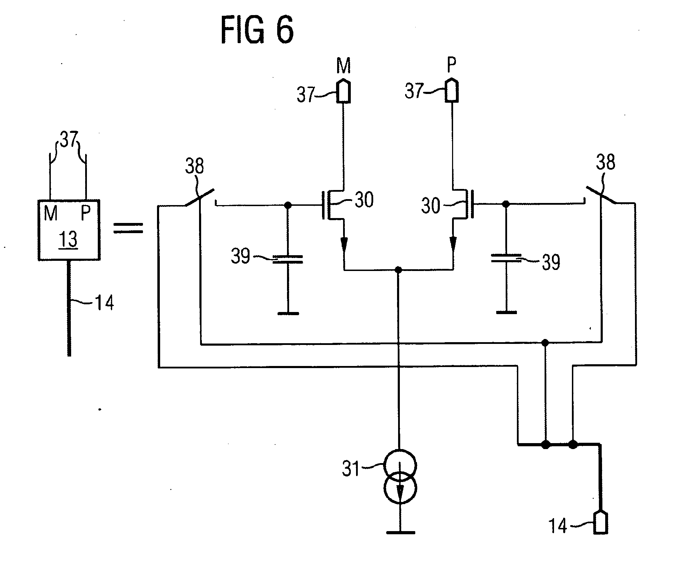

Figur 6 zeigt beispielhaft eine Verwirklichung der erfindungsgemäßen zweiten Mittel, die dann besonders vorteilhaft ist, wenn die Kalibrierungsinformation nicht diskretisiert als digitaler Wert, sondern als kontinuierlicher analoger Wert gespeichert werden soll. Dies eröffnet auch die Möglichkeit, den Teil des Kalibrierungsvorgangs, der das Gleichgewicht auf Soll bringt, durch Schließen einer Feedbackschleife als Einschwingvorgang durchzuführen, der schneller sein kann als die digitale Variante, die später beschrieben wird. In dieser analogen Variante bestehen die zweiten Mittel aus einem Differentialpaar 30 mit seiner Fußstromquelle 31, dessen Ausgänge auf die Ausgänge der zweiten Mittel 37 führen. Haltekondensatoren 39 und Abtastschalter 38 ermöglichen es, die von den Eingängen 14 zugeführten analogen Signale auf die Haltekondensatoren zu führen und dort zu speichern. Die beiden differentiellen analogen Eingangssignale können dabei gleichzeitig auf eine Vielzahl derartiger Stufen führen, und ein jeweils der Stufe zugeordnetes digitales Signal übernimmt das Schließen bzw. Öffnen der Abtastschalter derjenigen Stufe, die gerade kalibriert wird. Wie bereits bei den Figuren 5a bis 5c erwähnt kann diese Grundschaltung noch variieren, etwa durch Einbau von Kaskoden.

Figur 7 zeigt beispielhaft eine Verwirklichung der erfindungsgemäßen zweiten Mittel, die dann besonders vorteilhaft ist, wenn die Kalibrierungsinformation digital gespeichert werden soll. Dies erlaubt es, zwischen den Kalibrierungsvorgängen eine längere aktive Betriebszeit des ADC vorzusehen. Außerdem erlaubt es diese digitale Variante, das Kalibrierungsverfahren im Hintergrund durchzuführen, indem beispielsweise jede 100ste Quantisierung des Nutzsignals unterdrückt und dafür für einen Takt ein Schritt des Kalibrierungsverfahrens ausgeführt wird. Auf diese Weise kann der ADC kontinuierlich im Betrieb kalibriert werden und Einflüsse wie Temperaturdrift und 1/f - Rauschen auf die Gleichgewichtszustände werden ständig ausgeglichen. Ein für diese Lösung besonders geeignetes System bestehend aus dem erfindungsgemäßen selbstkalibrierenden ADC und einem Digitalfilter, der die durch die Selbstkalibrierungsschritte entstehenden Lücken im quantisierten Datenstrom ausgleicht, ist Gegenstand einer weiteren Patentanmeldung. Die dargestellte digitale Realisierung der zweiten Mittel besteht aus gewichteten Stromquellen 40, die über steuerbare Schalter 26 auf die Ausgänge 37 des zweiten Mittels aufgeschaltet werden können. Ein Dekoder 41, für den eine besonders vorteilhafte, da einfach zu realisierende Wahrheitstabelle im Figur ebenfalls angegeben ist, dekodiert die digitalen Eingangssignale 14 und steuert die steuerbaren Schalter 26 (1 = ein) derartig, daß ein in acht Stufen stellbarer Strom jeweils auf den einen oder den anderen Ausgang (im Figur mit M und P bezeichnet) des zweiten Mittels aufgeschaltet wird. Auf diese Weise kann der Gleichgewichtszustand in jede Richtung verstellt werden. Der Strom I der gewichteten Stromquellen ist dabei so zu wählen, daß die erwarteten Fehler im Gleichgewichtszustand in jedem Fall auf Soll gestellt werden können. In der Regel ist dieser Strom um Größenordnungen geringer als jener Strom der Fußstromquelle des Differentialpaares der Stufe, auf die die zweiten Mittel wirken. Die Speicherung der digitalen Stellsignale kann an einer zentralen Stelle erfolgen, z.B. innerhalb der vierten Mittel, oder lokal bei den zweiten Mitteln durch Hinzufügen eines Registers, welches im Figur aus Gründen dieser beiden bestehenden Möglichkeiten nicht dargestellt ist. Die Lösung mit lokaler Speicherung der Kalibrierungsinformation ist vor allem dann besonders vorteilhaft, wenn eine große Vielzahl von zweiten Mitteln bedient werden müssen, so daß in Summe eine große Vielzahl von Signalleitungen zu den Eingängen 14 erforderlich wären. Addressierbare Register zur digitalen Speicherung der Kalibrierungsinformation, die jeweils örtlich nahe der zweiten Mittel angeordnet sind, und über einen gemeinsamen Adreß-, Daten- und Steuerbus bedient werden, sind in diesem Fall die vorteilhafteste Lösung. Der Stand der Technik kennt die hierzu nötigen weiteren Mittel und Methoden aus der Technik des Schreib / Lesespeichers (RAM), so daß diese hier nicht weiter dargestellt werden müssen. Varianten dieser Grundschaltung können in zusätzlichen Stromquellen, Schaltern oder einer Anordnung von Stromspiegeln bestehen, um statt der im Beispiel ausgeführten unsymmetrischen Ströme, da einer immer Null ist, einen symmetrischen Strom zu erhalten, bei dem die Summe der Ströme ist immer gleich bleibt. Diese Maßnahme wäre dann von Vorteil, wenn die Gleichtaktunterdrückung der nachfolgenden Stufe zu schlecht wäre, so daß diese durch Kalibrierung der vorangegangenen Stufe verstimmt würde. In der Praxis ist dies jedoch nur selten der Fall, so daß die beispielhaft dargestellte Grundschaltung genügt. Da die 2 x 8 Stufen des Beispiels den Fehler des Gleichgewichtszustandes aber auf 1 / 8 des unkalibrierten Falls reduzieren können, und die für das Matching notwendige Fläche der Elemente des Differenzverstärkers somit auf ein 1/64stel reduzieren, sind die beispielhaften vier Bit Stellbereich in der Praxis in der Regel ausreichend.

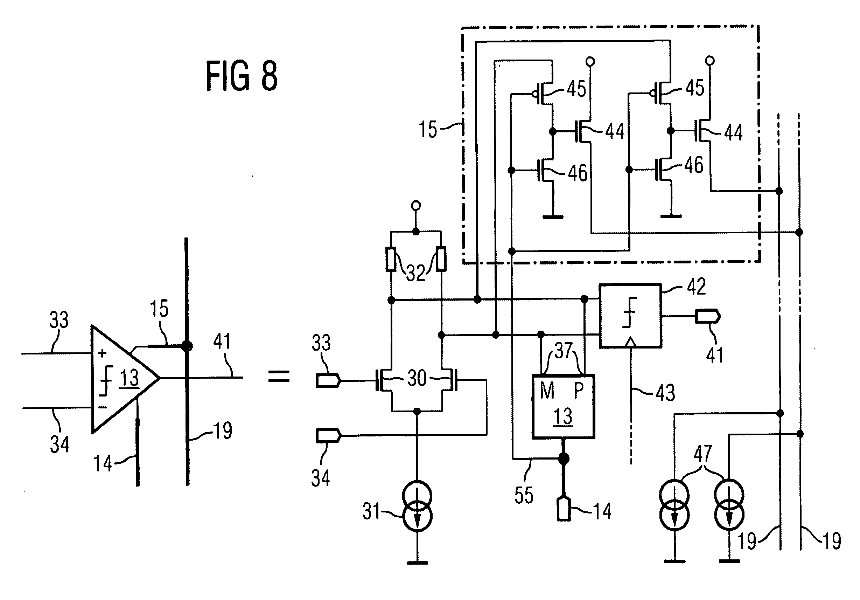

Figur 8 zeigt eine beispielhafte Realisierung der dritten Mittel, die besonders dann vorteilhaft ist, wenn eine analoge Speicherung der Kalibrierungsinformation erfolgen soll. In diesem Fall ist es zweckmäßig, eine analoge Feedbackschleife herzustellen, um den jeweils zu kalibrierenden Gleichgewichtszustand über die zweiten Mittel nach Figur 6 auf Soll zu bringen. Hierzu muß vor dem getakteten Teil 42 des Komparators das ihm innewohnende differentielle analoge Signal abgenommen werden. Gewöhnlich enthalten die Komparatoren vor dem getakteten Teil eine Differenzverstärkerstufe 30, 31, 32, deren Bandbreite einen limitierenden Faktor für die Gesamtleistung des ADC darstellt, und daher möglichst nicht durch zusätzliche kapazitive Lasten verschlechtert werden sollte. Außerdem würde bei der direkten Aufschaltung des differentiellen Signals auf einen Bus 19, über den es den zweiten Mitteln zugeführt wird, ein schädlicher Pol in der Übertragungsfunktion bewirkt werden, der die Kompensation des Frequenzgangs der Feedbackschleife sehr schwierig machen kann. Eine besonders vorteilhafte schaltungstechnische Lösung dieses Problems ist im Figur 8 dargestellt. Der Bus 19, der von den dritten Mitteln zu den vierten Mitteln führt, um dort der später dargestellten Kompensation des Frequenzgangs unterworfen zu werden, und nach dieser Kompensationsschaltung auf die zweiten Mittel wirkt, wird hier über spezielle schaltbare Sourcefolger, die die dritten Mittel 15 bilden, gespeist, wobei deren Speisestromquellen 47 an einer zentralen Stelle angeordnet sein können, so daß ein Paar dieser Stromquellen genügt. Die speziellen schaltbaren Sourcefolger bestehen aus den MOSFETs 44, 45 und 46 und werden über eine Steuerleitung 55 bedient, die im Beispiel von dem zu den zweiten Mitteln 13 der Stufe führenden Eingängen 14 nur deswegen abzweigt, da dies in den Schaltbildern der höheren Ebenen der hierfür geeignete Bus ist; ansonsten könnte das Steuersignal auch auf beliebige andere Weise zugeführt werden. Ist diese zu den Gates von 45 und 46 führende Steuerleitung 55 auf einem hohem Potential, sperren die P-Kanal MOSFETs 45 und die N-Kanal MOSFETs 46 ziehen das Gate des Sourcefolger - MOSFETs 44 auf niedriges Potential, so daß diese sperren und den Bus 19 nicht beeinflussen oder belasten. Da in diesem Fall die MOSFETs 45 keinen Kanal ausbilden, ist die kapazitive Belastung der inneren Knoten des Komparators sehr gering, zumal diese MOSFETs 45 so klein wie möglich ausgelegt werden. Somit ergibt sich im Normalbetrieb kein negativer Einfluß auf den Komparator. Im Kalibrierungsbetrieb dagegen wird die Steuerleitung 55 bei dem anzuwählenden Komparator auf niedriges Potential gebracht. In diesem Fall sperren die MOSFETs 46 und die MOSFETs 45 leiten, so daß das Gate des Sourcefolgers 44 mit den inneren Knoten des Komparators verbunden wird. Diese werden über den Sourcefolger 44 somit auf den Bus 19 aufgeschaltet.

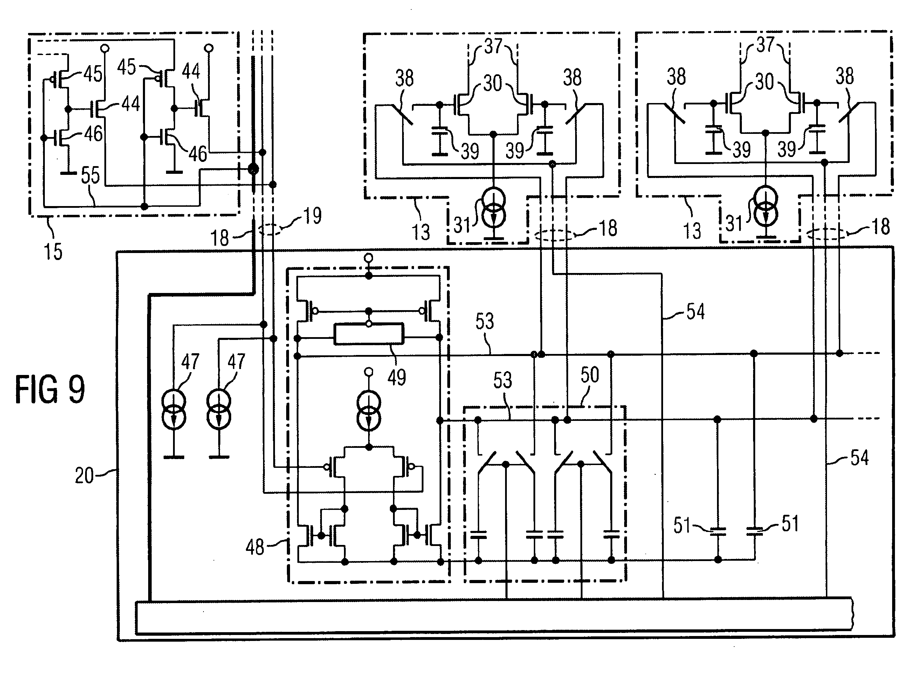

Figur 9 zeigt beispielhaft, wie die analoge Selbstkalibrierung in besonders vorteilhafter Weise realisiert werden kann. Innerhalb der vierten Mittel 20 sind hier alle Hilfsschaltungen angeordnet, die zu diesem Zweck notwendig sind. Ein voll differentiell aufgebauter Fehlerverstärker 48 mit Gleichtaktregelung der Ausgänge 49 (Common Mode Feedback) verarbeitet das über den Bus 19 von den dritten Mitteln 15 zugeführte differentielle Signal, welches vermöge der zu den dritten Mitteln 15 führenden Steuerleitungen 55 aus einem Steuerbus 18 auf den Bus 19 aufgeschaltet wird. Zuschaltbare Kompensationskapazitäten 50 und feste Kompensationskapazitäten 51 erzeugen zusammen mit der hohen Ausgangsimpedanz des Fehlerverstärkers an seinen Ausgängen 53 den für die Stabilität der Feedbackschleife erforderlichen dominanten Pol. Auch die ansonsten parasitäre Kapazität der von den vierten Mitteln zu den zweiten Mitteln führenden Busse 18 trägt bei dieser Schaltungsanordnung in vorteilhafter Weise ihren Teil zur Kompensation bei. Die schaltbaren Kompensationskapazitäten 50 haben den Zweck, abhängig von der Zahl in der Feedbackschleife befindlichen Stufen und damit einer veränderlichen Gesamtverstärkung im Feedbackpfad die jeweils notwendige Kompensation einstellbar zu machen, so daß sich in jedem Fall eine optimierte Einschwingzeitkonstante ergibt. Es sei darauf hingewiesen, daß der Fehlerverstärker und seine Kompensationskapazitäten auf jedem Fall notwendig sind, und es nicht möglich ist, eine solche Feedbackschleife direkt zu schließen, ohne diese beiden Mittel zwischenzuschalten. Es ist daher aus Flächengründen besonders vorteilhaft, diese beiden Mittel an zentraler Stelle pro gleichzeitig zu betreibender Feedbackschleife einmalig zu realisieren, statt sie jedem zweiten Mittel beifügen zu müssen, und die erfinderische Gesamtanordnung dieser Mittel und ihre besonders vorteilhaften Grundschaltungen nach den Figuren 6, 8 und 9 machen dies erst möglich und begründen einen Unteranspruch der Erfindung. Außer diesen analogen Hilfsschaltungen befindet sich auch ein digitales Steuerwerk 52 unter den vierten Mitteln, welches das erfindungsgemäße Selbstkalibrierungsverfahren verinnerlicht und dessen Durchführung vermöge der ersten, zweiten und dritten Mittel steuert. Die Abtastschalter der zweiten Mittel werden über die Steuerleitungen 54 gesteuert, die den Bussen 18 zugeordnet sind.

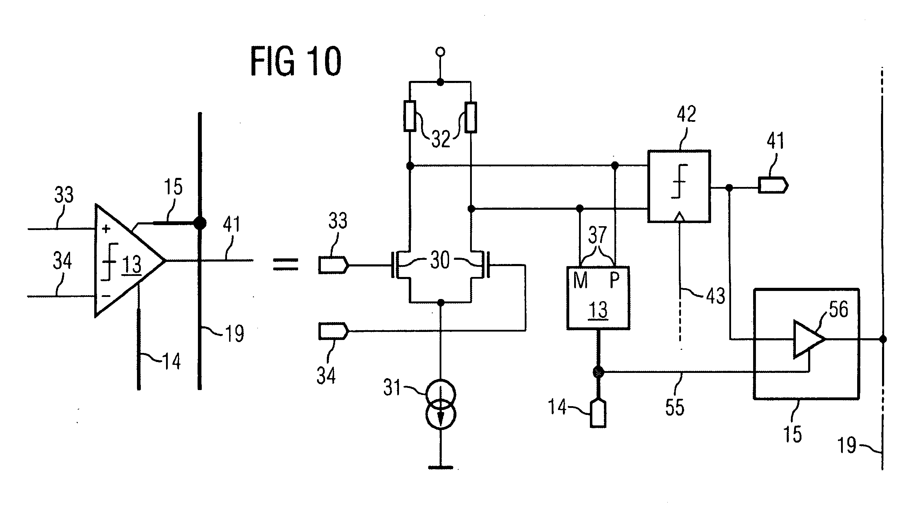

Figur 10 zeigt beispielhaft, wie die dritten Mittel 15 im Falle einer digitalen Speicherung der Kalibrierungswerte besonders vorteilhaft realisiert werden können. Es ist in diesem Fall zweckmäßig, alle Stufen des Komparators zu verwenden, diesen zu takten, und das digitale Signal nach dem getakteten Teil des Komparators 42 an dessen Ausgang 41 abzunehmen. Hier ist ein Tristate - Bustreiber 56 angeschlossen, dessen Ausgang auf den Bus 19 führt und der über die Steuerleitung 55 auf Bus 19 aufgeschaltet wird. Hat dieser Bus mehrere Signalleitungen, dann können beispielsweise auch mehrere Stufen gleichzeitig kalibriert werden, solange diese über eindeutige Signalpfade zu den Komparatoren verfügen, jedoch ist dies bei derzeitigen Architekturen von Folding - ADCs nur in Einzelfällen möglich. Eine bereits weiter oben erwähnte Möglichkeit der Realisierung der erfindungsgemäßen dritten Mittel nach den Ausgängen der Bubblegates oder des ROMs bzw. Encoders ist nicht so vorteilhaft wie die Lösung in Figur 10, da sie in jedem Fall einen Mehraufwand bedeutet und die Bubblegates oder den ROM bzw. Encoder verkompliziert und verlangsamt, da diese dann über zusätzliche Verknüpfungen verfügen müssen, um zu verhindern, daß andere Komparatoren die gezielte Beobachtung des Ausgangs des angewählten Komparators im Kalibrierungsmodus vereiteln würden.

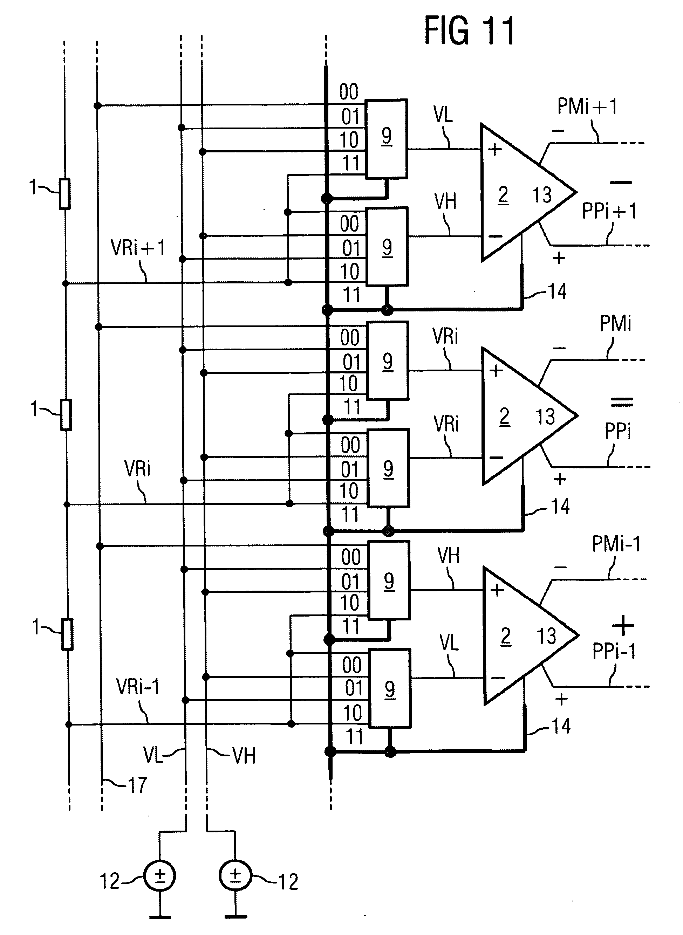

Die Figuren 11 bis 19 zeigen beispielhaft, wie die ersten Mittel der Vorverstärker realisiert werden können. Es gibt hierzu eine Vielzahl von Varianten, die abhängig von den Rahmenbedingungen besonders vorteilhaft sein können oder nicht. Im einfachsten Fall, der wegen seiner Trivialität nicht bildlich dargestellt werden soll, würde es genügen, daß diese Mittel nur in der Lage sind, die Vorverstärker in einen Gleichgewichtszustand zu bringen, indem ihr mit dem Eingangssignal des ADC verbundener erster Eingang auf ein dem Potential ihres zweiten Eingangs entsprechenen Knoten umgeschaltet werden kann, wobei der zweite Eingang fest mit der Referenzkette verbunden bleibt.

Dieser Trivialfall kann beispielsweise durch einen steuerbaren Umschalter realisiert werden, der den ersten Eingang wahlweise mit dem Eingang des ADC oder dem zweiten Eingang verbindet, was zwei Wirkungen der ersten Mittel entspricht.

Für den Fall, daß die Vorverstärker mit der Faltungsstufe zusammengefaßt sind, müssen, wie bereits weiter oben erwähnt, die ersten Mittel der Vorverstärker die erfindungsgemäßen ersten Mittel für Faltungsstufen vorgesehen werden. Dies folgt daraus, da hier die Vorverstärker auch eine Faltungsoperation durchführen. Die erfindungsgemäßen ersten Mittel für Faltungsstufen haben aber die kennzeichnende Eigenschaft der mindestens vier Wirkungen. Im Falle der Vorverstärker, der ersten Stufe des Folding - ADCs, wurden hier gegenüber der Realisierung der ersten Mittel für reine Faltungsstufen nach Figur 4 aber verschiedene Möglichkeiten zur vorteilhaften Reduktion des Schaltungsaufwandes gefunden, die sich jeweils in einem Unteranspruch der Erfindung niederschlagen.

Figur 11 zeigt beispielhaft, wie die direkte und geradlinige Umsetzung der Erfindung nach der bisher offenbarten Lehre ohne Versuch der Reduktion des Schaltungsaufwandes realisiert werden könnte. Es befinden sich die aus Figur 4 bekannten ersten Mittel vor den Vorverstärkern, sind aber mit 9 bezeichnet, da sie hier den Vorverstärkern zugeordnet sind.

In einem ersten Betriebszustand 00 verbinden sie den mit Plus bezeichneten ersten Eingang des Vorverstärkers 2 mit dem Eingangssignal 17 des ADC, den mit Minus bezeichneten zweiten Eingang mit der dem Vorverstärker zugeordneten Anzapfung VRi+1, VRi oder VRi-1 des Referenzspannungsteilers 1. Dieser Betriebszustand realisiert die erste Wirkung der ersten Mittel, die für den Normalbetrieb und während des Kalibrierungsvorgangs benutzt wird.

In einem zweiten Betriebszustand 01 wird der erste Eingang mit einer niedrigen Hilfsspannung VL verbunden, der zweite Eingang mit einer höheren Hilfsspannung VH, die jeweils aus Spannungsquellen 12 stammen. In diesem Fall ergibt sich eine negative Aussteuerung der differentiellen Ausgänge PMi+1 und PPi+1 des Vorverstärkers, im Figur mit Minus symbolisiert.

Dies realisiert die zweite Wirkung der ersten Mittel, die während des Kalibrierungsvorgangs benutzt wird.

In einem dritten Betriebszustand 10 wird der erste Eingang mit einer höheren Hilfsspannung VH verbunden, der zweite Eingang mit einer niedrigeren Hilfsspannung VL. In diesem Fall ergibt sich eine positive Aussteuerung der Ausgänge PMi-1 und PPi-1 des Vorverstärkers, im Figur mit Plus symbolisiert. Dies realisiert die dritte Wirkung der ersten Mittel, ebenfalls für den Kalibrierungsvorgang.

In einem vierten Betriebszustand 11 wird der erste Eingang und der zweite Eingang mit der dem Vorverstärker zugeordneten Anzapfung VRi+1, VRi oder VRi-1 des Referenzspannungsteilers 1 verbunden, so daß sich ein Gleichgewichtszustand an den Ausgängen PMi und PPi ergibt, im Figur durch ein Gleichheitszeichen symbolisiert. Dies realisiert die vierte Wirkung der ersten Mittel, welche während des Kalibrierungsvorgangs benutzt wird, wenn dieser Gleichgewichtszustand vermöge der zweiten Mittel auf Soll geführt werden soll.

In diesem Figur wurde davon ausgegangen, daß sich die ersten Mittel der Stufen von oben nach unten in den Betriebszuständen 01, 11, 10 befinden. Diese Variante ist am einfachsten verständlich, und eignet sich besonders zur Offenbarung des Prinzips, ist aber eine praktische Realisierung nur dann besonders vorteilhaft, wenn alle Stufen des Folding - ADC nach dem Baukastenprinzip identisch aufgebaut werden sollen, um Entwurfs- und Layoutaufwand zu sparen. Ansonsten ist ihr Schaltungsaufwand größer als nötig.

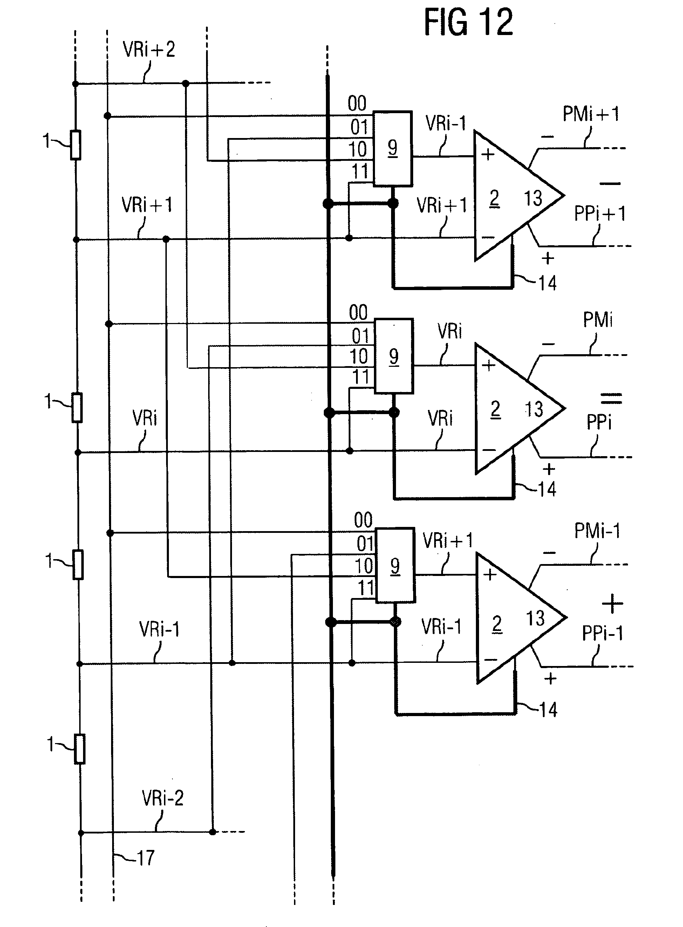

Figur 12 zeigt eine beispielhafte Realisierungsmöglichkeit mit geringerem Aufwand, was einen besonderen Vorteil darstellt. Hier wurde darauf verzichtet, erste Mittel am zweiten Eingang des Vorverstärkers zu realisieren. Statt der Hilfsspannungsquellen 12 von Figur 11, die ebenfalls entfallen, werden für jede Stufe jeweils geeignete Potentiale aus der Referenzkette abgenommen, um die vier Wirkungen der ersten Mittel zu erzielen. Eine mögliche Variante wäre die Verwendung jeweils noch weiter entfernter Anzapfungen, z.B. VRi-2 oder VRi-3 statt VRi-1 beim obersten Vorverstärker, und bei den anderen sinngemäß, um eine stärkere Aussteuerung erzielen zu können.

Figur 13 zeigt eine Variationsmöglichkeit von Figur 12, bei der erste Mittel mit weniger als vier Eingängen zum Einsatz kommen, um die sie kennzeichnenden mindestens vier Wirkungen zu erzielen. Dieses Beispiel ist zwar für die Praxis nicht vorteilhaft, da aufwendiger als das vorangegangene Beispiel, illustriert aber die prinzipielle Möglichkeit, bei den ersten Mitteln mit weniger als vier Eingängen auszukommen, so daß die Zahl ihrer Eingänge keine kennzeichnende Eigenschaft der ersten Mittel sein kann, sondern nur die Zahl ihrer Betriebszuständen bzw. Wirkungen.

Figur 14 schließlich zeigt anhand eines Ausschnitts aus Figur 2 die dort bereits gezeigte Variante der Ausgestaltung der ersten Mittel mit je drei Eingängen. Die Gleichgewichtszustände werden hierbei entweder durch die gleichzeitige Zuführung von VL oder von VH an beide Eingänge des Vorverstärkers erzielt. Diese Variante führt zu einem besonders einfachen und daher vorteilhaften Layout, allerdings erfordert sie Vorverstärker mit hoher Gleichtaktunterdrückung der Eingänge.

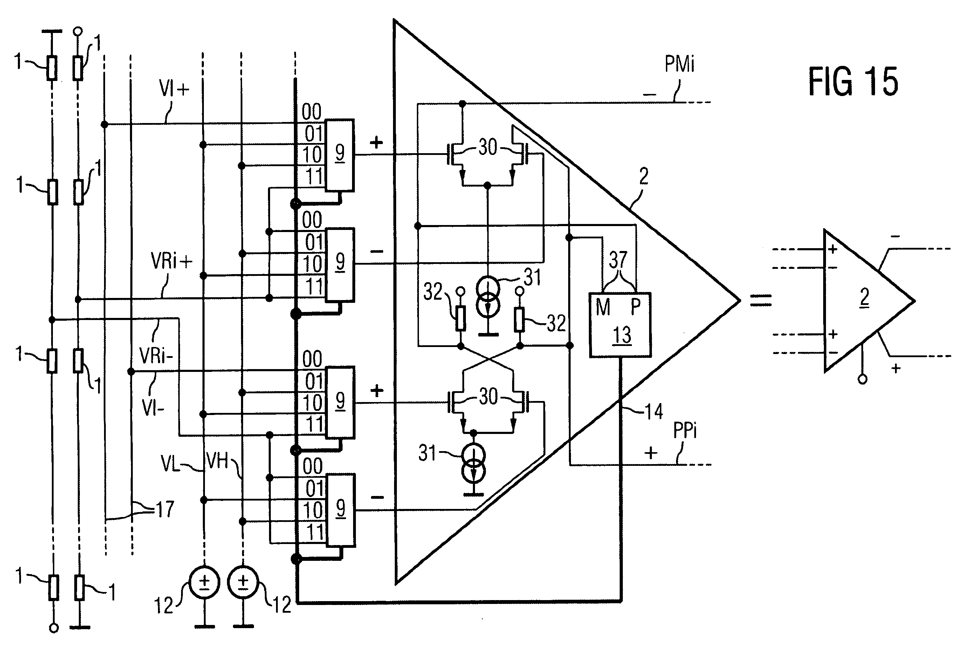

Figur 15 zeigt beispielhaft, wie die Grundschaltung von Figur 11 im Falle eines Folding - ADC mit zwei differentiellen Eingängen 17 erweitert werden kann. Hierzu ist eine Aufdoppelung der Referenzkette mit gegenläufigen Spannungen vorteilhaft, was zu einer Unterdrückung linearer Gradienten innerhalb der Referenzkette beiträgt. Wenn dies nicht nötig ist, könnten die gegenläufigen Referenzpotentiale auch an einer einzelnen Referenzkette abgenommen werden, was aber im Schaltbild und Layout zu einem großen Verdrahtungsaufwand führen würde, was nicht vorteilhaft ist. Die Vorverstärker 2 bekommen ein Paar von differentiellen Eingängen, d.h. es wird ein zusätzliches Differentialpaar mit seiner Fußstromquelle hinzugefügt, das auf dieselben Lastelemente 32 wirkt, wie das erste Differentialpaar. Dies ist eine dem Stand der Technik schon lange bekannte Methode, voll differentielle Eingangsstufen von ADCs auszuführen. Für die hier vorliegende Erfindung ist es jedoch relevant und genau zu beachten, daß das zweite Differentialpaar üblicherweise im umgekehrten Sinne auf die Lastelemente wirkt, als das erste Differentialpaar, so daß die Eingänge der ersten Mittel 9 entsprechend im umgekehrten Sinne beschaltet werden müssen, um die erfindungsgemäßen vier Wirkungen in richtiger Weise hervorbringen zu können. Diese Komplikation darzustellen, und die Anwendbarkeit der Erfindung auch für diesen Fall zu belegen, ist der Zweck von Figur 15. Entsprechend dieses Beispiels können die Varianten gemäß der Figuren 12...14 auch auf differentielle Eingänge erweitert werden.

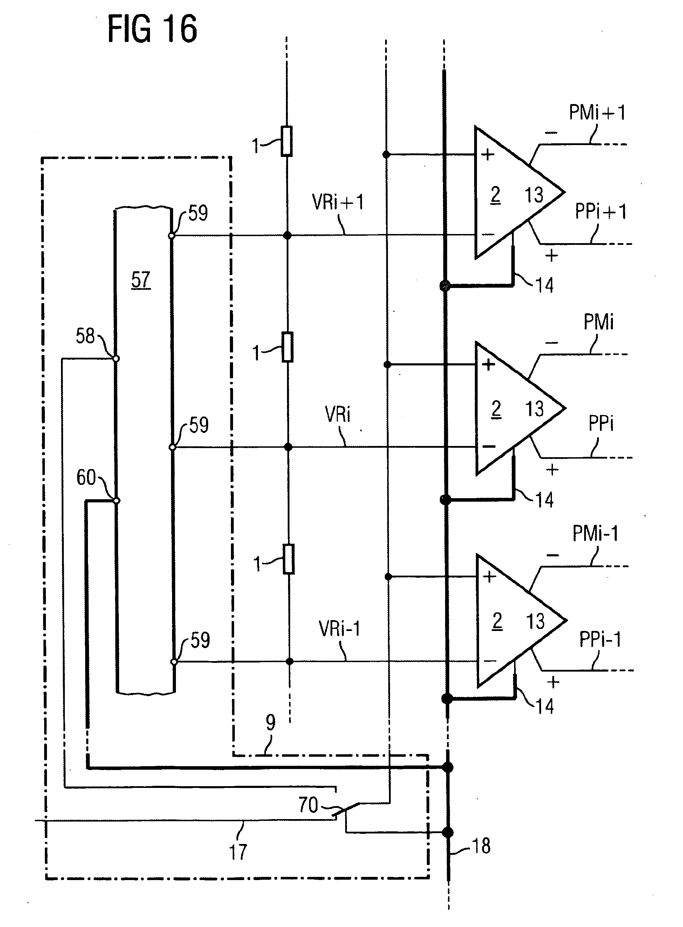

Figur 16 zeigt beispielhaft, wie die erfindungsgemäßen ersten Mittel im Falle echter Vorverstärker, die sich auf diese Aufgabe beschränken, und daher keine Faltungsoperation mit ausführen müssen, da diese ausschließlich in nachfolgenden Faltungsstufen stattfindet, in besonders vorteilhafter Weise mit geringem Aufwand realisiert werden können. Die Eingänge 59 eines Multiplexers 57 werden mit den Anzapfungen des Referenzspannungsteilers verbunden. Der Ausgang 58 des Multiplexers wird mit einem ersten Eingang eines steuerbaren Umschalters 70 verbunden. Der zweite Eingang des steuerbaren Umschalters ist mit dem Eingang 17 des ADC verbunden, der Ausgang des steuerbaren Umschalters führt auf die ersten Eingänge der Vorverstärker 2, deren zweite Eingänge mit den Anzapfungen des Referenzspannungsteilers verbunden sind. Über den Steuereingang 60 des Multiplexers, der mit den von den vierten Mitteln kommenden Steuerleitungen aus Bus 18 verbunden ist, der außerdem eine Steuerleitung für den steuerbaren Umschalter enthält, kann im Kalibrierungsmodus ein geeignetes Potential aus dem Referenzspannungsteiler ausgewählt und über den Multiplexer und den Umschalter mit den zweiten Eingängen der Vorverstärker verbunden werden. Auf diese Weise kann für jeden Vorverstärker der zu kalibrierende Gleichgewichtszustand bewirkt werden.

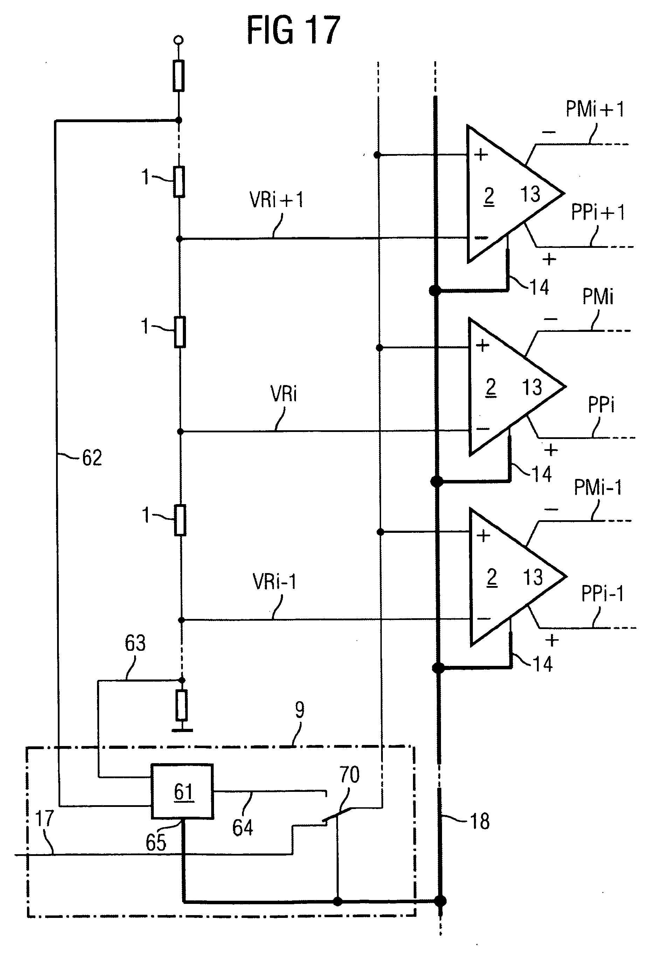

Figur 17 zeigt eine besonders vorteilhafte und erfinderische Variante der Idee aus Figur 16, deren besonderer Vorteil darin besteht, auch Mismatchfehler der einzelnen Anzapfungen der Referenzkette durch Selbstkalibrierung beseitigen zu können. Diese Fehler sind im Gegensatz zu einem Gradienten, der durch geeignete Layoutmaßnahmen weitgehend unterdrückt werden kann, dadurch charakterisiert, daß die einzelnen Widerstände zwischen den Anzapfungen statistischen Schwankungen um einen Mittelwert unterliegen, und daher - wieder nach den bekannten Matchinggesetzen - eine gewisse Fläche nicht unterschreiten dürfen. Soll nun die Referenzkette selbst mit optimal minimierter Fläche ausgelegt werden, so wird der entstehende Fehler rasch zu groß und kann nur durch Einbeziehung der Referenzkette in die Selbstkalibrierung wieder auf den erforderlichen geringen Wert zurückgeführt werden. Dies gelingt in erfinderischer Weise durch Verwendung eines Digital / Analogwandlers 61. Dieser DAC bezieht seine obere Referenzspannung 62 aus dem höchsten Potential in der Referenzspannungsteilerkette 1, seine untere Referenzspannung 63 aus deren niedrigsten Potential.

Der Ausgang 64 des DAC führt auf einen ersten Eingang des steuerbaren Umschalters 70. Der Eingang 17 des ADC führt auf den zweiten Eingang des steuerbaren Umschalters. Der Ausgang des steuerbaren Umschalters führt auf die ersten Eingänge der Vorverstärker 2, deren zweite Eingänge mit den Anzapfungen des Referenzspannungsteilers verbunden sind. Über den Steuereingang 65 des DAC, der mit dem von den vierten Mitteln kommenden Steuerleitungen 18 verbunden sind, die auch eine Steuerleitung für den steuerbaren Umschalter enthalten, kann im Kalibrierungsmodus der DAC angewiesen werden, eine entsprechend genaues Kalibrierungspotential über den steuerbaren Umschalter auf die ersten Eingänge der Vorverstärker zu legen. Die mismatchbedingten statistischen Fehler der Referenzpotentiale an den Anzapfungen des Referenzspannungsteilers können dann wie etwaige Offsetspannungen der Eingangsdifferentialpaare zusammen mit diesen über die zweiten Mittel minimiert werden. Einen hinreichend genauen DACs zu realisieren ist dem Stand der Technik kein Problem, da dieser nicht mit hoher Geschwindigkeit zu arbeiten braucht, und sich daher langsamer, aber hochlinearer Schaltungstechniken bedienen kann. Im Falle der Kalibrierung im Hintergrund ist es beispielsweise möglich, daß der DAC seinen Ausgangswert über einen längeren Zeitraum erzeugt, in dem der ADC im Normalbetrieb arbeitet, so daß der Ausgangswert für einen eingeschobenen Selbstkalibrierungsschritt verzugslos zur Verfügung steht.

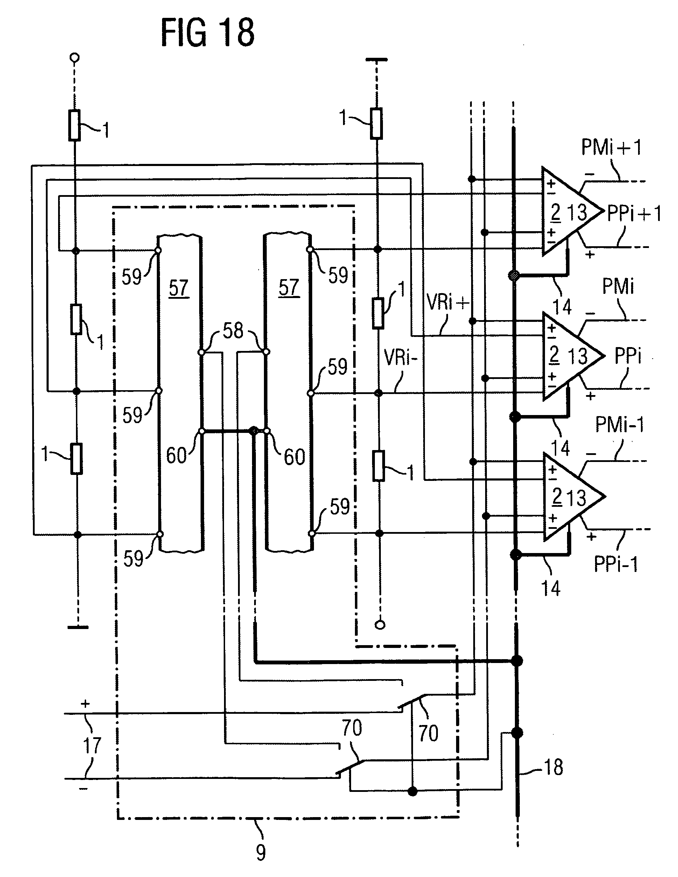

Figur 18 zeigt eine mögliche Realisierung der Schaltung aus Figur 16, wenn der ADC einen differentiellen Eingang erhalten soll. Die Grundmethode der verdoppelten Referenzkette und die notwendigen Vorverstärker mit zwei differentiellen Eingangspaaren sind bereits aus Figur 15 bekannt. Sinngemäß sind beim Übergang von Figur 16 zu Figur 18 auch die Multiplexer 57 und die steuerbaren Umschalter 70 zu verdoppeln, d.h. für jeden der nun zwei Eingangssignalpfade des ADC sind diese Mittel sinngemäß wie in Figur 16 vorzusehen. Besonders vorteilhaft ist es hier, den in den Multiplexern enthaltenen Dekoder gemeinsam für beide Multiplexer auszuführen, was im Figur aus Gründen der Übersichtlichkeit nicht dargestellt ist.

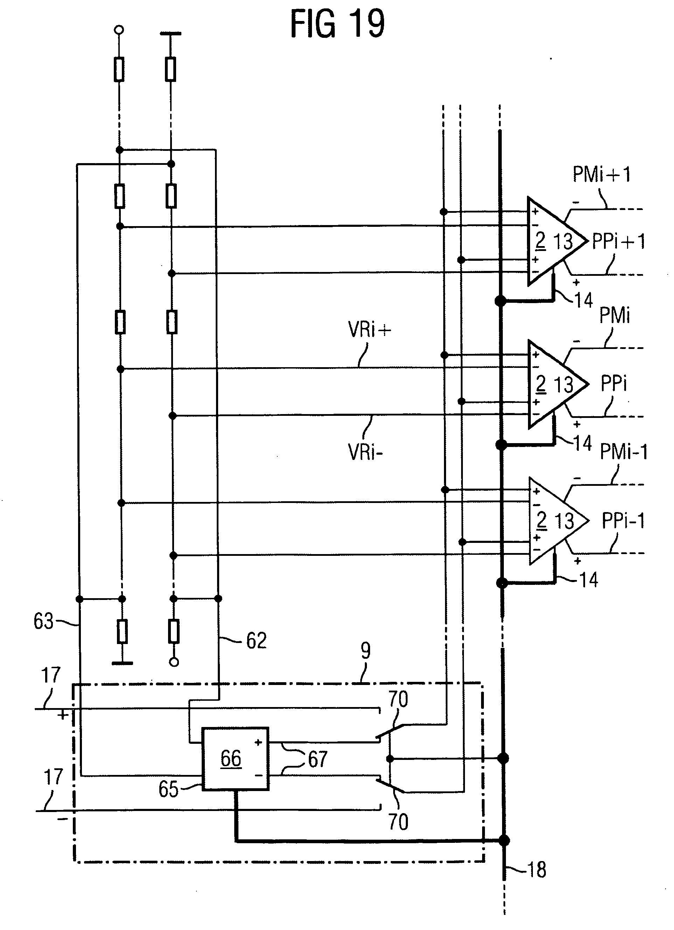

Figur 19 zeigt die besonders vorteilhafte Ausbildung aus Figur 17 für den Fall eines differentiellen Eingangs des ADC. Sinngemäß sind auch hier die Mittel in den Signalpfaden aufzudoppeln, wobei der DAC 66 jedoch als balancierter voll differentieller DAC, d.h. mit um die Referenzspannungsmitte balancierten differentiellen Ausgängen, ausgeführt werden sollte, und nicht nur als einfache Zusammenschaltung zweier DACs mit singulärem Ausgang. Eine weitere Feinheit für bestmögliche Resultate ist die möglichst niederohmige Zusammenschaltung der Enden der beiden gegenläufigen Referenzketten, die dem DAC als Referenzspannung zugeführt werden, wie im Figur dargestellt.

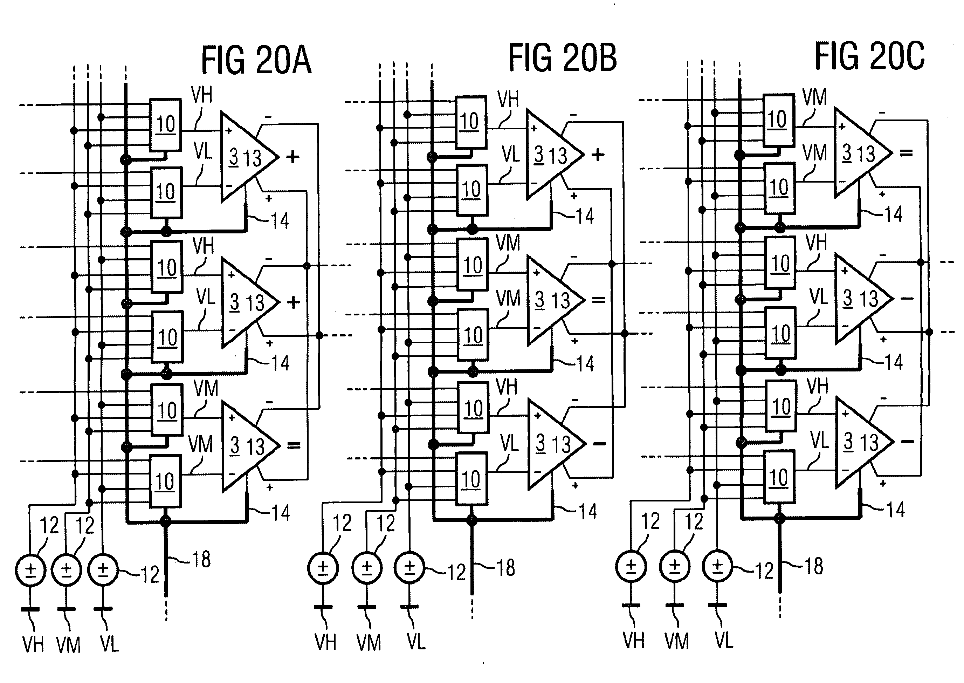

Die Figuren 20a bis c stellen die vier kennzeichnenden Wirkungen der ersten Mittel für Faltungsstufen und ihren Einsatz während des Kalibrierungsvorgangs beispielhaft dar. Bei Faltungsstufen sind die Ausgänge einer Anzahl von Differenzverstärkern in abwechselnden Sinn zusammengeschaltet, d.h. das Innenleben der Symbole 3 oder 4 unterscheidet sich nicht notwendigerweise vom Innenleben eines Vorverstärkers und ist beispielhaft in Figur 5 zu finden. Für den Faltungsprozeß ist immer eine ungerade Anzahl von Differenzverstärkern zusammengeschaltet, da sonst die Faltung nicht zirkular geschlossen werden kann. Für Folding - ADCs gilt prinzipiell, daß immer nur ein Differenzverstärker einer zusammengeschalteten Gruppe im oder nahe dem Gleichgewicht ist, während die restlichen Differenzverstärker der Gruppe so ausgesteuert sind, daß sich ihre Wirkungen gegenseitig aufheben, so daß nur der eine im oder nahe dem Gleichgewicht befindliche Differenzverstärker effektiv auf die Ausgänge wirkt. Diese rekonvergenten Signalpfade sind es, die dem bisherigen Stand der Technik die Selbstkalibrierung des Folding - ADCs unmöglich gemacht haben, bevor diese Erfindung es offenbarte, wie vermöge der erfindungsgemäßen ersten Mittel einzelne Pfade und damit einzelne Differenzstufen gezielt angewählt und gegen andere Pfade abgeschirmt werden können. Wie dies bewerkstelligt wird, ist in den einzelnen Phasen in den Figuren 20a bis c beispielhaft dargestellt. Würden mehr als drei Differenzstufen zusammengeschaltet sein, z.B. fünf oder sieben usw., gilt das Folgende sinngemäß. Es gilt im Folgenden weiterhin die Konvention, daß die Anordnung der Differenzstufen innerhalb der Faltungsstufen so ist, daß im Normalbetrieb diese mit steigender Eingangsspannung des ADC von unten nach oben aktiviert werden.

In Figur 20a ist dargestellt, wie die unterste Differenzstufe angewählt und gegen die beiden oberen abgeschirmt werden kann. Durch die vierte Wirkung der ersten Mittel wird für diese eine Differenzstufe der Gleichgewichtszustand erzwungen, indem beide Eingänge auf ein gleiches Potential, hier VM, gelegt werden. Alle in der Reihenfolge darüber liegenden Differenzstufen werden mit Hilfe der dritten Wirkung der ersten Mittel so angesteuert, daß sie in eine erste Richtung voll ausgesteuert werden. Durch die abwechselnd gleich- und gegensinnige Zusammenschaltung der Ausgänge heben sich die Wirkungen alle ausgesteuerten Stufen auf, und nur die unterste Differenzstufe wirkt effektiv auf die Ausgänge.

In Figur 20b ist dargestellt, wie die mittlere Differenzstufe angewählt und gegen die beiden oberen abgeschirmt werden kann. Die vierte Wirkung der ersten Mittel wird für diese eine Differenzstufe der Gleichgewichtszustand erzwungen, indem beide Eingänge auf ein gleiches Potential, hier VM, gelegt werden. Alle in der Reihenfolge darüber liegenden Differenzstufen werden mit Hilfe der dritten Wirkung der ersten Mittel so angesteuert, daß sie in eine erste Richtung voll ausgesteuert werden. Alle in der Reihenfolge darunter liegenden Differenzstufen werden mittels der zweiten Wirkung der ersten Mittel so angesteuert, daß sie in eine zweite Richtung voll ausgesteuert werden, die der ersten Richtung gegensinnig ist. Durch die abwechselnd gleich- und gegensinnige Zusammenschaltung der Ausgänge heben sich die Wirkungen aller ausgesteuerten Stufen auf, und nur die mittlere Differenzstufe wirkt effektiv auf die Ausgänge.

In Figur 20c ist dargestellt, wie die obere Differenzstufe angewählt und gegen die beiden anderen abgeschirmt werden kann. Durch die vierte Wirkung der ersten Mittel wird für diese eine Differenzstufe der Gleichgewichtszustand erzwungen, indem beide Eingänge auf ein gleiches Potential, hier VM, gelegt werden. Alle in der Reihenfolge darunter liegenden Differenzstufen werden mittels der zweiten Wirkung der ersten Mittel so angesteuert, daß sie in die zweite Richtung voll ausgesteuert werden. Durch die abwechselnd gleich- und gegensinnige Zusammenschaltung der Ausgänge heben sich die Wirkungen aller ausgesteuerten Stufen auf, und nur die oberste Differenzstufe wirkt effektiv auf die Ausgänge.

Beim Aufbau eines Signalpfades durch den Folding - ADC über nachfolgende Stufen gilt das obige genauso, nur wird bei derjenigen Differenzstufe, über die der Signalpfad führen soll, die erste Wirkung der ersten Mittel statt der vierten Wirkung eingestellt, so daß der Signalpfad sich über die regulären Eingänge der Stufe wie beim Normalbetrieb ergibt.

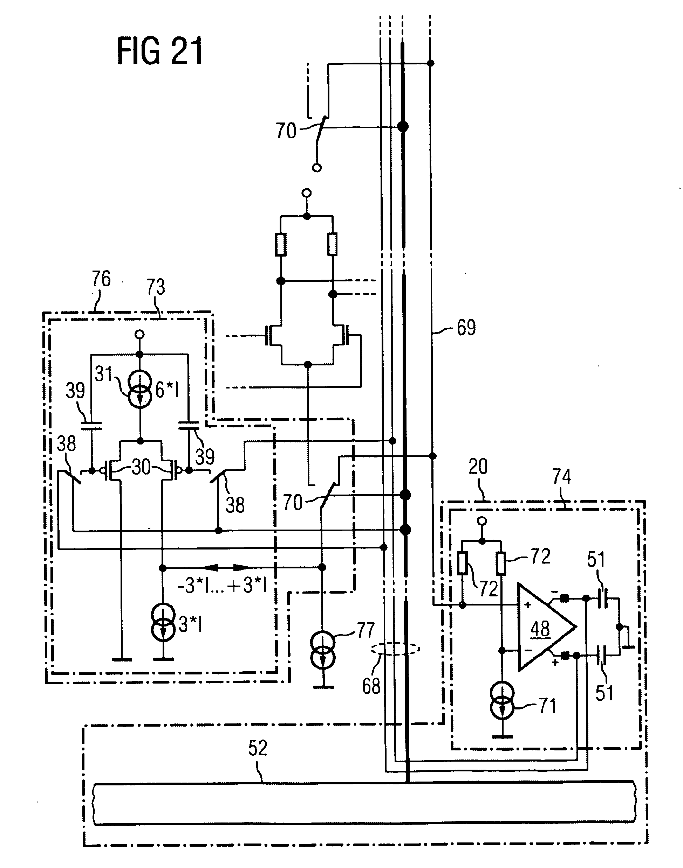

In Figur 21 ist beispielhaft eine Anordnung gezeigt, auch einzelne Stromquellen innerhalb des Folding - ADC auf Sollwert kalibriert werden können. Dies kann bei einigen Architekturen von Foldingwandlern, insbesondere solchen mit Interpolator, notwendig sein. Der Stand der Technik kennt zwar den sogenannten dynamischen Stromkopierer, der auch dazu genutzt werden kann, eine Vielzahl von Stromquellen gleichen Stroms zu realisieren, jedoch hat diese Lösung Nachteile, wie zu geringe Genauigkeit aufgrund zu geringer Verstärkung und beschränkte Speicherzeit. Eine besonders vorteilhafte Ausbildung, wie eine Vielzahl von Stromquellen gleichen Stroms realisiert werden kann, die diese Nachteile nicht hat, wird in Figur 21 dargestellt, bei der jeder zu kalibrierenden Stromquelle fünfte Mittel hinzugefügt werden, mit denen die Kalibrierung der so ausgestatteten Stromquellen auf einen von einer Sollstromquelle gelieferten Sollstrom ermöglicht wird, wobei der Vergleich der Ströme in einem Stromvergleicher geschieht, der in einer Weise realisiert ist, so daß nur so viele Stromvergleicher benötigt werden, wie Stromquellen gleichzeitig kalibriert werden sollen.

Die fünften Mittel 76 können mit einem steuerbaren Umschalter 70, und einer analog stellbaren Stromquelle mit analogem Stellwertspeicher 73, der in ähnlicher Weise aufgebaut ist wie die zweiten Mittel nach Figur 6, realisiert werden. Der Unterschied von Block 73 zu Figur 6 besteht hier zunächst darin, daß die Schaltung komplementär aufgebaut ist, also mit p-Kanal-MOSFETs statt n-Kanal-MOSFETs, weil dies für eine auf Masse führende Stromquelle 77 wie in der Figur zweckmäßig ist. Bei einer auf die Versorgungsspannung führenden Stromquelle, wie 31, würde die Schaltung von 76 bei n-Kanal-MOSFETs bleiben können. Der zweite Unterschied besteht darin, daß ein Ausgang des Differentialpaars auf Masse führt, und der andere auf eine auf Masse führende Stromquelle, die einen halb so großen Strom 3*I nach Masse ableitet, als der Strom 6*I beträgt, den die Fußstromquelle 31 des Differentialpaars 30 an dieses liefert. Je nach Aussteuerung des Differentialpaars über seine an die Haltekondensatoren 39 angeschlossenen und über die Abtastschalter 38 steuerbaren Eingänge ergibt sich aus Block 73 ein Ausgangsstrom von +3*I bis -3*I, der sich zu dem Strom der Stromquelle 77 addiert bzw. subtrahiert, so daß diese immer auf Sollstrom gebracht werden kann, wenn der Betrag 3*I hinreichend groß ist, um den Mismatchfehlerbereich von Stromquelle 77 überstreichen zu können. Eine mögliche Variante wäre, die mit 3*I bezeichnete Stromquelle wegzulassen, und den entsprechenden Vorhalt in die Stromquelle 77 einzubauen, nur wäre dann die Funktionsweise nicht so deutlich darstellbar. Zum Erreichen des Zwecks der Schaltung ist es weiterhin erforderlich, den oben erwähnten korrigierten Strom, der sich aus der Addition der Ströme aus Block 73 und der Stromquelle 77 ergibt, mit dem Sollstrom vergleichen zu können. Zu diesem Zweck enthalten die fünften Mittel den steuerbaren Umschalter 70, der diesen Strom wahlweise auf den Verbraucher, hier die unbeschriftete Differenzstufe, führt, oder über eine Sammelleitung 69 zu den vierten Mitteln 20, wo sich ähnlich wie im Fall von Figur 9 weitere Hilfsschaltungen für den Kalibrierungsvorgang an zentraler Stelle befinden. Dieser Ort für die Hilfsschaltungen ist eine Konventionssache, und muß natürlich nicht unbedingt in den vierten Mitteln liegen, um dieselbe erfindungsgemäße Funktion zu haben. Zum Zweck der Übersichtlichkeit der Darstellung ist diese Konvention aber nützlich, zumal die vierten Mittel jene sind, die das Selbstkalibrierungsverfahren verinnerlichen, und die hierfür notwendigen zentralen Mittel enthalten. Im Falle der Kalibrierung von Stromquellen bestehen diese zusätzlichen zentralen Mittel aus mindestens einem Stromvergleicher 74, der wiederum aus einer Sollstromquelle 71, einem Paar von Vergleichswiderständen 72 und einem differentiellen Fehlerverstärker 48 mit seinen Kompensationskapazitäten 51 besteht. Letztere dienen dazu, um in der Feedbackschleife den zur Stabilität notwendigen dominanten Pol einzuführen. Das Prinzip, die Schleife zu schließen, ist dasselbe wie bei Figur 9 und gelingt über einen von den vierten Mitteln zu den fünften Mitteln führenden Steuerbus 68, von denen zwei analoge differentielle Signalleitungen von dem Stromvergleicher 74 zu den Signaleingängen der Abtastschalter 38 innerhalb der fünften Mittel führen. Ferner umfaßt der Steuerbus 68 auch eine Anzahl von digitalen Steuerleitungen, die von dem digitalen Steuerwerk 52 innerhalb der vierten Mittel ausgehen und die die Abtastschalter 38 eines der fünften Mittel schließen und öffnen. Schaltbare Kompensationskapazitäten wie im Falle von Figur 9 sind bei der Stromkalibrierungsschleife meist nicht notwendig, da die zusätzliche Verstärkung innerhalb der Schleife nur von der Steilheit des MOSFETs 30 der Stromquelle 73 und dem Wert des Vergleichswiderstands 72 abhängt, und um das Produkt der beiden Parameter und damit die Verstärkung gleichzuhalten genügt es, die Steilheit aller stellbaren Stromquellen 73 in etwa gleich auszulegen. Sollte dies nicht möglich sein, kann eine in etwa gleich große Verstärkung durch einfachste Erweiterungen der Schaltung erzielt werden, z.B. in dem der auf die Sammelleitung 69 führende Widerstand mit Anzapfungen ausgeführt wird und der Eingang des Fehlerverstärkers 48 über einen von 52 stellbaren Multiplexer auf die jeweils geeignete Anzapfung umgeschaltet wird, bei der sich die gewünschte Verstärkung ergibt. Eine weitere ebenso einfache Alternative wäre, mehrere Vergleichswiderstandspaare 72 mit unterschiedlichen Werten vorzusehen und diese umschaltbar zu machen, so daß die Verstärkung immer gleich gewählt werden kann. Diese Maßnahmen sind wegen ihrer Trivialität nicht bildlich dargestellt.

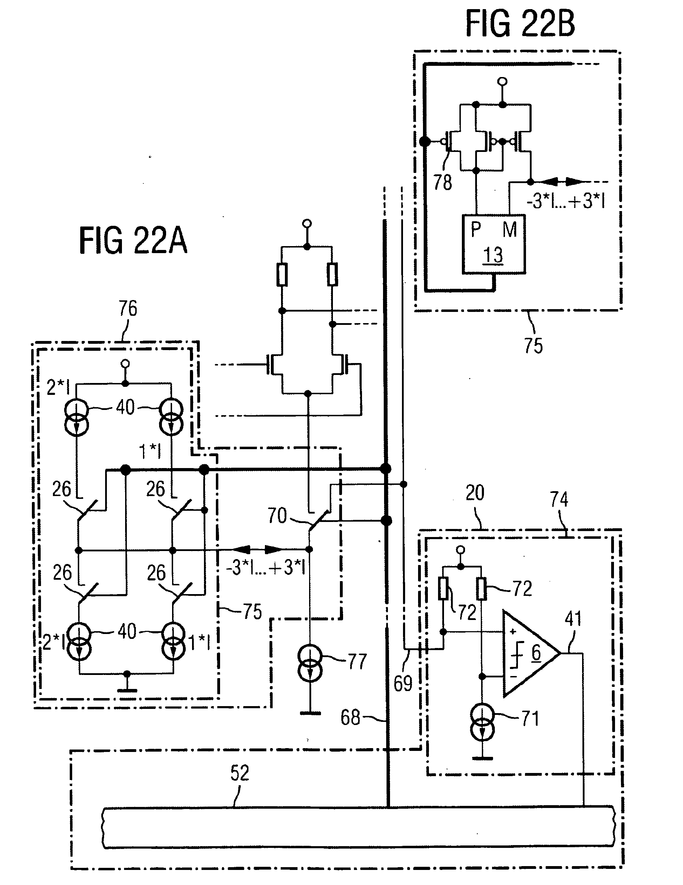

Figur 22 zeigt eine Variante von Figur 21, bei der die Stromquellen auf digitale Weise auf Sollwert getrimmt werden können. Diese Variante wurde aus Figur 21 abgeleitet, indem innerhalb der fünften Mittel 76 die analog stellbare Stromquelle 73 mit einer digital stellbaren Stromquelle 75 ersetzt wurde. Außerdem wurde der Fehlerverstärker im Stromvergleicher 74 durch einen Komparator 6 ersetzt, dessen Ausgang 41 auf das digitale Steuerwerk 52 innerhalb der vierten Mittel führt. Dieses Steuerwerk sucht diejenige Stellung der steuerbaren Schalter 26 innerhalb der digital stellbaren Stromquelle 75, bei der der Komparator gerade umschaltet. In diesem Fall stimmt der über den steuerbaren Umschalter 70 auf die Sammelleitung 69 fließende Summenstrom mit dem von der Sollstromquelle 71 vorgegebenen Sollwert bestmöglich überein, der verbleibende Restfehler entspricht dem kleinsten Strom der gewichteten Stromquellen 40 innerhalb der digital stellbaren Stromquelle 75. Diese ist hier nur prinzipiell skizziert, insbesondere wurde weder ein Dekoder noch ein Register zur Speicherung des digitalen Kalibrierungswerts eingezeichnet, um die Darstellung nicht unnötig aufzublähen. In der Praxis sind diese Teile natürlich vorzusehen, und es empfiehlt sich, für die Realisierung des Blocks 75 eine Schaltung ähnlich der Grundidee aus Figur 7 zu nehmen, um die Anzahl der Stromquellen zu halbieren, wobei ein Ausgang auf einen Stromspiegel führt, um Ausgangsströme in beiden Richtungen zu ermöglichen, und ein zusätzlicher MOSFET 78 hilft, den Stromspiegel abzuschalten. Diese in der Praxis besonders vorteilhafte Ausführung der digital stellbaren Stromquelle 75 für die fünften Mittel ist in Figur 22b dargestellt, wurde aber nicht schon z. B. in Figur 2 eingesetzt, da sie weniger anschaulich ist als die gewählte Darstellung.

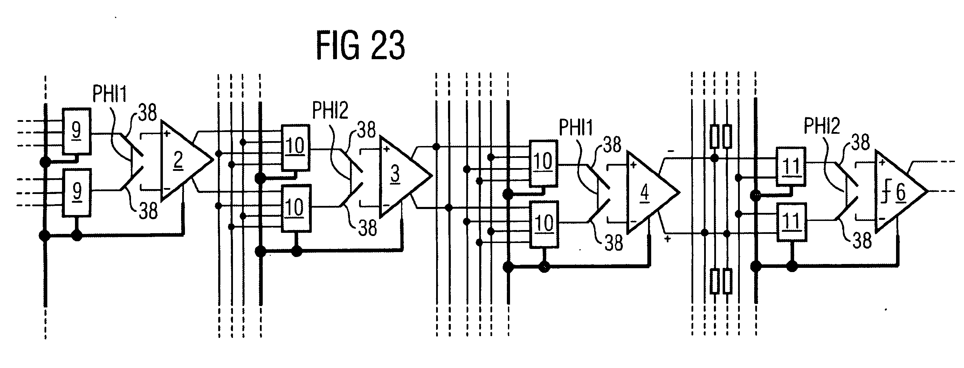

Die letzte Figur 23 schließlich zeigt einen Ausschnitt aus der Schaltung eines selbstkalibrierenden Folding - ADC, bei dem zwischen den Stufen zusätzliche Abtastschalter 38 angeordnet sind, die von einem nicht überlappenden Zweiphasentakt PHI1 und PHI2 derartig gesteuert werden, daß sich eine fließbändartige sogenannte "Pipeline" - Verarbeitung ergibt, was einen erheblichen Geschwindigkeitsvorteil bietet, da bei jedem Takt jeweils nur eine Stufe einschwingen muß, und nicht eine Kette bestehend aus mehreren Stufen. Dieses Prinzip an sich ist altbekannt und wird z.B. im sogenannten Pipeline - ADC benutzt. Bei Folding - ADCs war die Anwendung dieses Prinzips bisher nicht möglich, da Fehler durch unsymmetrische Ladungsinjektion an den Abtastschaltern die Signale verfälscht haben. Durch die Anwendung der erfindungsgemäßen Selbstkalibrierung des Folding - ADC ist es aber möglich, diese Fehler - wie andere Mismatchfehler auch - durch die Selbstkalibrierung zu beseitigen, es müssen hier lediglich vor der Kalibrierungsentscheidung auch die Abtastschalter 38 der zu kalibrierenden Stufe geöffnet werden, so daß sich ihr Fehler manifestiert, und damit ebenfalls in die Kalibrierungsentscheidung eingeht und somit ebenfalls herauskalibriert wird.

Das erfindungsgemäße Selbstkalibrierungsverfahren kann nach den obigen Ausführungen, die alle erfindungsgemäßen Mittel, ihre Wirkungen und praktischen Realisierungsmöglichkeiten derselben detailliert offenbart haben, im Folgenden beschrieben werden. In einem ersten Schritt werden - sofern dies vorgesehen ist - alle Stromquellen auf Sollwert gebracht, wozu sich die vierten Mittel der fünften Mittel bedienen. In den nachfolgenden Schritten wird eine Differenzstufe nach der anderen kalibriert, wobei die zu kalibrierende Differenzstufe über die vierte Wirkung der ersten Mittel in ein Gleichgewicht gebracht (sensibilisiert) wird, die unbeteiligten Differenzstufen über die zweite und dritte Wirkung der ersten Mittel daran gehindert (inhibitiert) werden den Signalpfad zu beeinflussen, und der Signalpfad über die erste Wirkung der ersten Mittel, die dem normalen Betrieb entspricht, über alle der sensibilisierten Differenzstufe nachfolgenden Differenzstufen bis zu den dritten Mitteln freigeschaltet wird. An dieser Stelle trifft das in den vierten Mitteln enthaltene digitale Steuerwerk die Kalibrierungsentscheidung, wie die zweiten Mittel zu stellen sind, um den Gleichgewichtszustand auf Soll zu bringen, bzw. läßt dies durch eine freigeschaltete analoge Feedbackschleife die Schaltung selbsttätig erledigen. Nach dem Einschwingen der analogen Feedbackschleife oder nach dem Feststellen des digitalen Stellwerts, bei dem sich ein Umkippen des Gleichgewichtszustandes ergibt, wird diese so gewonnene Kalibrierungsinformation der sensibilisierten Differenzstufe gespeichert. Im Falle der analogen Realisierung geschieht dies dadurch, daß das digitale Steuerwerk die Abtastschalter in den der Differenzstufe zugeordneten zweiten Mitteln öffnet, im Falle der digitalen Realisierung wird der ermittelte Wert in einem in den zweiten Mitteln enthaltenen Register oder an einer anderen geeigneten Stelle gespeichert. Das Selbstkalibrierungsverfahren beginnt mit der von dem Eingang des ADC am weitesten entfernt liegenden und mit den erfindungsgemäßen ersten und zweiten Mitteln ausgestatteten Stufe. Verfügen alle Stufen über diese Mittel, beginnt das Selbstkalibrierungsverfahren mit der Kalibrierung aller Differenzstufen der Komparatoren. Es folgt die Kalibrierung aller Differenzstufen der letzten Faltungsstufe. Sind diese kalibriert, kommt die jeweils vom Eingang des ADC aus betrachtete vorhergehende Stufe an die Reihe, bis die Kalibrierung der ersten Stufe erfolgt. Die Erfindung hat mehrere Varianten offenbart, wie diese erste Stufe kalibriert werden kann, darunter auch solche Varianten, die auch die Mismatchfehler der Referenzkette herauskalibrieren. Am Ende des Selbstkalibrierungsvorgangs steht ein nahezu idealer Folding - ADC bereit, der solange nahezu ideal bleibt, wie die gespeicherte Selbstkalibrierungsinformation gültig bleibt. Im Falle einer analogen Speicherung dieser Information sind es in der Regel die Leckströme der Abtastschalter, die die zeitliche Gültigkeit der Kalibrierung beeinträchtigen. Doch auch bei digitaler Speicherung gibt es eine zeitliche Grenze, da sich die Arbeitspunkte der Schaltung durch thermische Einflüsse verschieben. In beiden Fällen muß die Kalibrierungsinformation von Zeit zu Zeit aufgefrischt werden, was auch im Hintergrund geschehen kann. Bei dieser Methode wird alle N Umwandlungen des regulären Eingangssignals ein Takt eingeschoben, in dem ein Teilschritt des Selbstkalibrierungsverfahrens ausgeführt wird. Dies bewirkt dann ein langsames Mitführen und Anpassen der Selbstkalibrierungswerte während des normalen Betriebs des ADC. Ein erfinderisches System, in dem mittels eines Digitalfilters die alle N Takte entstehende Störung des quantisierten Datenstroms unterdrückt wird, ist Gegenstand eines anderen Patentantrags. Eine einfachere Lösung, eine Kalibrierung im Hintergrund auszuführen, besteht darin, jeden zweiten Takt des ADC eine reguläre Quantisierung des Eingangssignals, und in jedem anderen Takt des ADC einen Teilschritt der Selbstkalibrierung durchzuführen. Dies reduziert zwar die maximal mögliche effektive Datenrate auf die Hälfte, der ADC wird aber durch die erheblich geringeren Flächen, die das erfindungsgemäße Selbstkalibrierungsverfahren erlaubt, und damit geringere kapazitive Lasten, so viel schneller, daß dieser Verlust in der Regel mehr als ausgeglichen wird.

Die Erfindung kann allgemein zur Selbstkalibrierung von Strukturen mit konvergenten und rekonvergenten Signalpfaden angewandt werden.

Nachdem nun alle Grundlagen und Arbeitsweisen der Erfindung offenbart sind, sollte es dem durchschnittlichen Fachmann ohne weiteres möglich sein, die Erfindung zu realisieren. Es ist dem Fachmann ohne weiteres möglich, Variationen der dargestellten Schaltungen und Lösungen abzuleiten, die von der bildlichen Darstellung abweichen, aber dieselbe oder eine ähnliche Wirkungsweise haben. Insbesondere ist es dem Fachmann möglich, Schaltungsdetails zu verbessern, z.B. durch Einbau von Kaskoden, oder komplementäre Schaltungen abzuleiten, teilweise bipolare Transistoren statt der MOSFETs einzuführen, usw. Es ist auch möglich, mehrere Signalpfade gleichzeitig zu kalibrieren, wenn die erfindungsgemäßen vierten Mittel entsprechend ausgelegt werden und die von und zu den vierten Mitteln führenden Steuer- und Signalleitungsbündel entsprechend umfangreich ausgelegt werden.

Die vorstehend beschriebenen Vorrichtungen und Verfahren zur Selbstkalibrierung eines Faltungs-Analog/Digitalwandlers können - gegebenenfalls nach entsprechender Anpassung an die gegebenen Verhältnisse - auch bei anderen Analog/DigitalWandlern und auch bei sonstigen Schaltungen, die einen oder mehrere Verstärkerstufen, eine Sample-und-Hold-Stufe, und/oder einen Referenzspannungsteiler enthalten, zum Einsatz kommen.

Die beschriebenen Vorrichtungen und Verfahren werden im folgenden nochmals in allgemeinerer Form und unter Angabe möglicher Abwandlungen, vorteilhafter Weiterbildungen und weiterer Einsatzmöglichkeiten beschrieben.

Es wird mit der Vorrichtung und dem Verfahren zur Kalibrierung einer Gruppe von Verstärkerstufen begonnen, wobei
- unter "Gruppe von Verstärkerstufen" Schaltungsstrukturen aus Ketten oder Bäumen von Verstärkerstufen verstanden werden,
- die Gruppe von Verstärkerstufen Bestandteil einer integrierten Schaltung sein kann (aber nicht muß), und
- wobei Kalibrierung beispielsweise die Minimierung von Fehlern durch statistische Schwankungen der Bauteileparameter (Mismatch) bedeutet, oder die Einstellung einer bestimmten Eigenschaft, wie z.B. der Verstärkung der Stufen.

Schaltungsstrukturen aus Ketten oder Bäumen von Verstärkerstufen, im Text mit dem Oberbegriff "Gruppen von Verstärkerstufen" bezeichnet, da vielseitigste Topologievarianten auftreten können, finden sich beispielsweise in sogenannten Flash- oder Folding - Analog / Digitalwandlern, ADC, die viele, fallweise hunderte oder tausende, einzelne Verstärkerstufen enthalten können, die in sinnvoller Weise zu Gruppen von Verstärkerstufen verschaltet sind.

Figur 24 zeigt ein typisches Beispiel einer Verstärkerstufe für ADCs, für die sich die Erfindung besonders eignet, sowie das in den späteren Figuren dafür benutze Symbol.

Es sei bereits an dieser Stelle darauf hingewiesen, daß die Erfindung auch bei vielen anderen Typen von Verstärkern nutzbringend eingesetzt werden, wenn von diesen eine größere Anzahl, d.h. eine Gruppe, vorhanden ist, und eine Kalibration ihrer Parameter notwendig ist.

Andererseits lassen sich die im folgenden beschriebenen Vorrichtungen und Verfahren aber auch bei einzelnen Verstärkerstufen, d.h. bei Verstärkerstufen einsetzen, die nicht Bestandteil einer Gruppe von Verstärkerstufen sind, und daß die zu kalibrierende Verstärkerstufe.

Die zu kalibrierenden Verstärkerstufen müssen auch nicht Bestandteil eines ADC sein, sondern können auch in beliebigen anderen Vorrichtungen enthalten sein.

In der Figur 24 bezeichnen
- E1, E2: differentielle Eingänge, die auf die Gates von MOSFETs T1, T2 führen,
- IS: eine Fußstromquelle des so gebildeten Differentialpaares,
- RI und R2: Lastelemente der MOSFETS, die hier beispielhaft als Widerstände dargestellt sind, aber sowohl hier als auch bei den in den weiteren Figuren gezeigten Anordnungen durch MOSFETs oder andere aktive Schaltungen (siehe beispielsweise [4]) ersetzt werden können, und
- A1 und A2: die differentiellen Ausgänge der Verstärkerstufe.

Da Verstärkerstufen gemäß Figur 24 in der Regel ohne Gegenkopplung arbeiten und auch keine Kompensation des Frequenzgangs enthalten, handelt es sich nicht um Operationsverstärker. Dafür ist ihre Signalverarbeitungsbandbreite in der Regel sehr groß, und die Verstärkung je Stufe relativ gering, ein typischer Wert für schnelle ADCs im Bereich einiger 100 MHz Signalbandbreite ist ein Verstärkungsfaktor von nur vier.

Klassische Offsetkompensationsverfahren für Operationsverstärker wie [12] oder die wesentlich präzisere Variante nach [13], sowie die bis heute aus diesen Wurzeln entstandenen Verfeinerungen, sind schon aus Gründen des erheblichen Schaltungsaufwandes für diese Verstärkerstufen nicht geeignet, und das Fehlen eines hochimpedanten Knotens in den Verstärkerstufen macht die Kompensation des Frequenzganges einer analogen Autozero - Feedbackschleife auch bei Hinzufügung umfangreicher Zusatzschaltungen schwierig. Außerdem ist die analoge Speicherung der Korrekturinformation wie im Falle [12] und [13] nachteilig, da die Information durch Leckströme rasch verschwindet und der Flächenaufwand für die analogen Speicher in der Regel groß ist. Eine digitale Lösung wäre vorzuziehen, da digitale Speicher eine Information fehlerfrei mit einem geringeren Flächenaufwand über einen längeren Zeitraum speichern können.

Moderne digitale Offsetkompensationsverfahren nach [14] sind jedoch auf die oben erwähnten Verstärkerstufen nicht anwendbar, da die Verstärkungsfaktoren in der Regel zu klein sind, um einen eindeutigen Umschaltpunkt festzustellen. Außerdem ist das Verfahren nach [14] nicht flexibel genug, denn schließlich kann es Aufgabe der Kalibration sein, statt nur einer Offsetkorrektur auch andere Parameter der Schaltung auf ein Soll zu führen. Insbesondere in differentiellen Eingangsstufen von ADCs kann es notwendig sein, Verstärkungen einzelner Gruppen von Verstärkerstufen einander anzugleichen. Auch hierzu soll die erfindungsgemäße Vorrichtung und das Verfahren brauchbar sein.

Wie vorstehend bereits ausführlich erläutert wurde, und wie später nochmals genauer beschrieben wird, besteht im Falle von ADCs darüber hinaus beispielsweise auch die Möglichkeit, Nichtlinearitätsfehler durch statistische Schwankungen der Widerstände innerhalb der Referenzspannungsteilerkette auszugleichen, indem in der ersten Stufe des ADC gezielt solche Offsetfehler eingestellt werden, daß die Fehler der Referenzspannungsteilerkette ausgeglichen werden.

Dies ist mit einer reinen Offsetkompensation, die den Offset des Verstärkers nur minimieren kann, nicht möglich.

Bei der erfindungsgemäßen Kalibrationsvorrichtung kann ein Offset dagegen nicht nur minimiert, sondern gezielt auf beliebige Werte innerhalb eines Kalibrationsbereichs gestellt werden.

Strukturen, die Gruppen von Verstärkerstufen enthalten, finden sich auch bei vielen anderen Schaltungen, wie z.B. aus dem Gebiet der parallelen Signalverarbeitung, Stichwort neuronale Netze, Siliziumretina, integrierte Sensorfelder, usw., und auch hier ist es wünschenswert, über eine Methode zu verfügen, die eine Kalibration einer Gruppe von Verstärkerstufen in effizienter Weise erlaubt.

Dem bisherigen Stand der Technik sind keine systematischen Verfahren bekannt, eine Gruppe von Verstärkerstufen, gemeint ist eine Vielzahl von Verstärkerstufen, beispielsweise hunderte bis tausende, in effizienter Weise auf Sollwerte zu kalibrieren. Die vorherrschende Denkweise versucht vor allem durch Vergrößerung der Fläche eine geringere statistische Schwankung der Bauteileparameter zu erhalten. Für z.B. ein Viertel der Offsetspannung ist hierfür die sechzehnfache Fläche notwendig, was schnell unwirtschaftlich wird, die Geschwindigkeit bremst, Und die Leistungsaufnahme erhöht.

Die beschriebene Kalibrierungsvorrichtung enthält
- erste Mittel, um eine Verstärkerstufe in einen für die Kalibration zweckmäßigen Betriebszustand bringen zu können,
- zweite Mittel, um die zu kalibrierenden Eigenschaften der Verstärkerstufe einstellbar zu machen,
- dritte Mittel, um von der zu kalibrierenden Verstärkerstufe einen eindeutigen Signalpfad auf mindestens eine Vergleichereinheit aufbauen zu können,
- mindestens eine Vergleichereinheit, die eine Übereinstimmung mit einem Sollwert oder das Vorliegen eines Gleichgewichtszustandes feststellen kann, und
- eine Steuereinheit, die den Ausgang der Vergleichereinheit auswertet und die den Ablauf des Kalibrationsverfahrens steuert,
   wobei es sich als besonders vorteilhaft erweist, wenn
- die ersten, zweiten, und dritten Mittel digital gestellt werden können,
- eine digitale Speichereinheit, die für jede kalibrierbare Verstärkerstufe alle oder einen Teil der Stellwerte der ersten bis dritten Mittel speichert, und so ausgeführt ist, daß sich die einer kalibrierbaren Verstärkerstufe zugeordneten Speicherzellen in der Nähe der kalibrierbaren Verstärkerstufe oder in dieser befinden,
- Daten, Steuer- und Selektions- bzw. Adressleitungen vorhanden sind, die die Steuereinheit mit der Speichereinheit verbinden, so daß diese Zellen aus der Speichereinheit auswählen, auslesen und beschreiben kann, und
- die Vorrichtung und das Verfahren es erlaubt, eine kaskadierte stufenweise Kalibration durchzuführen, bei der bereits kalibrierte Verstärkerstufen benutzt werden, um während der Kalibration Signale von ihnen in einem Signalpfad vorangehenden Verstärkerstufen zu verstärken, bevor sie auf die Vergleichereinheit gelangen.

Vereinfacht dargestellt kann die Erfindung als digitaler Schreib/Lesespeicher aufgefaßt werden, der in systematischer Weise über die integrierte Schaltung verteilt ist, und dessen Speicherzellen statt nur Information zu speichern mit dieser Information auch analoge Parameter innerhalb von Verstärkerstufen stellen, die innerhalb des Speicherfeldes mit diesem verwoben sind.

Der Inhalt der Speicherzellen wird von der Steuereinheit so manipuliert, daß der über eine Vergleichereinheit gemessene Parameter einer angewählten Verstärkerstufe auf einen Sollwert gebracht wird, wobei das beschriebene Verfahren dies in einer besonderes effizienten Weise bewerkstelligt, indem - wo möglich - bereits kalibrierte Verstärkerstufen dazu benützt werden, um Signale von den ihnen vorangehenden Verstärkerstufen auf die Vergleichereinheit zu führen, so daß sich insgesamt ein möglichst geringer Mehraufwand und eine hohe Genauigkeit ergibt.

Die vorgeschlagene Kalibrationsvorrichtung unterscheidet sich damit deutlich von bekannten Kalibrations-Vorrichtungen.

Dies gilt auch für die mittlerweile bekannt gewordene Kalibrationsvorrichtung nach [15]. Während nämlich das Verfahren nach [15] einzelne Faltungsstufen aus dem laufenden System abtrennt und dann mit einem langsamen Delta-Sigma-Modulator den Offsetfehler mißt und kalibriert, während der Betrieb des ADC weiterläuft, muß bei der vorliegend beschriebenen Vorrichtung keine Abtrennung von zu kalibrierenden Stufen erfolgen, so daß Ketten von Verstärkerstufen benützt werden können, um die Genauigkeit der Kalibration ohne Mehraufwand zu erhöhen. Dies geschieht durch eine kaskadierte stufenweise Kalibration, was bei der Vorrichtung nach [15] nicht möglich ist.

Ein weiterer Vorteil der beschriebenen Kalibrierung besteht darin, daß es bei ihr nicht notwendig ist, Transferschalter zwischen den einzelnen Stufen einzubauen. Dies ist zwar prinzipiell möglich und bequem, insbesondere zur Realisierung der ersten Mittel, aber bei den zeitgemäßen 0.12 µm CMOS Prozessen mit typischerweise 1.2 V Versorgungsspannung haben Transferschalter in der Regel so schlechte Übertragungseigenschaften, daß die maximale Geschwindigkeit des Gesamtsystems leidet, wenn diese in den Signalpfaden für den Normalbetrieb liegen. Die beschriebene Kalibrierung erlaubt es dagegen, die Signalpfade zwischen den Verstärkern fest zu verbinden, ohne Transferschalter zwischenzuschalten. Diese werden nur an unkritischen Stellen der Schaltung und für den Kalibrationsbetrieb benützt, der keine so hohen Geschwindigkeitsanforderungen hat wie der Normalbetrieb.

Weitere Vorteile der vorliegenden Erfindung ergeben sich aus der rein digitalen Speicherung der Stellwerte zur Kalibration in einer verteilten Speichereinheit, die mit den Verstärkerstufen so verwoben ist, daß der Verdrahtungsaufwand gering ist, und der hohen Flexibilität der Vorrichtung, den Kalibrationsmodus einer Vielzahl von Verstärkerstufen während des Normalbetriebs umprogrammieren zu können, und dann durch Umschaltung nur eines globalen Signals sofort in den Kalibrationsmodus und wieder in den Normalbetrieb zurück wechseln zu können.

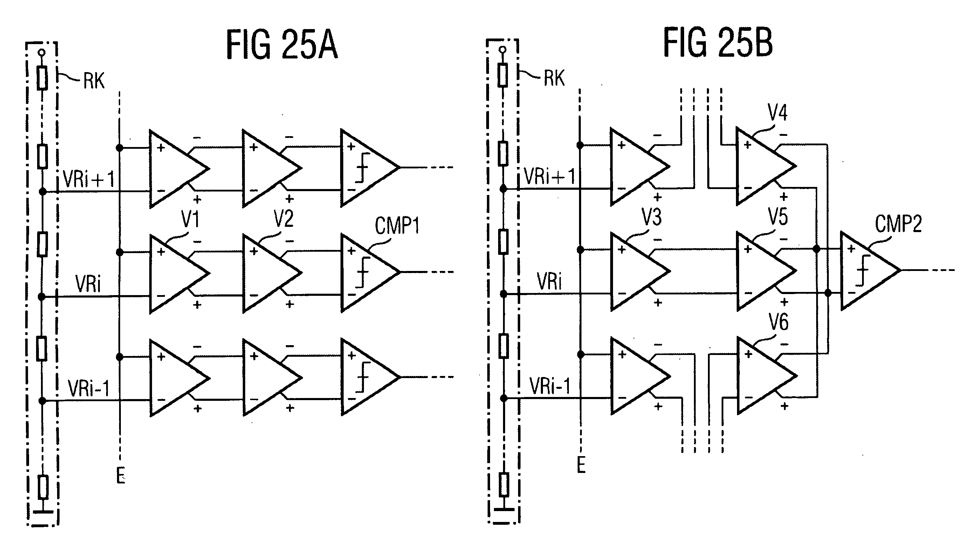

Nach den vorstehenden allgemeinen Ausführungen zur vorgeschlagenen Verstärkerstufen-Kalibration wird diese im folgenden unter Bezugnahme auf die Figuren 25 bis 40 genauer beschrieben. Die Beschreibung erfolgt anhand von in der Figur 25 gezeigten ADCs.

Figur 25a zeigt eine für Flash-ADCs typische Kettenschaltung von in der Figur 24 gezeigten Verstärkerstufen. Der Eingang des ADC ist hier mit E bezeichnet, die Referenzspannungen aus der Referenzteilerkette RK sind mit VRi-1, VRi, VRi+1 bezeichnet. Die in der Figur 25a gezeigte Anordnung enthält mehrere Verstärkerstufen-Kettenschaltungen; eine der Kettenschaltungen besteht z.B. aus den Verstärkerstufen V1 und V2 und dem Komparator CMP1.

Figur 25b zeigt eine für Folding-ADCs typische Baumstruktur von in der Figur 24 gezeigten Verstärkerstufen, bei denen im Gegensatz zu einem Flash-ADC mehrere Verstärkerstufen V4, V5, V6 an den Ausgängen verbunden sind, um eine Faltungsoperation zu ermöglichen. Es entsteht dadurch ein Baum aus Verstärkerstufen, in dem sich als Untermenge Kettenschaltungen befinden, hier z.B. V3, V5, CMP2.

Die beschriebene Vorrichtung und das beschriebene Verfahren sind in der Lage, solche Strukturen in besonders effizienter Weise zu kalibrieren: es wird in solchen Fällen kein großer Mehraufwand an zusätzlichen analogen Schaltungen zur Realisierung der Kalibration benötigt. Doch auch bei einer beliebigen Verdrahtung einer Gruppe von Verstärkerstufen sind die Vorrichtung und das Verfahren anwendbar.

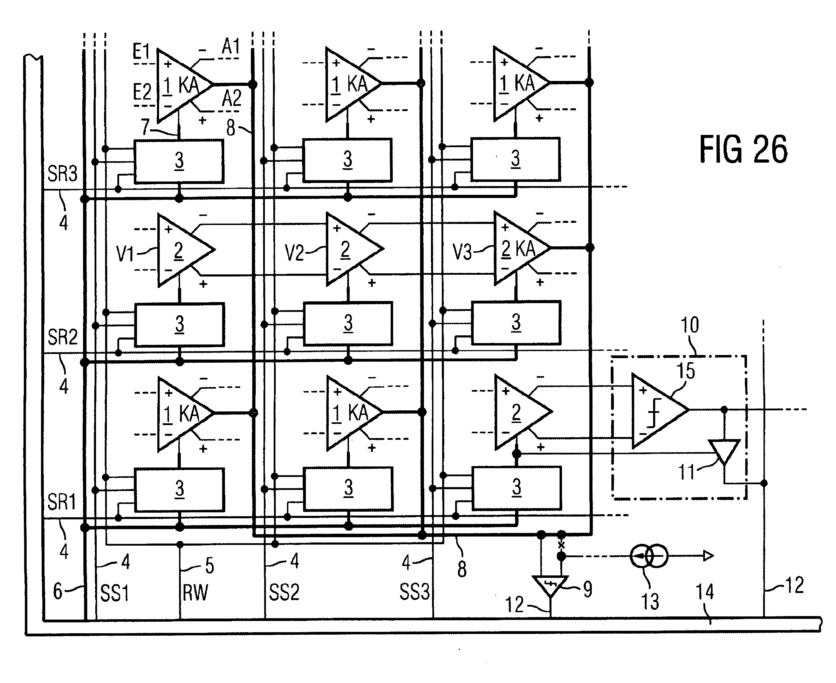

Figur 26 stellt die erfindungsgemäße Vorrichtung anhand eines Prinzipschaltbildes dar.

Die gewöhnlichen Verstärkerstufen nach Figur 24 sind hier durch kalibrierbare Verstärkerstufen 1, 2 ersetzt. Beide Varianten kalibrierbarer Verstärkerstufen verfügen über Stelleingänge 7, die es erlauben, in oder bei den kalibrierbaren Verstärkerstufen befindliche erste, zweite, und dritte Mittel zur Kalibration zu beeinflussen, auf die später noch eingegangen wird. Die universell verwendbare Hauptvariante der kalibrierbaren Verstärkerstufe 1 verfügt darüber hinaus noch über mindestens einen zusätzlichen Kalibrationsausgang KA, der an ein Meßleitungsnetz 8 angeschlossen ist.

Jeder kalibrierbaren Verstärkerstufe ist ein digitales Speicherregister 3 zugeordnet, das Stellwerte enthält, welche auf die Stelleingänge 7 der zugeordneten kalibrierbaren Verstärkerstufe geführt sind und über einen Datenbus 6 gelesen und beschrieben werden können. Zwar ist, wie eingangs unter Bezugnahme auf die Figuren 1 bis 23 beschrieben wurde, für die Stellwerte im Prinzip auch eine analoge Speicherung möglich, doch wird im allgemeinen wegen des geringen Flächenbedarfs für die praktische Realisierung des Speichers und wegen des nicht vorhandenen oder vernachlässigbar kleinen Risikos, daß sich die gespeicherten Daten verändern (Verlust der Information durch Leckströme) die digitale Speicherung zu bevorzugen sein.

An die digitalen Speicherregister sind neben dem Datenbus 6 auch Selektionsleitungen 4 und Steuerleitungen 5 angeschlossen, die es erlauben, Speicherregister gezielt zu selektieren und einen Lese- oder Schreibvorgang zu steuern, so daß sich eine Speichereinheit ergibt.

In diesem Fall entspricht der Aufbau der aus den Speicherregistern und ihren Selektionsschaltungen gebildeten Speichereinheit im wesentlichen einem dem Stand der Technik an sich bekannten Schreib- und Lesespeicher (RAM) oder einem sogenannten "Registerfile" mit einzeln selektierbaren Speicherregistern. Da die Ausgänge der Speicherregister auf Stelleingänge von erfindungsgemäßen Mitteln bei den Verstärkerstufen führen, ist es zweckmäßig, die einzelnen Speicherregister und die erfindungsgemäßen Mittel räumlich nahe beieinander in der Nähe der ihnen zugeordneten kalibrierbaren Verstärkerstufen anzuordnen, und einen Dekoder zur Selektion der einzelnen Speicherregister als verteilte Schaltung auszuführen.

Wenn die verwendete Halbleitertechnologie und der Temperatur-, Versorgungsspannungs-, und Langzeitdrift der integrierten Schaltung es zuläßt, kann die Speichereinheit auch als programmierbarer nichtflüchtiger Speicher, z.B. als PROM, ausgeführt werden und die Kalibration einmalig, beispielsweise während der Herstellung der integrierten Schaltung erfolgen. Hierbei ist es dann möglich, eine später noch genauer beschriebene Vergleichereinheit 9 und eine später ebenfalls noch genauer beschriebene Steuereinheit 14 von der integrierten Schaltung in den Testautomaten zu verlegen. An der beschriebenen Vorrichtung ändert hierdurch nur der Ort, an dem sich die Vergleichereinheit und Steuereinheit befinden.

Auch wenn die Erfindung keine besonderen Anforderungen an die Anordnung der kalibrierbaren Verstärker und der Speicherregister stellt, ist es in der Praxis vorteilhaft, je einen kalibrierbaren Verstärker und sein zugeordnetes Speicherregister in räumlicher Nähe anzuordnen. In einer bevorzugten Ausführung sind diese zu einer Einheit zusammengefaßt. Ferner ist es zweckmäßig, die kalibrierbaren Verstärker und ihre zugeordneten Speicherregister, oder die daraus gebildeten Einheiten, wie in der Figur 26 in einer Matrix anzuordnen, womit die Selektion vereinfacht wird, und sich auch ein reguläres Layout ergibt. Die Allgemeinheit der realisierbaren Ketten, Bäume oder sonstiger Gruppen von Verstärkerstufen wird damit nicht beschränkt, da die Verbindung der gewöhnlichen Ein- und Ausgänge der Verstärkerstufen (z.B. E1, E2, A1, A2) in einer beliebigen Weise erfolgen kann. In bestimmten Fällen kann das Kalibrationsverfahren jedoch Eigenschaften dieser gewöhnlichen Verbindungen in besonders vorteilhafter, da aufwandssparender Weise, für seine Zwecke nutzen, hierauf wird später eingegangen.

Der Datenbus 6 der Speichereinheit, und ihre Selektionsleitungen 4 und Steuerleitungen 5, es können implementierungsabhängig auch mehr oder weniger sein als in den Figuren dargestellt, auch ein zusätzlicher Adreßbus ist denkbar, sind mit der bereits erwähnten Steuereinheit 14 verbunden, die den Ablauf des Kalibrationsverfahrens steuert.

Diese Steuereinheit 14 benötigt zur Kalibration eine Auskunft darüber, ob der jeweils zu kalibrierende Parameter im Soll ist. Diese Information wird von die von mindestens einer Vergleichereinheit 9 oder 10 über Signalleitungen 12 an die Steuereinheit 14 geliefert.

Der kalibrierbare Parameter, ein Strom, eine Spannung, oder ein zeitabhängiges Signal, wird der Vergleichereinheit in einer ersten Variante über das Meßleitungsnetz 8 zugeführt, wozu die selektierte kalibrierbare Verstärkerstufe dritte Mittel enthält, um den gewünschten Parameter über ihre Kalibrationsausgänge KA dem Meßleitungsnetz zuzuführen.

In der zweiten Variante, die in der mittleren Zeile beispielhaft dargestellt ist, liegt eine Kettenschaltung von kalibrierbaren Verstärkerstufen V1 bis V3 vor, und hier ist es dann möglich, in den am Anfang der Kette liegenden Verstärkerstufen auf dort hinzugefügte dritte Mittel und den Kalibrationsausgang KA zu verzichten, indem die von dem erfindungsgemäßen Kalibrationsverfahren jeweils zuvor kalibrierten nachfolgenden Verstärkerstufen selbst als dritte Mittel zur Zuführung der Parameter der ihnen vorhergehenden Verstärkerstufen auf die Vergleichereinheit benützt werden.

Zum Beispiel, siehe Figur 26, würde der mit dritten Mitteln und einem Kalibrationsausgang KA ausgestattete kalibrierbare Verstärker V3 zuerst kalibriert, und wenn dessen Signalübertragungsfunktion dadurch hinreichend genau geworden ist, kann der ohne eigene dritte Mittel und ohne Kalibrationsausgang ausgeführte kalibrierbare Verstärker V2 kalibriert werden, indem der schon kalibrierte Verstärker V3 als drittes Mittel zur Wirkung gebracht wird, um das Ausgangssignal von V2 über seine Ausgänge KA dem Meßleitungsnetz 8 und damit der Vergleichereinheit 9 zuzuführen. Die zusätzliche Verstärkung durch V3 ist hierbei erwünscht, da sie auch die herauszukalibrierenden Fehler von V2 verstärkt, und somit eine wesentlich genauere Kalibration von V2 ermöglicht wird.

Wenn nun auch V2 kalibriert ist, können V2 und V3 für die Kalibration von V1 als dritte Mittel herangezogen werden. Auch hier stellt sich der vorteilhafte Effekt dieser zweiten Variante der Erfindung ein, daß durch die Verstärkung von V2 und V3 etwaige Fehler von V1 wesentlich genauer aufgelöst werden können, als es durch direkte Zuführung innerer Parameter oder der Ausgangswerte von V1 auf die Vergleichereinheit möglich wäre. Hat z.B. jede Verstärkerstufe einen Verstärkungsfaktor von 4 und hat die Vergleichereinheit eine Genauigkeit von 1 mV, die sich typischerweise mit dem Stand der Technik bekannten Offsetkompensationsverfahren innerhalb der Vergleichereinheit mit mäßigem Aufwand erzielen läßt, dann beträgt die erzielbare Genauigkeit der Kalibration der Kette aus V1, V2, V3 bezogen auf den Eingang der Kette im Idealfall (genügend feine Schrittweite der zweiten Mittel und kein Rauschen) 1 mV / (4 * 4 * 4) = 15.6 µV. Auch wenn dieser Idealfall in der Praxis nicht erzielbar ist, zeigt dieses Beispiel doch, welch hohe prinzipielle Genauigkeit das erfindungsgemäße Verfahren hat.

Durch diese besonders bei Analog/Digitalwandlern vom Flash- oder Foldingtyp einsetzbare kaskadierte stufenweise Kalibration, die durch die erfindungsgemäße Vorrichtung erst ermöglicht wird und die die Hauptvariante des erfindungsgemäßen Kalibrationsverfahrens darstellt, können Ketten oder Bäume von Verstärkerstufen auf eine dem bisherigen Stand der Technik nur mit großen schaltungstechnischen Aufwand zugängliche Genauigkeit kalibriert werden.

Solche Ketten von Verstärkerstufen finden sich vor allem in Flash-ADCs, während Bäume von Verstärkerstufen vor allem in Folding-ADCs eingesetzt werden.

Bei Analog/Digitalwandlern, aber auch bei vielen anderen Schaltungen mit Gruppen von Verstärkerstufen, befindet sich am Ende eines Pfades durch die miteinander verbundenen Verstärkerstufen ohnehin ein Komparator, der für viele zu kalibrierende Parameter als geeignete Vergleichereinheit im Sinne der Erfindung benutzt werden kann, insbesondere für Spannungen und Zeitkonstanten, wobei letzteres vor allem dann ermöglicht ist, wenn diese Komparatoren geeignet getaktet werden können.

Liegt eine solche Struktur vor, bei der sich am Ende von Signalpfaden Komparatoren befinden, in Figur 26 innerhalb des gestrichelten Kastens 10 beispielhaft dargestellt, kann dieser Komparator während des Kalibrationsvorgangs als Vergleichereinheit benutzt werden, während er im Normalbetrieb seine ursprüngliche Aufgabe innerhalb der Schaltung hat.

Der Mehraufwand für die Realisierung der erfindungsgemäßen Vergleichereinheit reduziert sich dann in den meisten Fällen auf das Hinzufügen eines selektierbaren Treibers 11 zum vorhandenen Komparator 15, wobei der Treiber von einem Signal eines Speicherregisters, wie in der Figur dargestellt, oder aus einer logischen Verknüpfung der Selektions- und/oder der Steuerleitungen selektiert werden kann, so daß er im selektierten Zustand den Ausgang des Komparators, und somit das Vergleichsergebnis, über eine Signalleitung 12 der Steuereinheit 14 zuführt.

Bei entsprechender Ausgestaltung der den Komparatoren gewöhnlich nachfolgenden digitalen Logik kann die Funktion der selektierbaren Treiber auch von der digitalen Logik übernommen werden.

Befinden sich an allen Enden der zu kalibrierenden Verstärkerketten bereits Komparatoren, dann ist es möglich, eine Variante der Erfindung zu benutzen, bei der auf das Hinzufügen einer Vergleichereinheit verzichtet werden kann, da mit den Komparatoren bereits alle benötigten Vergleichereinheiten vorhanden sind. Dies ist im Falle der oben erwähnten ADCs meistens zutreffend.

Eine auf die Kalibration spezialisierte Vergleichereinheit 9 ist insbesondere dann nützlich, wenn Ströme kalibriert werden sollen, oder Verstärkungsfaktoren, da sich gewöhnliche Komparatoren in diesen Fällen damit schwertun würden, das Vorliegen eines Sollwerts festzustellen.

Im Falle der Kalibration von Strömen auf einem Sollwert muß der Vergleichereinheit 9 ein Referenzstrom zugeführt werden, was in der Figur 26 durch eine Stromquelle 13 beispielhaft dargestellt wird. Hierbei ist dann die gestrichelte Leitung von der Stromquelle zum ersten Anschluß der Vergleichereinheit zu schließen und die mit "x" bezeichnete Stelle zu trennen. Am zweiten Eingang der Vergleichereinheit 9 wird über eine der Meßleitungen 8 der innerhalb der kalibrierbaren Verstärkerstufe abgezapfte Strom zugeführt und durch die Vergleichereinheit mit dem aus der Referenzstromquelle 13 stammenden Sollwert verglichen. Wenn die Kalibration von Strömen und Spannungen erfolgen soll, ist es zweckmäßig, mindestens zwei Vergleichereinheiten vorzusehen, eine für Ströme, und eine für Spannungen, oder die Vergleichereinheit(en) zwischen Strom- und Spannungsvergleich umschaltbar zu machen, was dem Fachmann keine Probleme aufwerfen sollte.

Im Falle der Kalibration von Verstärkungen auf einen Sollwert wird der zu kalibrierende Verstärker durch die ersten Mittel mit einem bekannten Eingangswert ausgesteuert, z.B. mit einer bekannten Spannungsdifferenz, und die Verstärkung wird durch die Vergleichereinheit mit einem Sollwert verglichen. Dieser Sollwert kann als Triggerschwelle bereits in die Vergleichereinheit eingebaut sein. Diese kann aber auch als Subtrahier- bzw. Addierverstärker mit nachfolgender Schaltschwelle ausgeführt sein. Diese Varianten der Vergleichereinheit sind nicht bildhaft dargestellt, da der Fachmann in der Lage ist, diese im Sinne der Erfindung zu realisieren.

Weitere kalibrierbare Eigenschaften von Verstärkergruppen sind ihr Frequenz- oder Phasengang. Mit einer geeigneten Ausbildung der Vergleichereinheit zur Messung von Amplituden bzw. Phasen und einer geeigneten Ausbildung der ersten Mittel zur Zuführung von Kalibrationssignalen, die z.B. aus einem stellbaren Sinusgenerator stammen, ist es der erfindungsgemäßen Vorrichtung möglich, auch eine Kalibration des Frequenz- und/oder Phasengangs von Verstärkergruppen durchzuführen, etwa indem innerhalb der Verstärkerstufen Kapazitäten auf einen passenden Wert umgeschaltet werden, oder indem die Steilheit von Transistoren angepaßt wird, so daß sich geeignete Zeitkonstanten ergeben. Hierbei ist es zweckmäßig, die dritten Mittel als Pufferstufe so auszubilden, daß das Aufschalten von aus der Verstärkerstufe stammenden Signalen auf die Meßleitungen 8 den Frequenzgang der Verstärkerstufe nicht oder nur unwesentlich beeinflußt.

Es sei darauf hingewiesen, daß auch eine Kalibration der Vergleichereinheit vorgesehen werden kann; dadurch kann sichergestellt werden, daß die Vergleichereinheit Ergebnisse mit hinreichender Genauigkeit liefert. Der oftmals erhebliche analoge Schaltungsaufwand für diese Kalibrationsschaltungen innerhalb der Vergleichereinheit fällt durch die erfindungsgemäße Vorrichtung jedoch in vorteilhafter Weise nur einmal pro Gruppe daran angeschlossener kalibrierbarer Verstärkerstufen an, und nicht jeweils pro Verstärkerstufe, wie es ohne die erfindungsgemäße Vorrichtung der Fall wäre. Die ersten, zweiten und dritten Mittel der Erfindung lassen sich in der Regel mit geringem Aufwand realisieren, beispielsweise durch einige wenige steuerbare Schalter pro kalibrierbarer Verstärkerstufe.

Die einfachste und am häufigsten anzutreffende Aufgabe für die erfindungsgemäße Vorrichtung und das Verfahren ist die Kalibration von Offsetspannungen auf einen möglichst kleinen Wert. Dies ist besonders nützlich bei Flash- und Folding-ADCs, um ihre Linearität und damit ihre spektrale Reinheit zu erhöhen. Zur Offsetkalibration genügt es,
- beide Eingänge der zu kalibrierenden Verstärkerstufe über erste Mittel mit Hilfspotentialen zu verbinden, so daß sich am Ausgang der Verstärkerstufe die verstärkte Offsetspannung ergibt,
- mit Hilfe der Vergleichereinheit die Ausgänge auf Gleichheit abzuprüfen, und
- die Stellwerte geeigneter zweiter Mittel, die das Gleichgewicht innerhalb der Verstärkerstufe beeinflussen, so zu stellen, daß sich am Ausgang der Verstärkerstufe eine minimale Differenzspannung ergibt.

Diese minimale Differenzspannung, geteilt durch die Verstärkung der Verstärkerstufe, ist dann der verbleibende Restoffset. Dementsprechend hoch sind auch die Anforderungen an die Genauigkeit der Vergleichereinheit. Der Stand der Technik kennt eine Vielzahl von Lösungen, hochgenaue Vergleichereinheiten zu realisieren, aber der schaltungstechnische Aufwand und der Flächenaufwand dafür ist relativ hoch.

Dieser Aufwand für hochgenaue Vergleichereinheiten begründet den Vorteil der Erfindung, die Zahl der notwendigen Vergleichereinheiten minimieren zu können, und ferner erlaubt die erfindungsgemäße Vorrichtung, eine erfinderische Hauptvariante des Kalibrationsverfahrens zu verwenden, die kaskadierte stufenweise Kalibration, bei der bereits kalibrierte Verstärkerstufen bei der Kalibration einer vor ihnen liegenden Verstärkerstufe zwischen dieser und der Vergleichereinheit geschaltet sind, so daß der Ausgangsspannungsunterschied der gerade zu kalibrierenden Verstärkerstufe über nahezu fehlerfreie, da bereits vorher kalibrierte, Verstärkerstufen weiter verstärkt wird, so daß die Genauigkeitsanforderungen an die Vergleichereinheit entsprechend dem Produkt der Verstärkungsfaktoren der einzelnen Stufen reduziert wird. Ist dieses Produkt der Verstärkungsfaktoren hinreichend groß, dann genügt die Genauigkeit gewöhnlicher Komparatoren am Ende solcher Ketten oder Bäume aus Verstärkerstufen, um diese Komparatoren als Vergleichereinheit einsetzen zu können. Zu den für diese besonders vorteilhafte Ausführung der Erfindung geeignete Schaltungsstrukturen gehören beispielsweise Flash- und Folding-Analog/Digitalwandler.

Dem bisherigen Stand der Technik ist eine kaskadierte stufenweise Kalibration für solche aus Verstärkerstufen aufgebaute Analog/Digitalwandler nicht bekannt, statt dessen versucht sich der bekannte Stand der Technik hier an schwierigen Kunstgriffen, wie Autozero-Feedbackschleifen der Komparatoren unter Einbeziehung der vorangegangenen Verstärkerstufen in die Autozero-Feedbackschleife, was erhebliche Stabilitätsprobleme aufwerfen kann, oder es wird sogar auf Autozero verzichtet und der für geringen Offset erforderliche erhebliche Flächenaufwand betrieben.

Gegenüber diesen Methoden des bisherigen Standes der Technik bietet diese Erfindung eine flächenoptimierte systematische Lösung ohne analoge Feedbackschleifen und damit ohne Stabilitätsprobleme, bei hoher möglicher Genauigkeit auch bei geringer Verstärkung pro Stufe, und durch die digitale Speicherung der Stellwerte eine Robustheit der Kalibration gegen Leckströme.

Die Erfindung mag zwar mit dem bisherigen Stand der Technik verglichen auf den ersten Blick als aufwendig und komplex erscheinen, es gilt aber zu bedenken, daß die allermeisten für die Realisierung der Erfindung notwendigen zusätzlichen Schaltungsteile digitaler Natur sind wie z.B. Dekoder, Register und Schalter, und deswegen mit minimal kleinen Transistoren realisiert werden können, die bei heutigen Stukturgrößen moderner 0.12 µm - Prozesse gegenüber den analogen Bauteilen in den Verstärkerstufen nur wenig ins Gewicht fallen. Mit der Erfindung ist es möglich, auch die analogen Bauteile radikal zu verkleinern, da die mit der linearer Reduktion der Fläche quadratisch größer werdenden statistischen Schwankungen der Bauteileparameter durch die Kalibration wieder ausgeglichen werden können. Die mit jedem Bit in den digitalen Stellwerten um den Faktor 2 steigende Feinheit der Kalibration, ein exponentielles Gesetz, ist in jedem Fall mächtiger als das quadratische Flächengesetz, das dem Fachmann als Pelgrom'sches Gesetz bekannt ist, so daß die Flächenersparnis sicher erzielbar ist.

Mit der Erfindung kann der Flächenbedarf von typischen ADCs gegenüber dem Stand der Technik - bei gleicher Genauigkeit - drastisch reduziert werden, und durch die so minimierten parasitären Kapazitäten ergibt sich ein viel günstigeres Verhältnis von Geschwindigkeit zur Leistungsaufnahme. Diese Vorteile der Erfindung ergeben sich auch für beliebige Gruppen von Verstärkerstufen, bei denen Parameter in effizienter Weise kalibriert werden müssen.

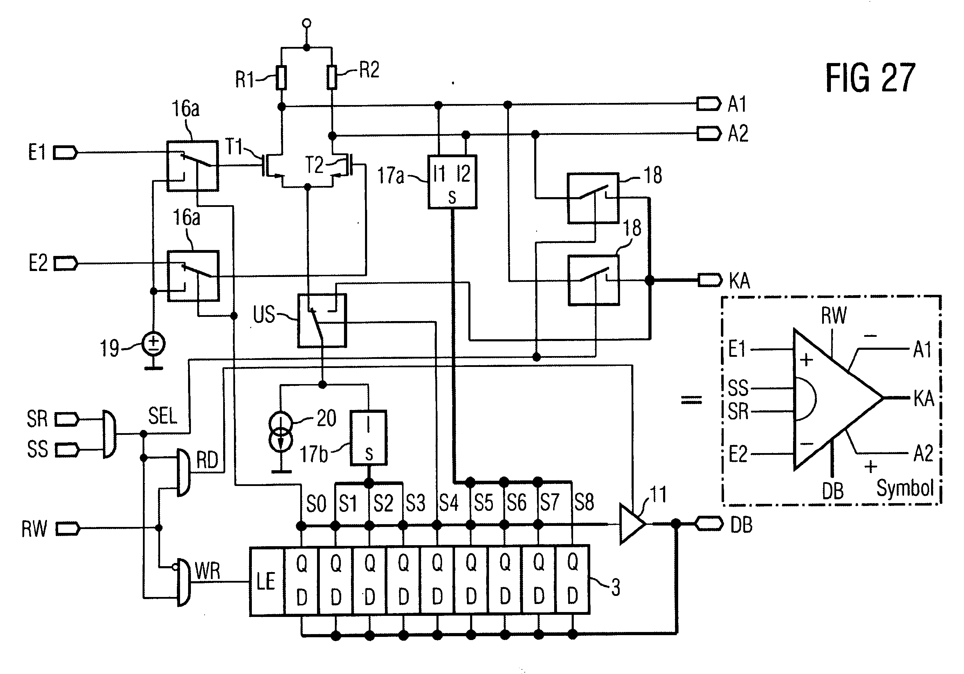

Figur 27 zeigt eine Möglichkeit zur praktischen Realisierung einer zur Kalibrierung der in der Figur 24 gezeigten Verstärkerstufe geeigneten Vorrichtung.

Dabei sind um die in der Figur 24 gezeigte Verstärkerschaltung verschiedene Mittel arrangiert, nämlich
- erste Mittel 16a, US, um die zu kalibrierende Verstärkerstufe in einen definierten Zustand zu bringen, in dem sie kalibriert werden kann (diese ersten Mittel können z.B. auf die Eingänge der Verstärkerstufe wirken oder Stromquellen von ihren Senken trennen, so daß der Strom beobachtbar wird),
- zweite Mittel 17a, 17b, um über Stelleingänge der zu kalibrierenden Verstärkerstufe Parameter der zu kalibrierenden Verstärkerstufe verändern zu können, beispielsweise indem Ströme von Stromquellen oder Spannungen an Stellgliedern zu verändert werden, oder indem durch Schalter hinzu- oder abschaltbare Schaltungselemente, wie Transistoren, Kapazitäten, usw. zugeschaltet oder weggeschaltet, oder aktiviert oder deaktiviert, werden,
- dritte Mittel 18, US, um elektrische Größen der zu kalibrierenden Verstärkerstufe auf Kalibrationsausgänge KA aufzuschalten, welche mit zur Vergleichereinheit führenden Leitungen verbunden sind.

Vereinfachend und zusammenfassend knapp dargestellt haben die ersten Mittel die Aufgabe, die Verstärkerstufe für die Kalibration vorzubereiten, die zweiten Mittel stellen den zu kalibrierenden Parameter auf den Sollwert, und die dritten Mittel machen den zu kalibrierenden Parameter unter Benutzung einer Vergleichereinheit, mit der ein Übereinstimmen des zu kalibrierenden Parameters mit einem Sollwert geprüft wird, letztlich der Steuereinheit zugänglich, indem sie einen Signalpfad von der Quelle über die Vergleichereinheit zur Steuereinheit aufbauen.

Mehrere Mittel können dabei auch funktional zusammengefaßt sein, in Figur 27 enthält der mit US bezeichnete Umschalter gleichzeitig ein erstes und ein drittes Mittel, da er erstens die Stromquelle 20 von der Senke T1, T2 trennt und zweitens den Strom dem Kalibrationsausgang KA zuführt. Erst auf Transistorebene ließe sich hier eine eindeutige Klassifizierung einzelner Transistoren des Umschalters US in erste oder dritte Mittel durchfuhren.

Die dritten Mittel durch bereits kalibrierte nachfolgende Verstärkerstufen gebildet werden oder solche Verstärkerstufen enthalten. Wenn Verstärkerstufen vorhanden sind, die von Haus aus über eine genügende Grundgenauigkeit verfügen, können diese auch ohne Kalibration als dritte Mittel verwendet werden.

Diese Flexibilität liegt daran, daß bei Vorliegen einer Kettenschaltung von Verstärkern ein additiver Fehler, z.B. ein Offsetfehler, eines nachfolgenden Verstärkers um den Verstärkungsfaktor des vorangehenden Verstärkers reduziert erscheint, wenn der Fehler auf die Eingänge dieses vorangehenden Verstärkers bezogen wird.

Eine ähnliche Flexibilität besteht oftmals für die ersten Mittel. Bei einer Kalibration der Offsetspannung werden z.B. die Eingänge der zu kalibrierenden Verstärkerstufe miteinander verbunden und auf ein definiertes Potential gebracht. Dies kann z.B. in einigen Fällen durch Abschalten der Fußstromquelle einer vorangehenden Verstärkerstufe bewirkt werden, denn die Lastelemente ziehen dann die Ausgänge dieser Verstärkerstufe und damit die Eingänge der daran angeschlossenen Verstärkerstufe auf ein gleiches Potential, was bei der Offsetkalibration für jene benützt werden kann. Siehe Figur 24 mit der Annahme, die Fußstromquelle IS1 sei abgeschaltet.

Es dürfte einleuchten und bedarf keiner näheren Erläuterung, daß eine Vielzahl von Möglichkeiten existiert, die erfindungsgemäßen ersten, zweiten und dritten Mittel zu realisieren.

Bei der in der Figur 27 gezeigten Anordnung sind die ersten Mittel 16a, US durch steuerbare Umschalter realisiert. Die an den Eingängen E1, E2 angeschlossenen ersten Mittel 16a erlauben es, die Gateanschlüsse der Transistoren T1, T2 statt mit den Eingängen E1, E2 mit einem Hilfspotential 19 zu verbinden, so daß die Offsetspannung der Verstärkerstufe um ihren Verstärkungsfaktor verstärkt an den Ausgängen A1, A2 erscheint. Diese Umschaltung erfolgt in der Figur über eine Steuerleitung SO, die aus dem Speicherregister 3 stammt. Die Veranlassung der Umschaltung könnte aber auch anders erfolgen, z.B. abhängig vom Ergebnis einer kombinatorischen Dekodierung von Selektionsleitungen.

Das mit den Ausgängen A1, A2 verbundene zweite Mittel 17a, beispielsweise eine steuerbare Stromquelle, die an ihren Ausgängen 11, 12 jeweils einen über ihre Steuereingänge S einstellbaren Strom zieht, kann nun durch das Kalibrationsverfahren benutzt werden, um den Offset der Verstärkerstufe zu minimieren. Die Steuerung dieses zweiten Mittels erfolgt in der Figur über vier aus dem Speicherregister 3 stammende Steuersignale S5 ... S8. Dies ermöglicht im Idealfall, eine sich aus statistischen Schwankungen der Bauelemente vorgegebene Offsetspannung betragsmäßig um den Faktor 8 zu reduzieren, da ein Steuersignal als Vorzeichen verwendet wird, und somit 2³ = 8 Korrekturstufen möglich sind. Da der Korrekturbereich in jedem Fall die erwartete maximale Offsetspannung abdecken muß, empfiehlt sich für die Praxis, eine gewisse Reserve einzubauen, oder den Korrekturbereich an zentraler Stelle einstellbar zu machen, was bei den vorgeschlagenen Beispielen in einfacher Weise möglich ist, indem die in den zweiten Mitteln benutzten Stromquellen von einer zentralen, einstellbaren Stromquelle gesteuert werden, die zum Beispiel von der Steuereinheit gestellt werden kann.

Die in der Figur 27 zur Zuführung der Ausgänge A1, A2 auf Kalibrationsausgänge KA vorgesehenen dritten Mittel 18 sind beispielhaft als steuerbare Schalter ausgeführt, ihr Steuereingang ist jeweils mit einem Signal SEL verbunden, das aus den Selektionssignalen SR und SS kombinatorisch gebildet wird. Dieser Steuereingang der Schalter könnte aber auch mit dem Speicherregister verbunden werden.

Das Speicherregister 3 ist in der Figur 27 beispielhaft als D-Latch ausgeführt, das den Eingängen D jeder Speicherzelle von einem Datenbus DB zugeführte Informationen übernimmt, sobald das auf den Eingang LE des Speicherregisters führende Schreibsignal WR aktiviert wird. Ausgelesen werden kann das Speicherregister unter Kontrolle durch das Signal RD über ein Ensemble von selektierbaren Treibern 11, die die Ausgänge Q des Speicherregisters auf den Datenbus DB aufschalten können. Die Signale WR und RD werden durch Verknüpfung des Signals SEL mit einem Schreib/Lesesignal RW erzeugt. Das Selektionssignal SEL entsteht durch Verknüpfung von Reihenselektionssignalen SR und Spaltenselektionssignalen SS, was bei einer Matrixanordnung der kalibrierbaren Verstärkerstufen besonders vorteilhaft ist, jedoch kann die Erfindung auch mit anderen Selektionsverfahren realisiert werden, z.B. mit einem Adressdekoder.

Auch für das Speicherregister 3 sind verschiedene Realisierungsmöglichkeiten denkbar, z.B. ein Schieberegister, das mit einem Latchregister gekoppelt ist.

Die hier vorgestellten erfindungsgemäßen ersten, zweiten und dritten Mittel erlauben es dem Kalibrationsverfahren, die Offsetspannung der Verstärkerstufe zu minimieren. Hierzu
- bringt sie die Steuereinheit durch Beschreiben des Speicherregisters in einen Zustand, bei dem die Gateeingänge von T1, T2 mit dem Hilfspotential 19 verbunden sind,
- beobachtet die verstärkte Offsetspannung mittels der Vergleichereinheit, der über die dritten Mittel die Zustände der Ausgänge A1, A2 zugeführt werden, und
- stellt über Beschreiben des Speicherregisters die zweiten Mittel derart nach, daß die Offsetspannung minimiert wird.

In einer ähnlichen Weise erfolgt das Kalibrieren einer Stromquelle auf Sollwert. In der Figur 27 ist die Fußstromquelle 20 des Differenzverstärkers hierzu über den daran angeschlossenen steuerbaren Umschalter US mit T1, T2 verbunden, der gleichzeitig das erste und das dritte Mittel realisiert, wobei sich die eindeutige Zuordnung erst auf Transistorebene ergibt: der Teil des Umschalters, der die Stromquelle mit dem gemeinsamen Sourceknoten von T1 und T2 verbinden kann, ist das erste Mittel, und der Teil des Umschalters, der die Stromquelle mit den Kalibrationsausgang KA verbinden kann, ist das dritte Mittel. Das mit derselben Fußstromquelle 20 verbundene zweite Mittel 17b kann beispielsweise eine steuerbare Stromquelle sein, und der Summenstrom aus der Stromquelle 20 und dem zweiten Mittel ist auf den Sollwert zu kalibrieren. Dieser Summenstrom wird im Kalibrationsmodus statt auf T1, T2 über einen der Kalibrationsausgänge KA auf eine Vergleichereinheit geleitet, die diesen Summenstrom mit einem ihr zugeführten Sollstrom vergleicht.

Auf diese Weise kann das Kalibrationsverfahren eine große Zahl von Stromquellen auf einen einheitlichen Sollstrom kalibrieren, was z.B. für einen einheitlichen Verstärkungsfaktor der Verstärkerstufen nützlich ist, doch es ist auch denkbar, bei speziellen Verstärkerschaltungen, sogenannten GmC - Schaltungen, mittels solcher kalibrierten Stromquellen auch einen Frequenzgang kalibrierbar zu machen.

In der Figur 27 ist auch ein Symbol für eine Verstärkerstufe mit eingebautem Speicherregister und Spalten/Reihendekodierung über Eingänge SS, SR angegeben. Dieses Symbol wird im folgenden für wie beschrieben oder ähnlich ausgebildete Verstärkerstufen verwendet.

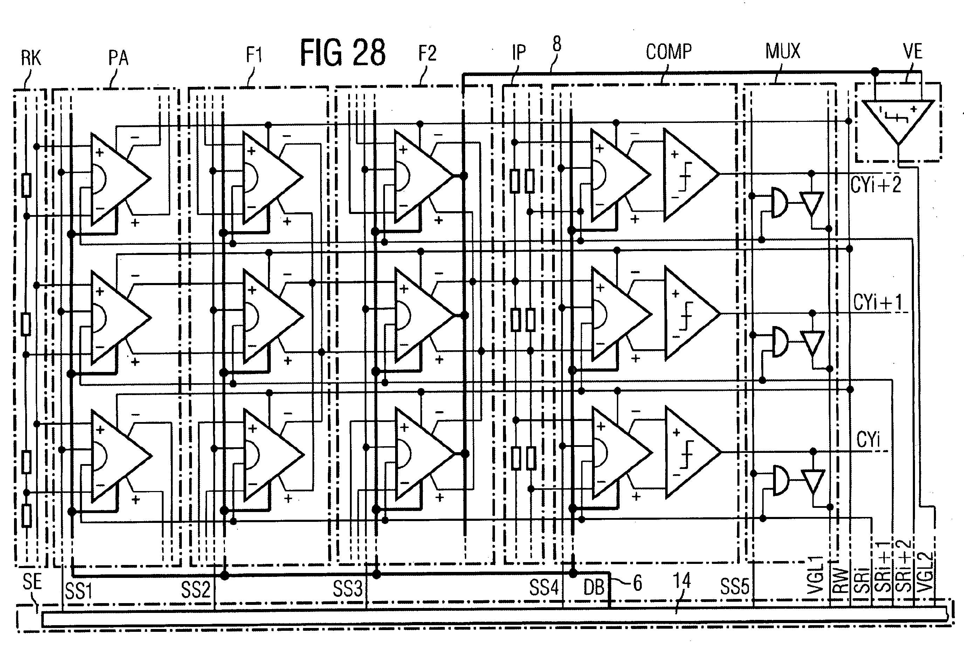

Figur 28 zeigt einen Ausschnitt aus einem ADC, der kalibrierbare Verstärkerstufen gemäß Figur 27 enthält. Es handelt sich hierbei um eine Folding-Architektur, die dem ADC-Fachmann an sich bekannt ist, und die mit der vorstehend beschriebenen Kalibrierungs-Vorrichtung ausgestattet wurde. Ausgehend von einer Referenzkette RK und sogenannten Vorverstärkern PA folgt eine erste Foldingstufe F1, eine zweite Foldingstufe F2, ein Interpolator IP, und Komparatoren COMP. Die Komparatoren COMP bestehen jeweils aus einer Differenzverstärkerstufe und einem diesem nachgeschalteten Komparator, meist als sogenanntes regeneratives Latch ausgeführt. Die Verstärkerstufen dieses ADC sind als kalibrierbare Verstärkerstufen gemäß Figur 27 ausgeführt, wobei im Beispiel die in den Blöcken PA, F1 und COMP enthaltenen kalibrierbaren Verstärkerstufen keine eigenen dritten Mittel und keine Kalibrationsausgänge enthalten. Es wird hier statt dessen in den Fällen von PA, FI eine kaskadierte stufenweise Kalibration ausgehend von den mit dritten Mitteln und Kalibrationsausgängen ausgestatteten Verstärkerstufen im Block F2 durchgeführt. Die Komparatoren im Block COMP sind im Beispiel als gut genug angenommen, um als Vergleichereinheiten für die Kalibration der ebenfalls im Block COMP enthaltenen Verstärkerstufen dienen zu können.
Der Mehraufwand zur Auswahl und Zuführung des bei der Kalibration beobachteten Signals auf die Steuereinheit beschränkt sich hierbei auf den mit MUX bezeichneten Multiplexer, der Treiberstufen enthält, die über Reihen-, und Spaltensignale dekodiert werden können.

Der mit MUX bezeichnete Block enthält eine Logik, durch welche bestimmbar ist, welches Vergleichsergebnis (das Vergleichsergebnis von welchem Komparator) über eine Signalleitung VGL1 der Steuereinheit zugeführt wird. Für die anderen kalibrierbaren Verstärkerstufen, PA, FI und F2, ist die Vergleichereinheit VE vorgesehen, der die zu vergleichenden elektrischen Größen über die Meßleitungen 8 zugeführt werden.

Wenn es die Architektur und die Detailauslegung des Gesamtsystems zulassen würden, Signalpfade von jedem der zu kalibrierenden Verstärker auf einen der im Block COMP befindlichen Komparatoren durchzuschalten, und wenn diese genau genug wären, dann können diese die Rolle der Vergleichereinheit VE übernehmen, und der in Figur 28 mit VE bezeichnete Block könnte entfallen, ebenso das Netz 8. Außerdem würde dann keine der kalibrierbaren Verstärkerstufen Kalibrationsausgänge und eigene dritte Mittel benötigen, da die ohnehin vorhandenen Verstärkerstufen als dritte Mittel im Sinne der Erfindung benutzt werden könnten. Wegen dem Interpolator IP wurde bei der in der Figur 28 gezeigten Anordnung jedoch kein Gebrauch von dieser Vereinfachungsmöglichkeit gemacht. Die erwähnte Vereinfachung kann aber beispielsweise bei nichtinterpolierenden ADCs (ADCs vom Flash-Typ) Anwendung findet.

Im Block SE der Figur 28 befindet sich die Steuereinheit 14, die das Kalibrationsverfahren durchfuhrt. Die Steuerung der erfindungsgemäßen Mittel in den kalibrierbaren Verstärkerstufen erfolgt über Datenbus DB, Spaltenselektionssignale (im betrachteten Beispiel SS1 ... SS5), Reihenselektionssignale (im betrachteten Beispiel über SRi, SRi+1 und SRi+2), und dem Schreib/Lesesignal RW. Was diese Steuerung und den Datentransfer angeht, stellen sich der Steuereinheit SE die Speicherregister innerhalb der Matrix von kalibrierbaren Verstärkern funktionsmäßig ähnlich wie ein RAM dar. Über die beiden Eingänge VGL1 und VGL2 werden der Steuereinheit Vergleichsergebnisse zugeführt, mit deren Hilfe sie feststellen kann, ob die zu kalibrierenden Eigenschaften der Verstärkerstufen bereits im Soll sind oder nicht; wenn dies nicht der Fall ist, werden die Stellwerte der zweiten Mittel entsprechend nachgeführt.

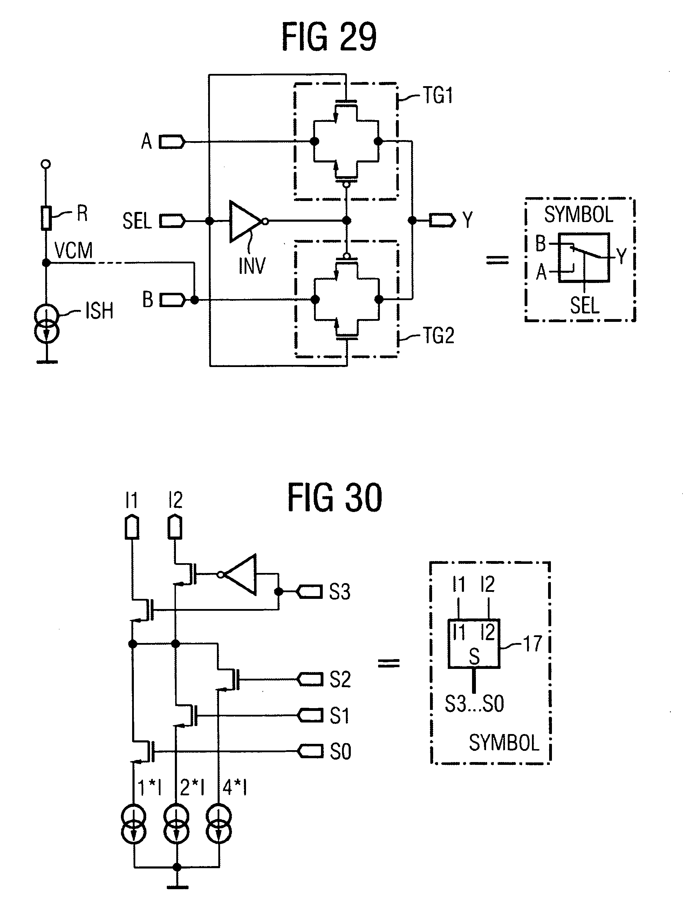

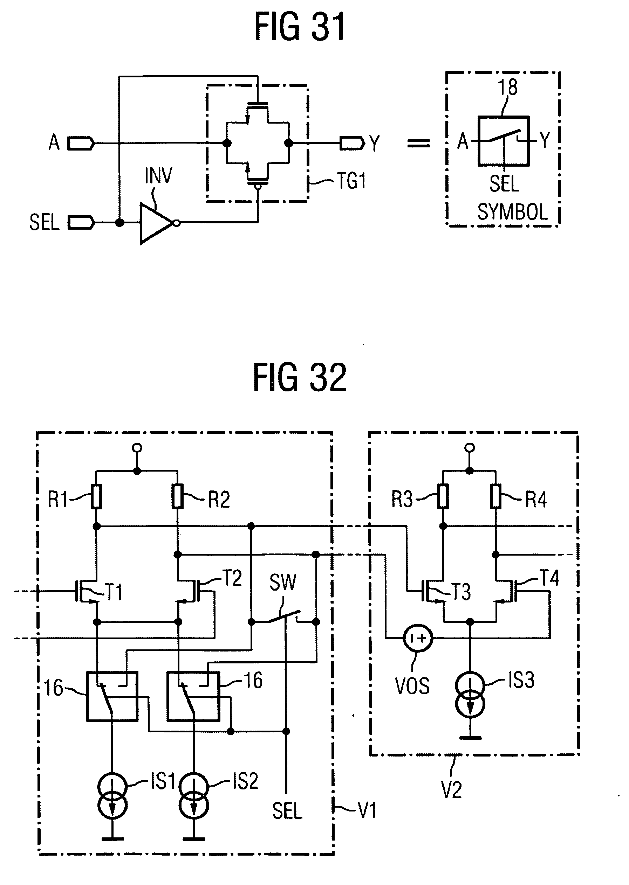

Für den praktischen Eisatz geeignete, besonders einfache Realisierungen der ersten, zweiten und dritten Mittel sind beispielhaft in den Figuren 29 bis 31 dargestellt, während die Figuren 32 bis 39 besonders vorteilhafte Realisierungen solcher Mittel für spezielle Einsatzgebiete der Erfindung beispielhaft zeigen.

Figur 29 zeigt ein einfaches Beispiel einer schaltungstechnischen Realisierung der ersten Mittel und das zugehörige Symbol hierfür. Es handelt sich hier um zwei Transfergates TG1, TG2, die über einen Steuereingang SEL und einen Inverter INV so angesteuert werden, daß bei SEL=L das Transfergate TG1 leitet, und bei SEL = 0 das Transfergate TG2. In Figur 29 ist ebenfalls beispielhaft dargestellt, wie ein Hilfspotential VCM erzeugt werden kann, das dem Gleichgewichtszustand einer vorangehenden Verstärkerstufe entspricht, hierzu genügt es, eine Stromquelle ISH auf einen Widerstand R zu führen. Die Stromquelle ISH liefert dabei den halben Fußstrom der Stromquelle IS des Verstärkers aus der Figur 24, und der Widerstand R hat denselben Wert wie die Widerstände R1 und R2 des Verstärkers gemäß Figur 24.

Figur 30 zeigt ein einfaches Beispiel einer schaltungstechnischen Realisierung der zweiten Mittel und das zugehörige Symbol. Hier wird eine Anzahl binär gewichteter Stromquellen über steuerbare Schalter, die von Signalen SO bis S2 gestellt werden, über weitere vom Signal S3 steuerbare Schalter wahlweise auf einen Anschluß I1 oder I2 aufgeschaltet. Das Signal S3 entspricht dem Vorzeichen des zu korrigierenden Fehlers.

Figur 31 zeigt ein einfaches Beispiel einer schaltungstechnischen Realisierung der dritten Mittel und das zugehörige Symbol. Es handelt sich um ein einfaches Transfergate, welches von einem Signal SEL ein- oder ausgeschaltet werden kann.

Figur 32 zeigt eine schaltungstechnische Realisierung der ersten Mittel, wobei diese ersten Mittel sich in einer der zu kalibrierenden Verstärkerstufe V2 vorangehenden Verstärkerstufe VI befinden. Auf diese Weise können Transfergates in den Signalpfaden für den Normalbetrieb vermieden werden, was besonders bei kleineren Versorgungsspannungen einen Geschwindigkeitsvorteil bringt oder sogar erst die Anwendung der Erfindung erlaubt.

Die Grundidee ist hier, auf die vorhergehende Stufe so einzuwirken, daß sich an ihren Ausgängen eine im wesentlichen gleiche Spannung einstellt. Ist die vorhergehende Stufe beispielsweise eine Verstärkerstufe gemäß Figur 24, könnte dies prinzipiell durch Abschaltung ihrer Fußstromquelle bewerkstelligt werden. Die Lastwiderstände R1, R2 würden dann den Ausgang dieser vorhergehenden Stufe auf ein gleiches Potential ziehen und damit auch die Eingänge der nachfolgenden Stufe. Der Abschalter für die Fußstromquelle der vorhergehenden Stufe wäre somit das erste Mittel der nachfolgenden Stufe. Dieses Beispiel verdeutlicht, daß die erfindungsgemäßen Mittel auf mannigfaltige Weise realisiert werden können, allerdings hätte diese Einfachlösung den Nachteil, daß die zu kalibrierende nachfolgende Verstärkerstufe bei einer anderen Gleichtaktaussteuerung kalibriert wird als im Normalbetrieb.

In der Figur 32 wird eine Schaltung offenbart, die diesen Nachteil vermeidet. Die Fußstromquelle besteht hier aus zwei Stromquellen ISI, IS2, die jeweils den halben Strom beitragen, und diese sind im Normalbetrieb (Schalterstellung in der Figur) auf den gemeinsamen Sourceknoten des Differentialpaars TI, T2 aufgeschaltet. Im Kalibrationsbetrieb werden die Stromquellen ISI, IS2 jeweils auf einen der Lastwiderstände R1, R2 umgeschaltet. Der Schalter SW ist im Normalbetrieb offen, im Kalibrationsbetrieb geschlossen. Er ist so niederohmig auszulegen, daß ein hinreichender Ausgleich des Potentials an den Ausgängen A1 und A2 auch bei Mismatch der Stromquellen und der Lastwiderstände RI, R2 erfolgt. Wenn es sich um vorher kalibrierte Stromquellen handelt, und das Matching der Lastwiderstände gut genug ist, was bei Widerständen meist keine Probleme aufwirft, da sie in der Regel bessere Matchingeigenschaften als Transistoren haben, kann der Schalter SW auch entfallen. Der Vorteil dieser erfinderischen Schaltungsanordnung besteht darin, daß die Kalibration der nachfolgenden Verstärkerstufe bei einer dem Normalbetrieb entsprechenden Gleichtaktaussteuerung erfolgt und es kann daher auch bei einem höheren Ausgangsleitwert ihrer Fußstromquelle IS3 eine erfolgreiche Kalibration der Offsetspannung durchgeführt werden. Bei geringeren Anforderungen genügt aber meist die nicht bildhaft dargestellte, oben erwähnte Lösungsmöglichkeit, einfach die Fußstromquelle der vorangehenden Verstärkerstufe abzuschalten.

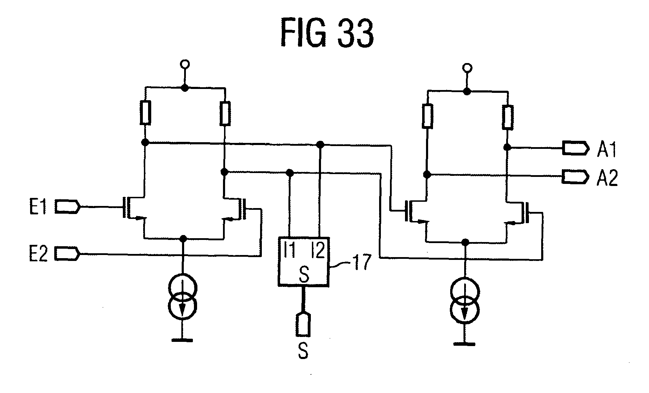

Figur 33 zeigt ein für Folding-ADCs geeignetes Beispiel eines zweistufigen Verstärkers, bei dem die zweiten Mittel gemäß Figur 30 auch für Foldingstufen benützt werden können. Da bei Foldingstufen mehrere kalibrierbare Verstärkerstufen unter Bildung von Bäumen aus solchen Verstärkern an ihren Ausgängen zusammengeschaltet werden, ist es nicht möglich, die zweiten Mittel gemäß Figur 30 direkt an den Ausgängen A1, A2 des Verstärkers anzusetzen, da ansonsten die zweiten Mittel kurzgeschlossen würden und somit eine unabhängige Kalibration der zusammengeschalteten Einzelverstärker nicht möglich wäre. Der mehrstufige Aufbau nach Figur 33 zeigt den Ausweg. Die zweiten Mittel werden hierbei zwischen zwei Differenzverstärkerstufen so angeschlossen, daß eine Verbindung der Ausgänge A1, A2 keine unerwünschte Rückwirkung auf die zweiten Mittel hat. Ein solcher zweistufiger Aufbau bringt auch weitere Vorteile (Bandbreite), da die geforderte Verstärkung auf zwei Stufen verteilt werden kann.

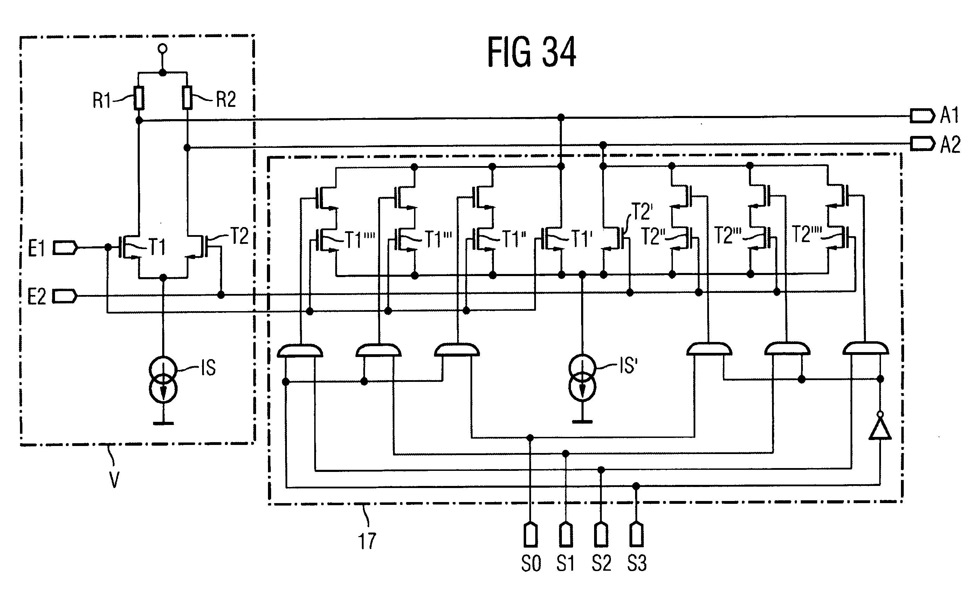

Figur 34 zeigt beispielhaft ein weiteres für Folding-ADCs geeignetes Beispiel einer schaltungstechnischen Realisierung der zweiten Mittel. Parallel zum Eingangsdifferentialpaar T1, T2 werden zuschaltbare Transistoren T1', T1'', T1''', T1'''', und T2', T2'', T2''', T2'''' angeschlossen, wobei die Gateanschlüsse aller Transistoren T1 ... T1'''' und T2 ... T2'''' verbunden sind. Die Drainanschlüsse der Transistoren T1' ... T1'''' werden dabei über steuerbare Schalttransistoren mit dem Ausgang A1, die Drainanschlüsse der Transistoren T2' ... T2'''' werden dabei über steuerbare Schalttransistoren mit dem Ausgang A2 verbunden. Wenn die Transistoren beispielsweise in ihrer Weite binär gewichtet sind, ergeben sich bei drei zusätzlichen Differentialpaaren - wie im Beispiel - bis zu acht Abstufungen, bei vier ergäben sich sechzehn Abstufungen, usw. Es ist zweckmäßig, daß die Fußstromquelle IS', die mit den Sourceanschlüssen der zusätzlichen Transistoren T1' ... T1'''' und T2' ... T2'''' verbunden ist, einen wesentlich geringeren Strom liefert als die Fußstromquelle IS des Differentialpaares TI, T2. Durch Änderung des Stroms in IS' könnte der Offsetkorrekturbereich gesteuert werden, falls das erforderlich ist.

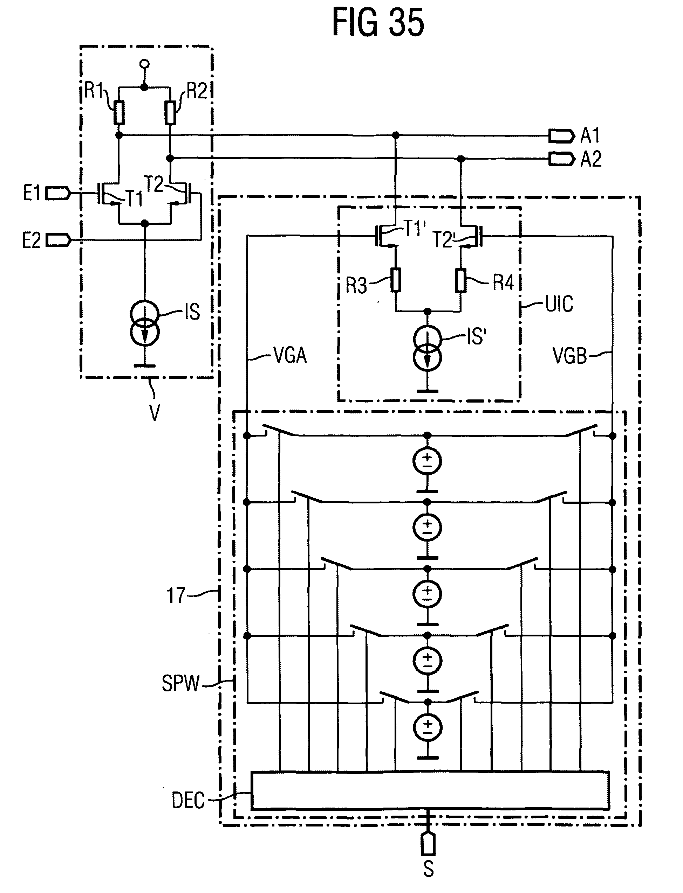

Figur 35 zeigt eine besonders vorteilhafte Realisierung zweiter Mittel, innerhalb des Blocks 17. Diese ist gekennzeichnet durch eine spannungsgesteuerte differentielle Stromquelle UIC, die auf die Lastelemente R1, R2 des kalibrierbaren Verstärkers wirkt, und einen Spannungswähler SPW, der unter Einfluß von Steuereingängen S geeignete Spannungen auswählt und über seine Ausgänge VGA und VGB der spannungsgesteuerten differentiellen Stromquelle UIC zuführt. Zusammen bilden UIC und SPW das erfindungsgemäße zweite Mittel 17.

Die in den Blöcken UIC und SPW angegebene Innenschaltung in Figur 35 ist als ein mögliches Ausführungsbeispiel zu sehen, generell können beliebige zweckmäßige spannungsgesteuerte differentielle Stromquellen und Spannungswähler benutzt werden, um diese besonders vorteilhafte, digital steuerbare differentielle Stromquelle zu realisieren. Ihre Vorteile bestehen in einer hohen Gleichtaktunterdrückung auch gegen Störungen, die über Gates von Schalttransistoren eingekoppelt werden, da diese bei geeigneter Auslegung symmetrisch sind, und in einer nur geringen kapazitiven Belastung der inneren Knoten des Verstärkers.

Im Beispiel wird die spannungsgesteuerte differentielle Stromquelle durch ein Differentialpaar T1', T2' realisiert. Degenerationswiderstände R3 und R4 dienen zur Linearisierung. Bei geringeren Anforderungen können diese Widerstände entfallen. Der Stand der Technik kennt viele weitere Schaltungstechniken, geeignete spannungsgesteuerte differentielle Stromquellen zu realisieren, sogenannte Transkonduktoren, die anstelle der Beispielschaltung im Block UIC treten können.

Der Stand der Technik kennt weiterhin viele Möglichkeiten, geeignete Spannungswähler zu realisieren. Gekennzeichnet sind mögliche Spannungswähler im Sinne der Erfindung durch eine Anzahl von Spannungsquellen, die beispielsweise auch aus Anzapfungen einer Widerstandskette gebildet werden können, einer Anzahl von steuerbaren Schaltern, mit denen die gewünschten Spannungen ausgewählt und den Anschlüssen VGA und VGB zugeführt werden können, und einer Steuersignalauswertung, beispielsweise ein Dekoder DEC, der die steuerbaren Schalter stellt. Es sind hier beliebige Varianten möglich, die die kennzeichnenden Eigenschaften des Spannungswählers haben, z.B. Realisierung der Dekodierung durch Serienschaltung von steuerbaren Schaltern.

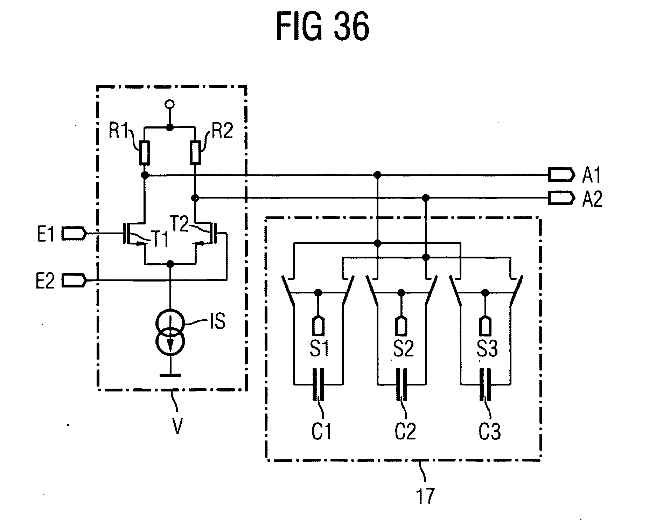

Figur 36 zeigt ein Beispiel einer schaltungstechnischen Realisierung zweiter Mittel zur Kalibrierung eines Frequenzganges. Statt schaltbarer Stromquellen wie in Figur 30 werden hier Kapazitäten an Knoten des Verstärkers V geschaltet. Auch hier ist die schaltungstechnische Realisierung des Verstärkers freibleibend, eine beliebige zweckmäßige Verstärkerschaltung kann anstelle des Beispiels treten.

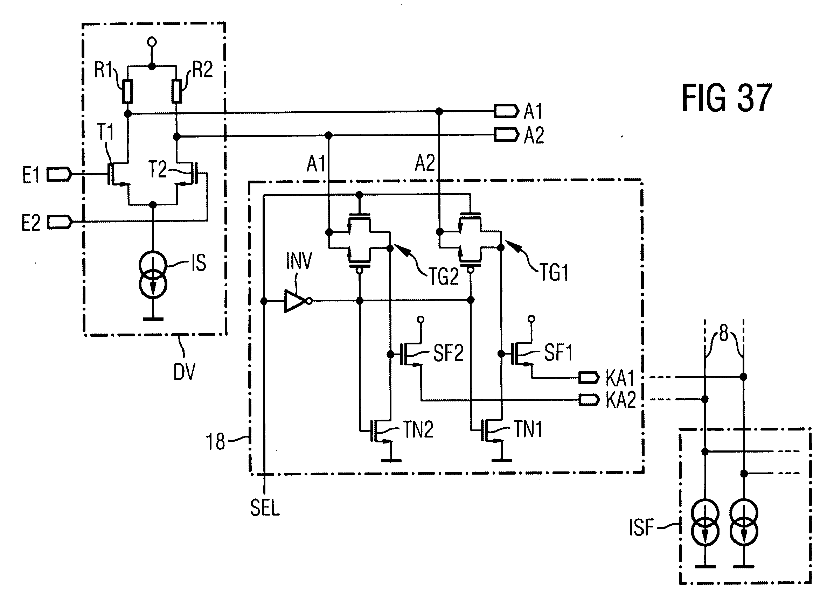

Figur 37 zeigt ein Beispiel für eine besonders vorteilhafte schaltungstechnische Realisierung der dritten Mittel. Diese bestehen hierbei aus Transfergates TG1, TG2, denen jeweils ein Sourcefolgertransistor SF1, SF2 nachgeschaltet ist. Die Ausgänge der Sourcefolger führen auf die Kalibrationsausgänge KAI, KA2 des kalibrierbaren Verstärkers, die über die Meßleitungen 8 mit den Stromquellen der Sourcefolger im Block ISF verbunden sind. Diese Stromquellen brauchen daher nur einmal an zentraler Stelle vorhanden sein.

Im Normalbetrieb ist SEL = 0 und die Transfergates sind abgeschaltet. Da ihre Transistoren keine Kanäle ausbilden, ist die kapazitive Belastung der Knoten des kalibrierbaren Verstärkers gering. Die Transfergates selbst können wegen der Sourcefolger wesentlich kleiner ausgelegt werden als im Fall von Figur 31, wo die Transfergates die Meßleitungen 8 direkt bedienen. Die Sourcefolger SF1 und SF2 sind im Normalbetrieb abgeschaltet, da ihre Gates über die Transistoren TN1 und TN2 unter Steuerung durch den Inverter INV auf Masse gezogen werden. Im Kalibrationsbetrieb ist bei der selektierten kalibrierbaren Verstärkerstufe SEL = 1. Die Transfergates sind eingeschaltet, TN1 und TN2 sind ausgeschaltet, und somit schalten die Sourcefolger die Knoten der kalibrierbaren Verstärkerstufe auf die Meßleitungen 8 auf.

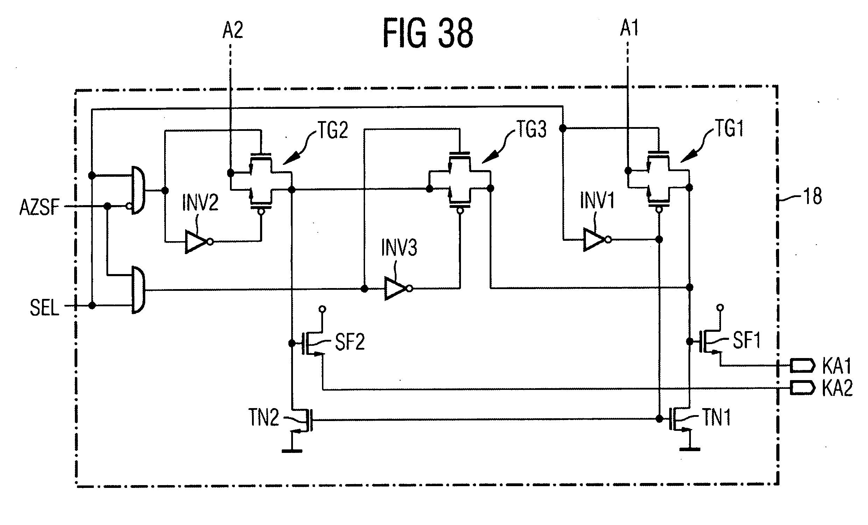

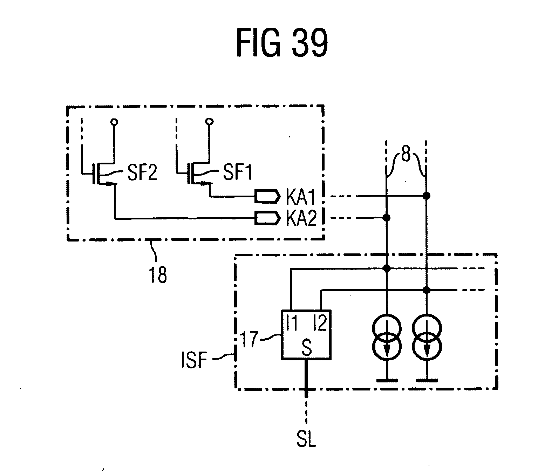

Figur 38 zeigt ein Beispiel für eine offsetkompensierte Variante der dritten Mittel von Figur 37. Diese Maßnahme ist dann erforderlich, wenn eine höhere Genauigkeit der Kalibration gefordert wird. Ein zusätzliches Transfergate TG3 und ein zusätzliches Steuersignal AZSF, das z.B. aus dem Speicherregister der kalibrierbaren Verstärkerstufe kommen kann, erlaubt es, vor der Kalibration der Verstärkerstufe eine Offsetkompensation der Sourcefolger durchzufahren. Hierzu ist bei SEL = 1 und AZSF = 1 das Transfergate TG2 noch abgeschaltet, während Transfergate TG1 das Gate von SF1 mit Knoten A1 verbindet. Das Transfergate TG3 verbindet das Gate von SF2 mit dem Gate von SF1 und somit mit dem gleichen Potential, dem von Knoten Al. Zwar könnte TG3 direkt mit Knoten Al verbunden werden, aber dies würde die kapazitive Last an Al auch im Normalbetrieb unsymmetrisch erhöhen. In beiden Varianten liegen die Gates von SF1, SF2 am selben Potential, so daß sich eine Offsetspannung der Sourcefolger an den Ausgängen KAI und KA2 manifestiert und somit herauskalibriert werden kann. Wie dies geschieht ist weiter unten bei Figur 39 beschrieben. Nach der Kalibration der Sourcefolger wird nun AZSF = 0 gesetzt, TG3 ist dann abgeschaltet, und TG1, TG2 eingeschaltet, das Gate von SF2 ist somit mit Knoten A2 verbunden. Nun übertragen die zuvor kalibrierten Sourcefolger den Gleichgewichtszustand an A1, A2 fehlerfrei auf die Kalibrationsausgänge KAI, KA2, die zu der Vergleichereinheit führen.

Figur 39 zeigt beispielhaft, wie die Stromquellen der Sourcefolger, Block ISF, erweitert werden können, um die Offsetkompensation der dritten Mittel nach Figur 38 mit geringem Aufwand durchzufahren. An einer oder beiden Stromquellen der Sourcefolger werden zweite Mittel 17 vorgesehen, mit denen der Strom um einen Mittelwert einstellbar gemacht wird.

Es ist somit für die Steuereinheit, die das Kalibrationsverfahren durchführt, über die Steuerleitungen SL in einfacher Weise möglich, die bei Figur 38 beschriebene Kalibration der dritten Mittel durchzuführen. Auf diese Weise sind die aufwendigeren zweiten Mittel nur einmal je Stromquellenblock ISF notwendig, d.h. im Normalfall nur einmal pro Vergleichereinheit, und nicht pro drittem Mittel in den kalibrierbaren Verstärkerstufen.

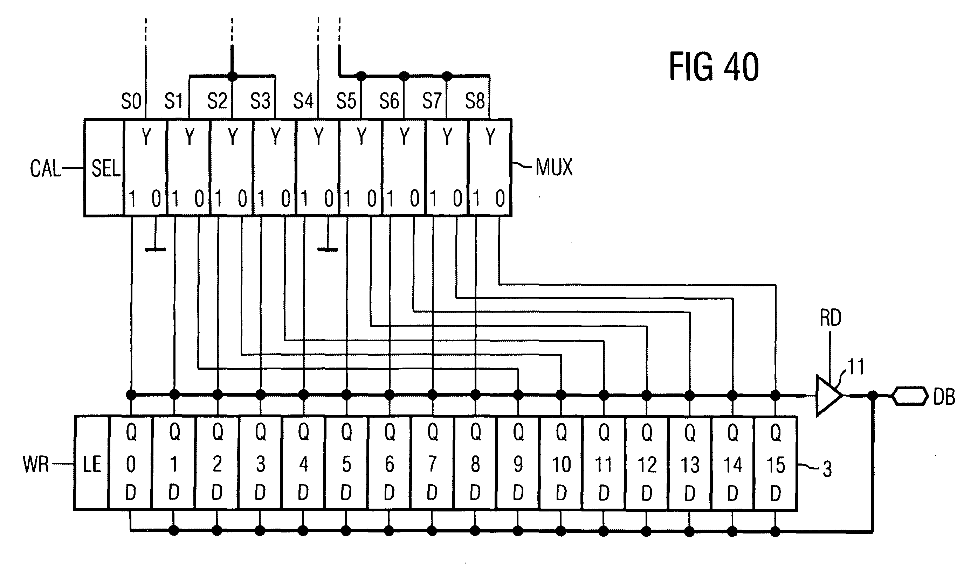

Figur 40 zeigt eine besonders vorteilhafte Ausführung des Speicherregisters einer kalibrierbaren Verstärkerstufe, bei der ein besonders schnelles Wechseln zwischen Normalbetrieb und Kalibrationsbetrieb möglich ist.

Dies gelingt durch die Erweiterung des Speicherregisters um einen zweiten Satz der für den Normalbetrieb erforderlichen Speicherzellen und einer kombinatorischen Auswahllogik, beispielsweise aus 2:1 Multiplexerzellen aufgebaut, in der Figur mit MUX bezeichnet. Ein zusätzliches globales Signal CAL, in den vorangehenden Figuren nicht eingezeichnet, das allen derartigen kalibrierbaren Speicherzellen zugeführt wird, wirkt auf die kombinatorische Auswahllogik so, daß den ersten, zweiten und dritten Mitteln im Normalbetrieb, CAL = 0, die für den Normalbetrieb vorgesehenen Stellwerte zugeführt werden, im Beispiel Bits 9 ... 15 des Speicherregisters, und im Kalibrationsbetrieb, CAL = 1, die für den Kalibrationsbetrieb vorgesehenen Stellwerte, im Beispiel Bits 0 ... 8. Wie einige der fest mit Masse verbundenen Multiplexereingänge zeigen, ist es nicht notwendig, für alle im Kalibrationsbetrieb benötigten Steuerbits eine weitere Speicherzelle für den Normalbetrieb vorzusehen, wenn eine rein kombinatorische Verknüpfung genügt, um den Stellwert für Normalbetrieb liefert.

Die Steuereinheit ist nun vermöge dieses erweiterten Speicherregisters in der Lage, einen Kalibrationsschritt vorzubereiten, indem sie die für den Kalibrationsbetrieb vorgesehenen Speicherzellen beschreibt, ohne die Speicherzellen für den Normalbetrieb zu ändern. Dann wird durch Umschalten des Signal CAL auf 1 das gesamte kalibrierbare System sofort in den Kalibrationsmodus versetzt, und nach dem Einschwingen und Vorliegen des Resultats der Vergleichereinheiten kann es durch Rücksetzen von CAL auf 0 sofort wieder in den Normalbetrieb zurückversetzt werden. Die Steuereinheit kann nun das Ergebnis des Vergleichs auswerten und den nächsten Kalibrationsschritt vorbereiten, während der Normalbetrieb weiterläuft. Auf diese Weise können Kalibrationsschritte taktweise in den Normalbetrieb eingeschoben werden.

Diese Ausbildung der Erfindung, die sich des Speicherregisters nach Figur 40 bedient, ist beispielsweise in der Lage, das Kalibrationsverfahren in einen mit voller Geschwindigkeit getakteten ADC jeden Nten Takt einzuweben, so daß die Illusion entsteht, das Kalibrationsverfahren laufe im Hintergrund ab. Damit diese Illusion nicht trügerisch ist, darf nach einem Takt, in dem der ADC in den Kalibrationsmodus versetzt war, und das Quantisierungsergebnis daher zwangsläufig falsch ist, dieses falsche Quantisierungsergebnis nicht weiterverarbeitet werden. Dies gelingt in trivialer Weise dadurch, daß N=2 ist und jedes zweite Quantisierungsergebnis weggeworfen wird, es entsteht dadurch der Eindruck eines im Hintergrund kalibrierten ADC mit halber Abtastfrequenz. Dies ist keine Einbuße, da selbstkalibrierte ADCS, die sich der Erfindung bedienen, auch bei der Hälfte ihrer maximalen Geschwindigkeit noch wesentlich schneller sind als gewöhnliche ADCS.

Hiermit ist die Beschreibung der erfindungsgemäßen Vorrichtung abgeschlossen. Es ist dem Fachmann ohne weiteres möglich, Änderungen oder Ergänzungen in den beispielhaft vorgestellten Schaltungen vorzunehmen, ohne den Geist und den Anspruch der Erfindung zu verändern, z.B. können die beschriebenen Schaltungen auch mit komplementären MOS-Transistoren aufgebaut werden, oder MOS-Transistoren im Falle eines BiCMOS-Prozesses durch bipolare Transistoren ersetzt werden, oder es können Kaskoden eingebaut werden.

Wie das erfindungsgemäße Kalibrationsverfahren arbeitet, wird im folgenden bezugnehmend auf Figur 26 dargestellt.

Die Kalibration wird über ein auf die Steuereinheit 14 wirkendes, in der Figur nicht dargestelltes, Startsignal gestartet. Dies geschieht zweckmäßigerweise mindestens einmal unmittelbar nach dem Einschalten der integrierten Schaltung.

Enthält das zu kalibrierende System kalibrierbare Stromquellen, werden zunächst diese auf den jeweiligen Sollwert kalibriert. Dies geschieht durch Abtrennen der Stromquellen von ihrer normalen Senke und Umleitung des Ausgangsstroms über ein Meßleitungsnetz auf eine Vergleichereinheit für Ströme. Abhängig vom Ergebnis des Vergleichs stellt die Steuereinheit die zweiten Mittel so, daß der beobachtete Strom dem Sollwert möglichst nahekommt. Hierzu sind lineare Suchverfahren, Aufwärts/Abwärtszähler, oder binäre Suchverfahren, wie sukzessive Approximation, denkbar. Da die Stromquellen während der Kalibration von ihren Senken abgetrennt werden, beeinflussen sie sich nicht untereinander und können daher in einer beliebigen Reihenfolge kalibriert werden.

Bei der Kalibration von Offsetspannungen oder anderen Verstärkereigenschaften, die nicht schon bei der Stromquellenkalibration auf Soll gebracht werden können, wäre die Reihenfolge der Kalibration der Stufen in dem Fall egal, in dem alle kalibrierbaren Verstärkerstufen über dritte Mittel und Kalibrationsausgänge verfügen würden. Dies würde aber den Aufwand erhöhen.

Bei einer besonders vorteilhaften Variante des Kalibrationsverfahrens, kaskadierte stufenweise Kalibration genannt, strebt das Verfahren an, bereits durch die Architektur des kalibrierbaren Systems vorgegebene Verbindungen zwischen den kalibrierbaren Verstärkerstufen, durch die diese zu Signalverarbeitungsketten oder Signalverarbeitungsbäumen verbunden sind, so zu nutzen, daß zusätzliche dritte Mittel dadurch eingespart werden, indem bereits kalibrierte Verstärkerstufen bei der Kalibration ihnen vorangestellter kalibrierbarer Verstärkerstufen als drittes Mittel benutzt werden. Im Regelfall sind zusätzliche dritte Mittel daher nur an den jeweiligen Enden der Signalverarbeitungsketten oder Signalverarbeitungsbäume notwendig. Befinden sich an diesen Enden geeignete Komparatoren, können diese sogar als Vergleichereinheit im Sinne der Erfindung benutzt werden.

Das Verfahren der kaskadierten stufenweisen Kalibration beginnt mit der Kalibration derjenigen Verstärkerstufen, die am Ende der Signalverarbeitungsketten oder Signalverarbeitungsbäume liegen, z.B. V3. Wenn diese kalibriert sind, werden sie in den folgenden Kalibrationsschritten als drittes Mittel benutzt, um die Ausgangsspannungen vorangehender Verstärkerstufen, z.B. V2, zu verstärken und der Vergleichereinheit bzw. den Vergleichereinheiten zuzuführen. Dies geschieht vorzugsweise unter Ausnutzung ohnehin vorhandener Verbindungen. Denkbar wäre jedoch auch der Einbau zusätzlicher dritter Mittel, die einzelne oder mehrere Verstärkerstufen umgehen, um das Signal über weitere Verstärkerstufen der Vergleichereinheit zuzuführen. Bisher wurde jedoch in der Praxis kein Fall gefunden, in dem diese Komplikation notwendig gewesen wäre. Auch für so komplexe Strukturen wie Folding-ADCs existieren geeignete dritte Mittel, um eindeutige Signalpfade durch die Verstärkermatrix aufbauen zu können.

Das Kalibrationsverfahren schreitet so in systematischer Weise von Stufe zu Stufe fort, z.B. V3, V2, V1, bis alle kalibrierbaren Parameter in allen Verstärkerstufen auf Soll sind.

Gelingt dies nicht, z.B. durch einen Fabrikationsfehler der jeweiligen integrierten Schaltung, kann die Steuereinheit das Mißlingen der Kalibration dadurch feststellen, daß einer der Parameter nicht auf Soll geführt werden kann. Diesen Sachverhalt kann die Steuereinheit dann als Fehlermeldung weitergeben, somit handelt es sich bei einer mit der Erfindung ausgestatteten Schaltung auch um einen Selbsttest, der die Testzeit und Kosten bei der Fertigung einer solchen integrierten Schaltung erheblich senken kann.

Für Fälle, in welchen das Scheitern des Selbsttests auf einen zu geringen Korrekturbereich für Fehler, z.B. Offsetspannungen, zurückzuführen ist, ist der Korrekturbereich durch die Steuereinheit zentral einstellbar gemacht worden, indem die Ströme in den Stromquellen der zweiten Mittel beeinflußt werden können, dann kann das beschriebene Selbstkalibrationsverfahren den Korrekturbereich schrittweise erhöhen, bis ein Kalibrationserfolg eintritt, oder bei weiterem Mißerfolg die integrierte Schaltung endgültig als defekt bewerten. Als Nebenprodukt ergibt sich hier nicht nur eine Vollzugsmeldung, sondern eine Klassifizierung der integrierten Schaltungen beispielsweise in erste, zweite und dritte Wahl, ohne aufwendige Testautomaten bemühen zu müssen.

Nach dem erfolgreichen Abschluß der Kalibration steht das kalibrierbare Subsystem, beispielsweise ein ADC, zum Normalbetrieb bereit. Durch unvermeidliche Einflüsse wie z.B. langsame Temperatur- und Versorgungsspannungsschwankungen wird das kalibrierbare Subsystem aber unvermeidlich aus der Kalibration wegdriften.

Durch einen erneuten Start der Kalibration von Zeit zu Zeit kann dieser Drifteffekt ausgeglichen werden. Dies ist insbesondere bei Systemen machbar, in denen das kalibrierbare Subsystem nicht dauernd benutzt wird, z.B. ist es bei Plattenspeicherlaufwerken während der Kopfbewegung sinnlos, die vom Lesekopf kommenden Daten zu digitalisieren. Hier könnte das Kalibrationsverfahren dann ohne Leistungseinbußen eingeschoben werden.

Wenn eine solche Unterbrechungsmöglichkeit nicht besteht, kann mit dem Speicherregister nach Figur 40 eine geschwindigkeitsoptimierte Umschaltmöglichkeit zwischen Normal- und Kalibrationsbetrieb geschaffen werden, so daß die einzelnen Kalibrationsschritte taktweise in den Normalbetrieb eingeschoben werden können und eine kontinuierliche Kalibration im Hintergrund stattfindet.

Es folgt nun eine detaillierte Beschreibung von Vorrichtungen und Verfahren zur Kompensierung von Fehlern, die in einer Verstärkerstufe vorgeschalteten Einrichtungen vorhanden sind.

Zunächst wird die Kompensierung eines Fehlers in einem Referenzspannungsteiler (die Kompensierung einer fehlerhaften Referenzspannung) beschrieben.

Referenzspannungteiler bestehen aus einer Kette von Widerständen, und finden vor allem in Analog/Digitalwandlern (ADC) vom Flash- oder Foldingtyp Anwendung.

In der Eingangsstufe eines solchen ADCs befindet sich gewöhnlich eine Vielzahl von Differenzverstärkern, denen an einem Signaleingang das zu quantisierende Eingangssignal zugeführt wird, und denen an einem Referenzeingang ein aus einer Referenzspannungsteilerkette stammendes Referenzpotential zugeführt wird.

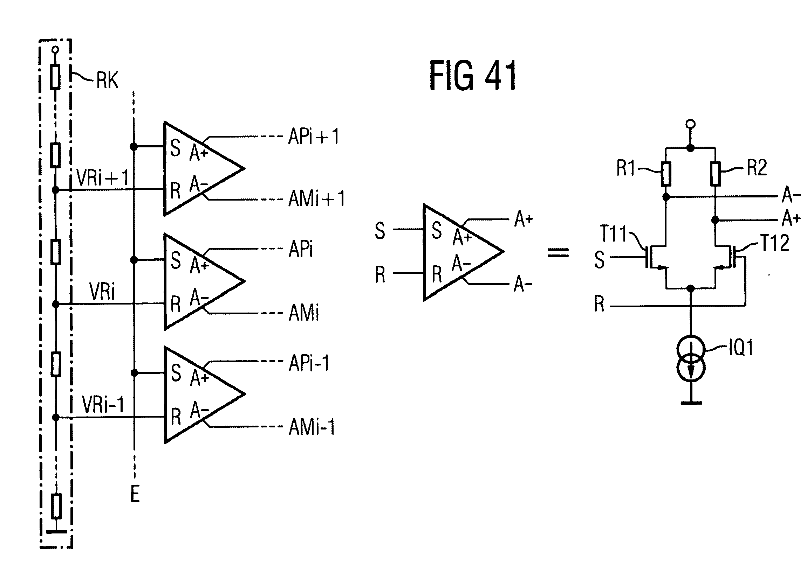

In der Figur 41, die beispielhaft einen Ausschnitt aus einer bekannten Eingangsstufe eines solchen ADC zeigt, sind die Referenzspannungsteilerkette mit RK, die von dieser stammenden Referenzpotentiale mit VRi-1, VRi, VRi+1, das zu quantisierende Eingangssignal mit E, und die Differenzverstärkereingänge mit S und R bezeichnet. Aufgabe der Differenzverstärker ist der Vergleich des Eingangssignals E mit dem jeweiligen Referenzpotential.

Eine solche Eingangsstufe eines ADC hat den Nachteil, daß die Genauigkeit der Quantisierung auch bei Annahme idealer Eigenschaften der Differenzverstärker und der ihnen folgenden Schaltungsstufen prinzipiell nicht genauer sein kann als die Genauigkeit der Referenzpotentiale an den Anzapfungen der Referenzspannungsteilerkette.

Gewöhnlich ist es zwar ohne weiteres möglich, eine Referenzspannungsteilerkette für geringere Anforderungen, beispielsweise einen 8-Bit-Video-ADC, problemlos zu realisieren, etwa als Polysiliziumstreifen. Bei höheren Geschwindigkeiten ist es aber notwendig, die Referenzspannungsteilerkette niederohmiger auszuführen, und somit muß in der Regel ein Material mit geringerem Widerstandsbelag genommen werden.

Hier bietet sich salizidiertes Polysilizium an. Durch die größere Korngröße des Salizids ergäben sich aber größere statistische Schwankungen der Widerstandswerte zwischen den Referenzspannungsabzapfungen, die nur durch eine stark vergrößerte Fläche der Referenzspannungsteilerkette vermieden werden könnten.

In der Praxis wird diese dadurch oft unbrauchbar groß, so daß einige Entwicklungen auf die Verwendung von Metallleiterbahnen als Referenzspannungsteiler ausgewichen sind. Diese werden in der Regel als mäanderartige Strukturen ausführt, die sich über einer Matrix aus Differenzverstärkern schlängeln. Eine Matrixanordnung stellt meist die bestmögliche Lösung dar, um die Länge zeitkritischer Signalleitungen zu minimieren, bringt aber gleichzeitig den Nachteil, daß zu den statistischen Schwankungen der Referenzwiderstandssegmente auch noch systematische Fehler hinzukommen, da nicht alle Segmente exakt gleich layoutet werden können.

Diese Fehler sind schwierig zu modellieren und vorherzusagen, so daß beim bekannten Stand der Technik mit mehreren Maskenversionen und Fabrikationsläufen gerechnet werden muß, wenn, wie beispielsweise für einen 10-Bit- oder 12-Bit-ADC, eine hohe Genauigkeit der Referenzspannungsteilerkette erforderlich ist, was einen hohen Kostenaufwand und einen unplanbaren Zeitverlust mit sich bringt.

Im folgenden werden eine Vorrichtung und ein Verfahren beschrieben, mit welchem vor allem Fehler der Referenzspannungsteilerkette oder sonstiger Referenzspannungsgeneratoren durch einen Kalibrationsvorgang des ADC in ihren Auswirkungen minimiert werden können. Als weiterer Nutzeffekt ist es bei einer bestimmten Ausgestaltung der Erfindung möglich, auch statische Fehler von dem ADC vorgeschaltenen Funktionen, vor allem einer Sample-und-Hold bzw. Track-und-Hold Stufe, ebenfalls durch den Kalibrationsvorgang zu minimieren.

Vorstehend wurden bereits ausführlich Vorrichtungen und Verfahren beschrieben, mit denen unter anderem Offsetfehler von Differenzverstärkern durch ein Selbstkalibrationsverfahren minimiert werden können. Da statistische oder systematische Schwankungen der Referenzspannungspotentiale um ihren jeweiligen Sollwert dieselben Auswirkungen haben wie Offsetfehler der Differenzverstärker, kann die Vorrichtung und das Verfahren zur Kalibration dieser Offsetfehler in der hier offenbarten Weise dazu benutzt werden, Fehler der Referenzspannungsteilerkette herauszukalibrieren.

Die den im folgenden beschriebenen Vorrichtungen und Verfahren zugrundeliegende Idee wurde vorstehend bereits unter Bezugnahme auf die Figuren 17 und 19 beschrieben.

Die folgenden Ausführungen enthalten eine allgemeinere Darstellung, vorteilhafte Weiterbildungen, und die Angabe weiterer Einsatzmöglichkeiten.

Eine besonders vorteilhafte Ausbildung der Grundidee umfaßt die Einbeziehung einer Sample-und-Hold-Stufe in den Kalibrationsvorgang:

Da ein statischer Nichtlinearitätsfehler oder ein statischer Offsetfehler einer Sample-und-Hold-Stufe auf einen ihnen entsprechenden systematischen Fehler der Referenzpotentiale innerhalb des ADC abgebildet werden kann, ist es prinzipiell möglich, diese Fehler der Sample-und-Hold-Stufe herauszukalibrieren, wenn diese in den Kalibrationsvorgang einbezogen wird. Die Grundidee hierzu ist bereits in Figur 23 und der darauf bezugnehmenden Beschreibung enthalten. In diesem Beispiel wurde zwar ein sogenannter Distributed-Track-und-Hold dargestellt, es ist aber für die Möglichkeit der Kalibration von Fehlern der Sample-und-Hold-Stufe unerheblich, wo sich diese befindet, wenn man sich der erfindungsgemäßen Vorrichtung und des Verfahrens bedient, solange die Kalibrationssignalquelle ihr Signal vor der Sample-und-Hold-Stufe einspeist. Die Architektur des Analog/Digitalwandlers mag hierbei jeweils unterschiedlich sein, die Vorrichtung und das Verfahren zur Kalibration ist jedoch dieselbe.

Die im vorgeschlagene Vorrichtung wird am Beispiel eines Analog / Digitalwandlers beschrieben, der eine Referenzspannungsteilerkette enthält, deren Anzapfungen auf Referenzeingänge mehrerer Differenzverstärker führen, deren Offsetspannung unabhängig voneinander kalibrierbar sind,

Die beschriebene Vorrichtung weist die Besonderheiten auf,
- daß Mittel zur Erzeugung eines Kalibrationssignals und Zuführung desselben auf Signaleingänge der Differenzverstärker vorhanden sind, und
- die Kalibrationssignale so beschaffen ist, daß sie die Idealwerte der Potentiale an den Referenzspannungsteilerketten-Abzapfungen mit der jeweils erforderlichen Genauigkeit nachbilden.

Die Besonderheiten des Kalibrationsverfahrens bestehen darin, daß den Differenzverstärkern im Kalibrationsmodus statt des Eingangssignals des ADC das Kalibrationssignal zugeführt wird, und dann derjenigen Teil des Offsetkompensationsverfahrens durchlaufen wird, bei dem die Offsetspannung des Differenzverstärkers so gestellt wird, daß sich an dem Ausgang des Differenzverstärkers ein Gleichgewichtszustand einstellt.

Die Verwendung des Kalibrationssignals als Eingangssignal der Differenzverstärker während der Kalibration der Offsetspannungen der Eingangsstufe des ADC bewirkt aufgrund der Tatsache, daß die Differenzverstärker wegen ihrer inneren Symmetrie nicht zwischen dem Referenzsignal und dem Kalibrationssignal unterscheiden können, eine Stellung der jeweiligen Offsetspannung eines Differenzverstärkers auf einen Wert, der dem Fehler des jeweiligen Referenzpotentials entgegengesetzt ist und diesem betragsmäßig weitgehend gleicht, so daß sich diese Fehler weitgehend gegenseitig aufheben, und somit nahezu ideale Quantisierungsschwellen entstehen.

Diese individuelle Einstellung der Quantisierungsschwellen innerhalb der Differenzverstärker der Eingangsstufe des ADC über eine Stellung der Offsetspannungen dieser Differenzverstärker zum Zwecke der Kompensation von Offsetfehlern, Fehlern der Referenzspannungsteilerkette, und/oder Fehlern weiterer den Differenzverstärkern vorgeschalteter Schaltungsstufen ist ein Merkmal, das die aus dem Stand der Technik bekannten Vorrichtungen und Verfahren zur Kalibration von ADCs nicht aufweisen. Es gibt eine Vielzahl von bekannten Kalibrationsverfahren, die einen Kalibrations-Digital/Analog-Wandler (Kalibrations-DAC) verwenden, um ein Kalibrationssignal zu erzeugen, und dann beispielsweise vermöge einer hinter dem ADC vorgesehenen digitalen Korrekturtabelle versuchen, Fehler zu korrigieren. Diese Verfahren scheitern in der Praxis meist daran, daß der ADC als solcher dann eine wesentlich höhere Zahl von hinreichend monotonen Quantisierungsschritten aufweisen muß, um über Umsetzung seines Ausgangscodes mit der Korrekturtabelle zu einer kalibrierten Quantisierung zu gelangen. Es würde beispielsweise ein 10-Bit-ADC mit einer differentiellen Nichtlinearität DNL von kleiner 0.5 LSB benötigt, um nach der Korrekturtabelle einen 8-Bit-ADC mit einer differentiellen und integralen Nichtlinearität von kleiner 0.125 LSB zu erhalten. Da eine DNL von 0.125 LSB des 8-Bit-ADC von der möglichen absoluten Auflösung jedoch den 0.5 LSB des 10-Bit-ADC entsprechen, wird durch diese und ähnliche Verfahren bis auf die Möglichkeit der Korrektur einer integralen Nichtlinearität INL eigentlich nichts dazugewonnen. Insbesondere ist es nicht möglich, solche Fehler des 10-Bit-ADC zu korrigieren, die zu Kodierungskonflikten seiner niederwertigen Bits führen würden und diesen ADC und damit das ganze Kalibrationskonzept mit der Korrekturtabelle funktionsuntüchtig machen. Der 10-Bit-ADC kann sich daher bei diesen bekannten Kalibrationsverfahren keine größeren statistischen Schwankungen der Referenzpotentiale und der Offsetspannungen der Differenzverstärker erlauben, und gerät dementsprechend flächenaufwendig und teuer.

Demgegenüber erlaubt die hier offenbarte Vorrichtung und das Verfahren, die Quantisierungsschritte beliebig genau einzustellen, beschränkt nur durch die Auflösung und den Stellbereich der Mittel zur Stellung der Offsetspannung in den Differenzverstärkern, und bei Bedarf auch eine nichtlineare Korrekturfunktion in den ADC hineinzukalibrieren, was beispielsweise für die Korrektur von statischen Linearitätsfehlern von dem ADC vorgeschalteten Signalverarbeitungsstufen benutzt werden kann, wenn diese in die Kalibration einbezogen werden. In der Praxis gelingt es durch den Einsatz der hier offenbarten Erfindung, einen ohne Kalibration an sich unbrauchbaren ADC mit schweren Mängeln, beispielsweise einer DNL von mehr als einem LSB, also einer Nichtmonotonie, auf den Qualitätsstandard eines Premium-ADCs zu kalibrieren.

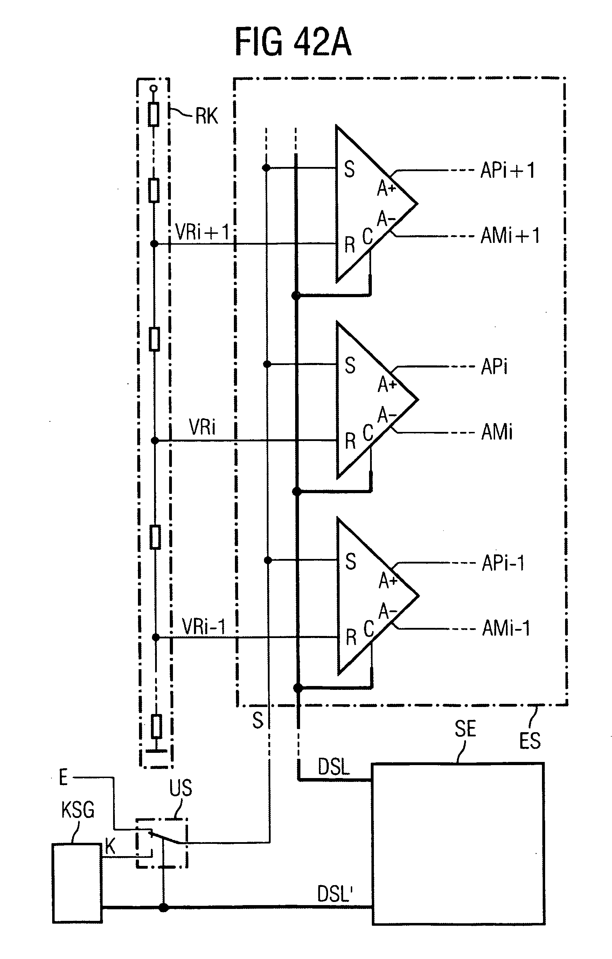

Figur 42a zeigt ein Blockschaltbild der erfindungsgemäßen Vorrichtung.

Das Mittel zur Erzeugung des Kalibrationssignals ist mit KSG bezeichnet, sein Ausgang mit K. Ein weiteres Mittel, mit US bezeichnet, ermöglicht ein Umschalten zwischen dem Eingangssignal E und dem Kalibrationssignal K. Im Normalbetrieb wird den Eingängen S der Differenzverstärker, die sich in der kalibrierbaren Eingangsstufe ES des ADC befinden, das Eingangssignal E zugeführt. Im Kalibrationsbetrieb wird den Eingängen S der Differenzverstärker das Kalibrationssignal K zugeführt.

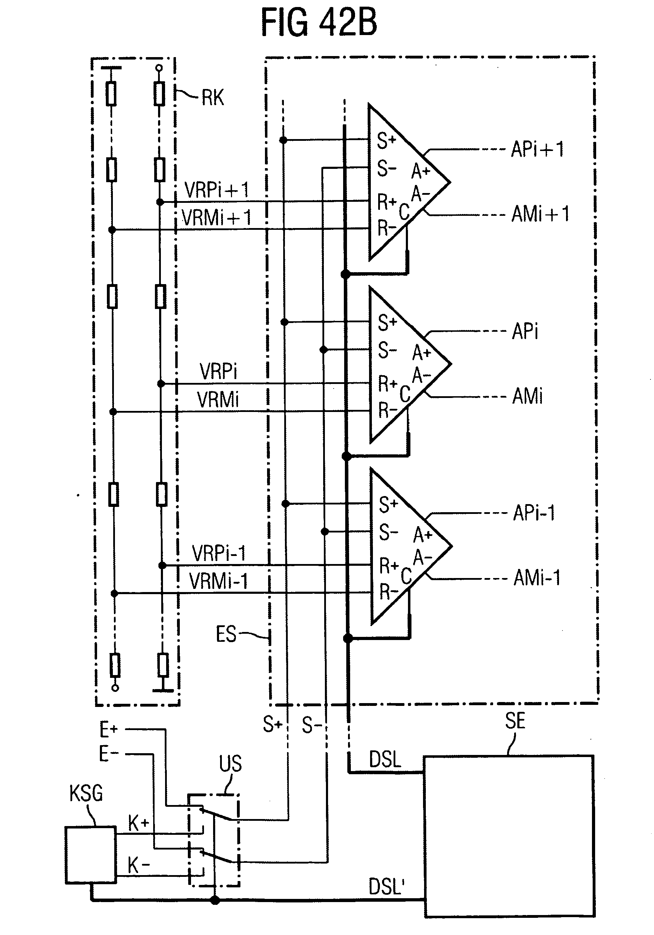

Figur 42b zeigt eine voll differentielle Ausführung mit Eingangssignalen E+, E- und Kalibrationssignalen K+, K-, die den Eingängen S+, S- der Differenzverstärker über das Mittel US wahlweise zugeführt werden können. Die Signale E+, K+ entsprechen den Signalen E und K aus Figur 42a, und der Eingang S+ entspricht dem Eingang S. Die Signale E-, K- sind jeweils das komplementäre Signal zu E+, K+, d.h. wenn E+ steigt, sinkt E-, und umgekehrt. Die Summe der differentiellen Signale E+, E- und K+, K- wird in der Praxis vorzugsweise auf einen konstanten Wert gehalten. Sinn und Zweck des volldifferentiellen Aufbaus ist die bessere Unterdrückung von Gleichtaktstörsignalen.

In den Figuren 42a, 42b sind mindestens die Differenzverstärker der Eingangsstufe ES des ADC mit einer Vorrichtung zur Offsetkalibration ausgestattet, und zur Steuerung dieser Vorrichtung über Daten- und Steuerleitungen DSL mit einer das Kalibrationsverfahren durchführenden Steuereinheit SE verbunden. Als Vorrichtungen und Verfahren zur Offsetkompensation der Differenzverstärker können die unter Bezugnahme auf die Figuren 1 bis 40, aber auch beliebige andere Kalibrationsvorrichtungen und Kalibrationsverfahren für die Offsetkompensation von Differenzverstärkern eingesetzt werden. Für die vorgeschlagene Kalibration der Referenzspannungsteilerkette ist lediglich relevant, daß die Steuereinheit SE die Offsetspannungen der Differenzverstärker individuell stellen kann und über eine Auswertung der Ausgangssignale der Differenzverstärker prüfen kann, ob an diesen ein Gleichgewichtszustand vorliegt oder nicht. Außerdem muß die Steuereinheit auch die Erzeugung des Kalibrationssignals im Block KSG und das Mittel US steuern können, wozu KSG und US ebenfalls über Daten- und Steuerleitungen DSL' mit der Steuereinheit SE verbunden sind. Die Steuereinheit SE steuert die Kalibration der Differenzverstärker und der Referenzspannungsteilerkette.

Die Figuren 42a und 42b stellen die allgemeinste Ausführungsform der Erfindung dar, insbesondere werden keine expliziten Annahmen darüber gemacht, wo sich etwaige Treiberstufen oder Sample-und-Hold-Stufen oder Track-und-Hold-Stufen befinden, die gemäß dem Stand der Technik bei der praktischen Realisierung eines ADC benötigt werden. Etwaig benötigte Treiberstufen könnten Bestandteil des Mittels US sein, oder wenn die Eingangskapazität der Differenzverstärker niedrig ist, auch vor diesem angeordnet werden, bzw. entfallen, und die Sample-und-Hold bzw. Track-und-Hold Funktion könnte wie in [16] als sogenannter "Distributed Sample and Hold" nach der Eingangsstufe ES innerhalb des ADC angeordnet sein oder bei geringen Signalbandbreiten sogar entfallen.

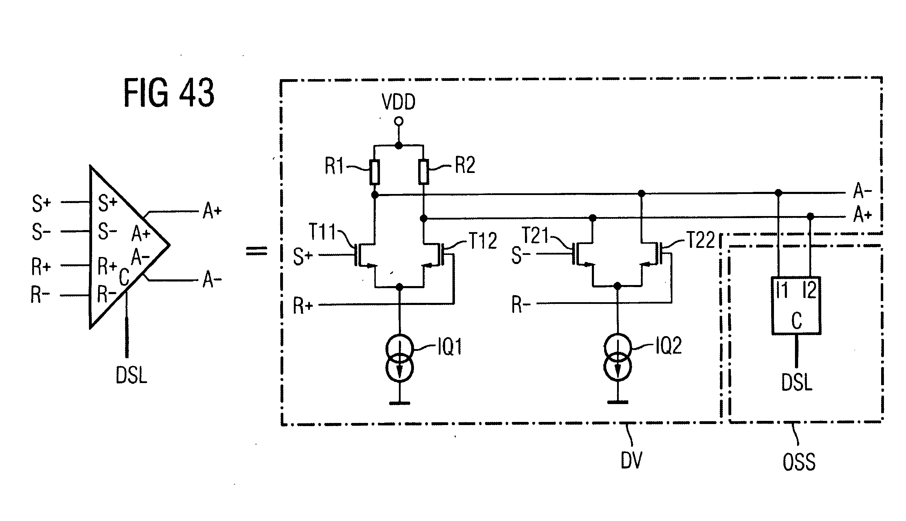

Figur 43 zeigt eine Möglichkeit der Realisierung eines der in der Figur 42b gezeigten Differenzverstärker der Eingangsstufe ES für voll differentielle Eingangssignale (Kasten DV) und ein daran angeschlossenes Mittel zur Stellung der Offsetspannung des Differenzverstärkers (Kasten OSS).

Die Differenzverstärker weisen gegenüber einer nicht voll differentiellen Implementierung eine verdoppelte Anzahl von Differentialpaaren auf:

Ein erstes Differentialpaar aus Transistoren T11, T12 mit einem Signaleingang S+ und einem Referenzeingang R+ ist mit seinen Drainanschlüssen an Lastwiderstände R1, R2 und den Ausgangsklemmen A+, A- des Differenzverstärkers angeschlossen. Der zweite Anschluß der Lastwiderstände R1, R2 ist mit einer Klemme VDD verbunden, an der eine Versorgungsspannung zugeführt wird.

Ein zweites Differentialpaar aus Transistoren T21, T22 mit einem Signaleingang S- und einem Referenzeingang R- ist gegensinnig an dieselben Lastwiderstände R1, R2 angeschlossen.

Die Sourceanschlüsse der Differentialpaare sind mit Stromquellen IQI, 1Q2 verbunden. Die Eingänge S+ aller Differenzverstärker sind auf einer höheren Schaltungsebene (siehe Figur 42b) untereinander verbunden, ebenso die Eingänge S- und bilden den voll differentiellen Eingang S+, S- der voll differentiellen Eingangsstufe.

Den Referenzeingängen R+, R- wird jeweils ein aus einem oder zwei Referenzspannungsteilerketten RK stammendes voll differentielles Referenzpotential zugeführt. Die Summe zweier auf einen Differenzverstärker fahrenden Referenzpotentiale an R+, R- ist vorzugsweise gleich groß wie die Summe der Potentiale an S+, S- um eine möglichst gute Gleichtaktunterdrückung zu erhalten.

Für die Realisierung der Erfindung ist lediglich relevant, daß das Mittel zur Erzeugung des Kalibrationssignals KSG ein voll differentielles Kalibrationssignal K+, K- liefern können muß, bei dem die Summe der Potentiale an K+, K- ebenfalls der Summe der Potentiale an den Eingängen S+, S- entspricht, und ferner muß das Kalibrationssignal die Idealwerte eines Paares von Referenzpotentialen R+, R- mit einer hinreichenden Genauigkeit darstellen können.

Die Funktion des Mittels zur Stellung der Offsetspannung im Kasten OSS besteht darin, daß es über zwei Klemmen 11, 12, die an die Ausgangsklemmen A+, A- des Differenzverstärkers angeschlossen sind, jeweils einen einstellbaren Strom herauszieht, und somit die Spannung an den Lastwiderständen verschieben kann. Das Mittel hat Daten- und Steuereingänge, die mit DSL bezeichnet sind, und die auf einer höheren Schaltungsebene (siehe Figur 42) mit der Steuereinheit SE verbunden sind. Vorzugsweise enthält das Mittel ein digitales Speicherregister, mit dem die Stellwerte der Ströme an seinen Klemmen 11, 12 gespeichert werden. Details dieses Mittels sind der Beschreibung der Figuren 24 bis 40 entnehmbar.

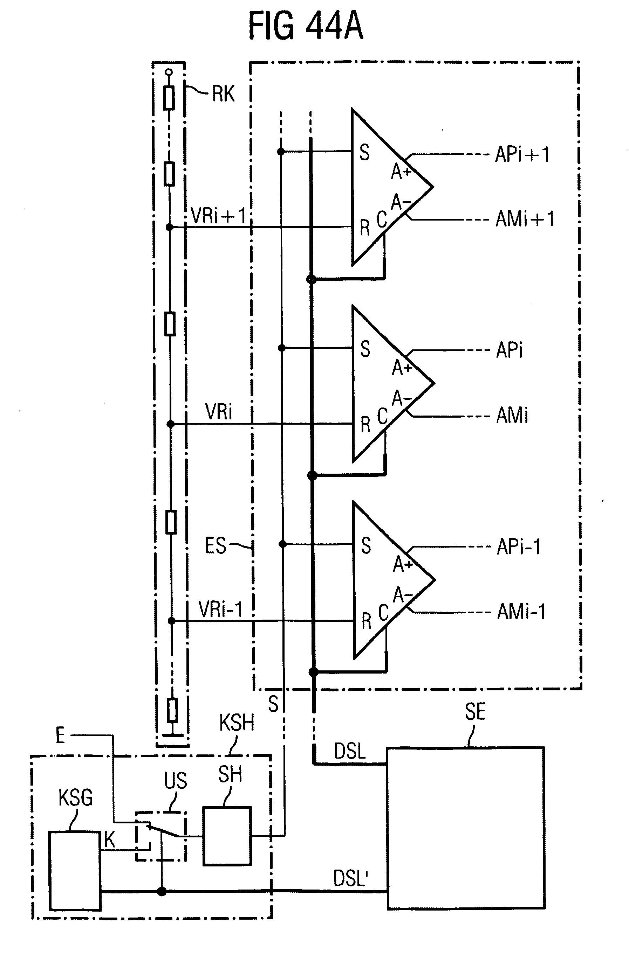

Für eine nicht voll differentielle Ausbildung der Schaltung von Figur 43 genügt es, die Transistoren T21, T22 und die Stromquelle 1Q2 wegzulassen, es ergibt sich dann ein kalibrierbarer Differenzverstärker, der für die Ausbildung der Erfindung gemäß den Figuren 42a und 44a geeignet ist.

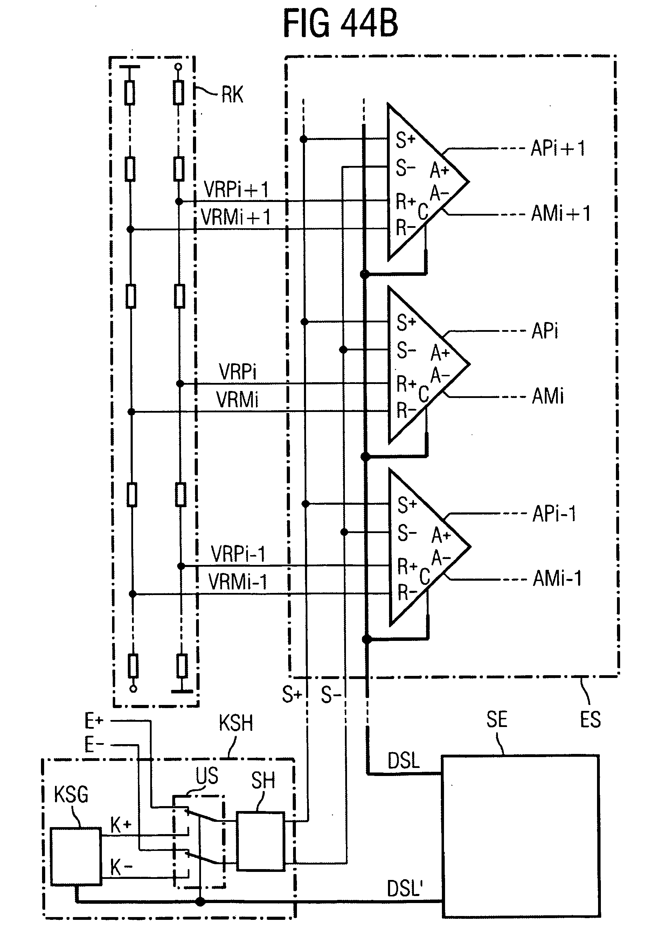

Eine bevorzugte Ausführung der Erfindung ist in den Figuren 44a und 44b dargestellt. Hier ist zwischen dem Umschaltmittel US und den Eingängen S bzw. S+, S- der Differenzverstärker der Eingangsstufe ES eine Sample-und-Hold-Stufe SH angeordnet. Diese kann auch als Track-und-Hold-Stufe ausgeführt sein.

Ein erster Vorteil dieser bevorzugten Ausführung besteht in der Ausnutzung der Treiber der Sample-und-Hold-Stufe auch für die Zuführung des Kalibrationssignals auf die Eingangsstufe des ADC, so daß diese nur einmal vorhanden sein müssen, wodurch sich eine Verringerung der Fläche und des Stromverbrauchs ergibt.

Ein zweiter Vorteil besteht darin, daß nun auch noch geringfügige signalabhängige statische Fehler der Sample-und-Hold-Stufe herauskalibriert werden können, ohne daß das erfindungsgemäße Verfahren irgendwie erweitert werden müßte.

Der Hintergrund ist der, daß solche Fehler der Sample-und-Hold-Stufe das abgetastete Kalibrationssignal K oder K+, K-in gleicher Weise verfälschen wie ein zu quantisierendes Eingangssignal E oder E+, E-. Da nun die Kalibration dieses verfälschte Signal als Idealwert ansieht und einen entsprechenden Korrekturoffset einstellt, bei dem der quantisierte Wert dem Idealwert entspricht, wird ein dem Idealwert entsprechendes Eingangssignal im Normalbetrieb trotz der Verfälschung durch die Sample-und-Hold-Stufe den richtigen, idealen quantisierten Wert am Ausgang des ADC ergeben. Dies ist eine nützliche Eigenschaft der Realisierung der Erfindung nach Figur 44a oder 44b, die ohne jeden Mehraufwand mitgenommen werden kann. Dynamisch bedingte Fehler der Sample-und-Hold-Stufe lassen sich durch diese Anordnung allerdings nicht beseitigen.

Das vorgeschlagene Kalibrations-Verfahren der hier vorliegenden Erfindung besteht knapp dargestellt darin, daß im Kalibrationsmodus für jeden Differenzverstärker in der Eingangsstufe des ADC ein Kalibrationssignal K oder K+, K- erzeugt wird, das den Idealwert des Potentials bzw. der Potentiale an den Referenzeingängen R oder R+, R- des Differenzverstärkers bis auf einen geringen zulässigen Restfehler entspricht, dieses Kalibrationssignal K oder K+, K- anstelle des regulären Eingangssignals E oder E-, E+ auf die Signaleingänge S oder S+, S- der Differenzverstärker gegeben wird und eine Offsetkalibration des Differenzverstärkers durchgeführt wird. Dieser Vorgang wird vorzugsweise für alle Differenzverstärker in der Eingangsstufe des ADC nacheinander durchgeführt, es ist jedoch auch denkbar, statt aller Differenzverstärker nur einen kleineren, tatsächlich benutzten Eingangssignalbereich des ADC zu kalibrieren.

Wie vorstehend bereits erläutert wurde, wird beim Offsetkalibrationsvorgang die Offsetspannung des Differenzverstärkers so verstellt, daß sich an seinen Ausgängen ein im wesentlichen gleiches Potential einstellt, d.h. die differentielle Ausgangsspannung wird minimiert und im Idealfall auf Null geführt.

Der Unterschied zwischen einer reinen Offsetkompensation und der Kalibration der Referenzspannungsteilerkette besteht lediglich in der Vorbereitung dieses Offsetkalibrationsschritts:

Im Fall einer reinen Offsetkalibration werden die Eingänge des zu kalibrierenden Differenzverstärkers auf einen gleiches Potential gebracht, indem sie beispielsweise beide gemeinsam auf ein Hilfspotential umgeschaltet oder kurzgeschlossen werden, im Fall der Kalibration der Referenzspannungsteilerkette bleiben die zu dieser führenden Referenzeingänge R oder R+, R- der Differenzverstärker mit dieser verbunden, und es wird am Signaleingang S oder S+, S- das hinreichend genaue Kalibrationssignal zugeführt. In diesem Fall führt der Offsetkalibrationsschritt dann nicht zu einer Minimierung des Offsetfehler des Differenzverstärkers, sondern zu einem gezielten Offsetfehler, der dem Fehler des Referenzpotentials polaritätsmäßig entgegengesetzt ist und betragsmäßig gleich, oder mit hinreichender Genauigkeit gleich ist, und diesen kompensiert. Es wird also ein erster stellbarer Fehler dazu benutzt, einen zweiten, nicht beeinflußbaren Fehler auszugleichen, der innerhalb der Referenzspannungsteilerkette liegt oder in dem ADC vorangeschalteten Stufen, beispielsweise einer Sample-und-Hold-Stufe.

Als Mittel KSG zur Erzeugung eines Kalibrationssignals K oder K+, K- eignet sich ein gewöhnlicher Digital/Analogwandler DAC mit einer wesentlich höheren Auflösung als der ADC, beispielsweise ein 13-Bit-DAC bei einem 10-Bit-ADC. Bei einer in etwa gleichen Spanne des Signals könnte der DAC damit das Kalibrationssignal in Stufen von ca. 0.125 LSB des ADC auflösen, was der damit erreichbaren Genauigkeit der Kalibration der Referenzspannungsteilerkette entspräche.

Dem Stand der Technik ist eine Vielzahl von Möglichkeiten bekannt, hochgenaue, aber langsame DACs zu realisieren, siehe beispielsweise [17]. Da das Kalibrationssignal für einen Kalibrationsschritt erzeugt werden kann, während der ADC regulär betrieben wird, und ein Kalibrationsschritt relativ selten eingeschoben werden muß, da er nach einer ersten Kalibration des ADC nach dem Einschalten nur langsame Drifteffekte auszugleichen hat, vor allem thermischen Drift, ist die langsame Arbeitsweise solcher hochgenauen DACs kein Problem für ihre Nutzung in dieser Erfindung.

Oftmals befinden sich auf einem hochintegrierten Chip ohnehin hochauflösende DACs für verschiedene Aufgaben, z.B. für Audiokanäle, und diese können für einen Kalibrationsvorgang des ADC benutzt werden, so daß kein extra DAC vorgesehen werden muß.

Ein noch einfacheres Mittel zur Erzeugung des Kalibrationssignals ist ein getakteter Integrator mit geschalteten Kondensatoren, mit dem nach dem Rücksetzen durch eine Vielzahl von Integrationsschritten eine linear ansteigende Rampe gleichförmig hoher Schritte erzeugt werden kann. Wird das Kalibrationsverfahren geeignet ausgestattet, ist die absolute Höhe dieser Integrationsschritte unerheblich, solange diese klein genug für eine genügende Auflösung der Kalibration sind. Sogenannte Matchinganforderungen an die Bauelemente des Integrators werden hierdurch wesentlich entschärft.

Viele der bekannten Sample-und-Hold-Stufen sind nun zufälligerweise einem getakteten Integrator sehr ähnlich. Werden diese geringfügig erweitert, kann die Funktionalität der Sample-und-Hold Schaltung, des Mittels zur Erzeugung des Kalibrationssignals, und des Mittels zur Umschaltung zwischen Eingangs- und Kalibrationssignal zu einer Funktionseinheit KSH, kalibrierende Sample-und-Hold-Stufe genannt, zusammengefaßt werden.

Eine solche Funktionseinheit KSH ist in den Figuren 44a, 44b als gestrichelter Block dargestellt und umfaßt die oben genannten Funktionen. Das Innenleben des gestrichelten Blocks in den Figuren 44a, 44b ist dann nur funktionssymbolisch zu verstehen, da die tatsächliche schaltungstechnische Realisierung dann davon abweicht, da die Funktionen in der Realisierung zusammengefaßt sind.

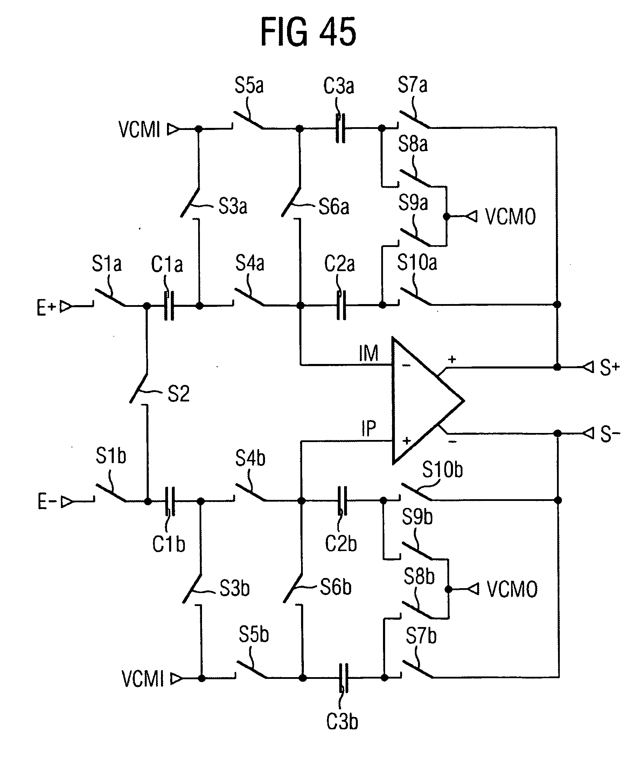

Figur 45 zeigt die schaltungstechnische Realisierung einer bekannten Sample-und-Hold-Stufe; eine ähnlich aufgebaute Sample-und-Hold-Stufe wird auch in [18] verwendet. Der Unterschied zwischen der Schaltung aus Figur 45 und der zitierten Literaturstelle besteht lediglich aus den zusätzlichen Kondensatoren C3a, C3b und den ihnen zugeordneten Schaltern S5a, S5b, S6a, S6b, S7a, S7b, S8a, S8b, um das abgetastete Eingangssignal auch während der nächsten Samplephase bereitstellen zu können. Diese Zusatzteile wären für eine Kalibrationssignalerzeugung an sich nicht notwendig, es handelt sich aber bei der Schaltung nach Figur 45 um die derzeit beste Lösung, und daher wird die folgende Beschreibung auf dieser Lösung aufgebaut.

In der Samplephase sind die an den Kondensatoren C1a, C1b befindlichen Schalter S1a, S1b, S3a, S3b geschlossen und es werden somit die an den Klemmen E+, E- anliegenden Eingangssignale auf diesen Kondensatoren C1a, C1b gespeichert; das Bezugspotential ist hierbei VCMI. C1a und C1b sind noch nicht mit den Feedbackschleifen des Operationsverstärkers OP verbunden, denn es handelt sich um sogenanntes "Open Loop Sampling". Der Operationsverstärker wird über die Kondensatoren C3a, C3b und die geschlossenen Schalter S6a, S6b, S7a, S7b gegengekoppelt. Die Kondensatoren C2a, C2b werden über geschlossene Schalter S9a, S9b mit einem Bezugspotential VCMO verbunden. Die restlichen Schalter, S4a, S4b, S5a, S5b, S8a, S8b, S10a, S10b sind geöffnet.

In der Holdphase werden zuerst die Schalter S3a, S3b, S6a, S6b geöffnet, dann die Schalter S1a, S1b, S7a, S7b, S9a, S9b. Danach werden die Schalter S2, S4a, S4b, S5a, S5b, S8a, S8b, S10a, S10b geschlossen. Die Ladungen auf den Kondensatoren werden hierbei so umverteilt, daß sich an den Ausgängen S+, S- des Operationsverstärkers die von E+, E- abgetastete Eingangsspannungsdifferenz einstellt, jedoch mit einem von VCMI auf VCMO verschobenen Gleichtaktpegel, was eine beabsichtigte Funktion ist. Wenn die Potentiale VCMI und VCMO gleich sind, erfolgt eben keine Verschiebung des Gleichtaktpegels.

Beim Zurückschalten auf die Samplephase werden zuerst S4a, S4b, S5a, S5b geöffnet, dann werden die restlichen Schalter in die bereits oben beschriebenen Stellungen für die Samplephase gebracht. Die Ladungen werden hierdurch wiederum verschoben, und während die nächste Abtastung vorgenommen wird, bleibt das Signal aus der vorangegangenen Abtastung an den Ausgängen S+, S- erhalten. Bei der einfacheren Schaltung gemäß [18] wäre dies nicht der Fall, da bei dieser der Operationsverstärker während der Samplephase nicht gegengekoppelt ist. Bis auf diese weniger günstige Eigenschaft ist die Arbeitsweise der beiden Schaltungen gleich, es wird hier aber Wert darauf gelegt, jeweils die beste Lösung darzustellen, so daß die vorteilhaftere Schaltungsvariante gemäß Figur 45 ausgewählt wurde, um eine vorteilhafte Zusatzmaßnahme beispielhaft darzustellen, die bei dieser Schaltung, ihren Vorgänger nach [18], und bei weiteren dafür geeigneten Schaltungen realisiert werden kann, so daß aus der ursprünglichen Sample-und-Hold-Stufe die oben erwähnte kalibrierende Sample-und-Hold-Stufe KSH entsteht, die in besonders aufwandsparender Weise das Mittel KSG zur Erzeugung des Kalibrationsspannung und das Mittel US zur Umschaltung zwischen dem Normal- und dem Kalibrationsbetrieb enthält und mit der Sample-und-Hold-Funktion vereint.

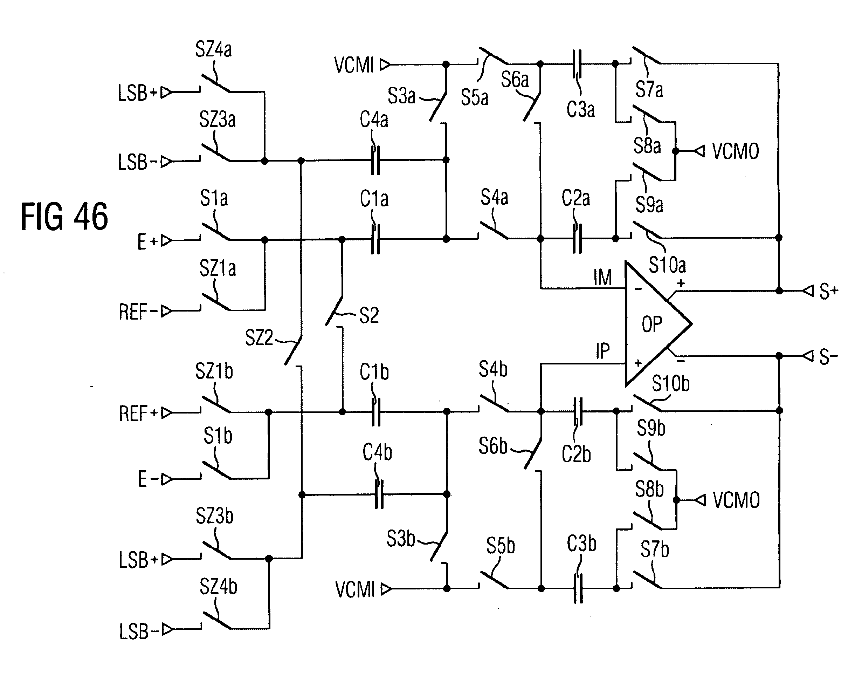

Figur 46 stellt hierzu eine erweiterte Schaltung vor, bei der die Schaltung auf Figur 45 um zusätzliche Schalter SZ1 a, SZ1 b, SZ2, SZ3a, SZ3b, SZ4a, SZ4b sowie um ein Paar von Kondensatoren CZa, CZb ergänzt wurde. Die Kapazität von CZa, CZb ist vorzugsweise kleiner als die der Kondensatoren C1a, C1b. Der Schalter SZ1 a ist mit einer Klemme REF- verbunden und mit dem Kondensator C1a. Der Schalter SZ1b ist mit einer Klemme REF+ verbunden und mit dem Kondensator C1b. Die Schalter SZ2, SZ3a, SZ3b, SZ4a, SZ4b sind mit den Kondensatoren C4a, C4b sinngemäß so verbunden wie die Schalter S1a, S1b, SZ1a, SZ1b, S2 mit den Kondensatoren C1a und C1b verbunden sind. Diese Schaltungsanordnung aus SZ2, SZ3a, SZ3b, SZ4a, SZ4b, C4a, C4b hat sinngemäß die gleiche Topologie wie die Schaltungsanordnung aus S1a, S1b, SZ1a, SZ1b, S2, C1a, C1b und ist parallel zu dieser an den gemeinsamen Knoten der Schalter S3a, S4a und S3b, S4b angeschlossen. Die Schalter SZ3a, SZ3b, SZ4a, SZ4b sind an Klemmen LSB+, LSB- derart angeschlossen, daß -SZ3a, SZ3b die eine Differenzspannung der Potentiale an diesen Klemmen abtasten kann, und SZ4a, SZ4b dieselbe Differenzspannung, aber mit umgekehrten Vorzeichen.

Es ist mit dieser Anordnung nun möglich, einerseits den oben beschriebenen Sample-und-Hold-Betrieb durchzufahren, hierzu werden die Schalter SZ1a, SZ1b, SZ2, SZ3a, SZ3b stets geöffnet gehalten und SZ4a und SZ4b werden stets geschlossen gehalten. SZ3a, SZ3b und SZ4a, SZ4b können auch die Rollen tauschen, d.h. SZ3a, SZ3b bleiben geschlossen und SZ4a, SZ4b geöffnet.

Andererseits sind durch die zusätzlichen Schalter und Kondensatoren folgende drei zusätzlichen Funktionen möglich geworden:
a) Rücksetzen des Kalibrationssignals
b) Schrittweise Aufwärtsintegration, d.h. Erhöhung des Kalibrationssignals um einen Schritt
c) Schrittweise Abwärtsintegration, d.h. Erniedrigung des Kalibrationssignals um einen Schritt

Es wird im folgenden angenommen, daß beispielsweise die Klemme REF- mit der niedrigsten an einem Referenzeingang R oder R+, R- eines Differenzverstärkers vorkommenden Potential verbunden ist, die Klemme REF+ mit dem höchsten derartigen Potential, die Klemmen LSB- mit einem Potential, das geringfügig kleiner ist als der arithmetische Mittelwert von REF- und REF+, die Klemmen LSB+ mit einem Potential, das geringfügig größer ist als der arithmetische Mittelwert von REF- und REF+. Alle die hier notwendigen Potentiale lassen sich vorzugsweise direkt aus Anzapfungen der Referenzspannungsteilerkette entnehmen, falls notwendig unter Zwischenschaltung von Treiberstufen, oder aus anderen geeigneten Spannungsquellen.

Im Fall a), d.h. beim Rücksetzen des Kalibrationssignals (im Rücksetzmodus) entspricht die Arbeitsweise der Schaltung im wesentlichen dem oben beschriebenen Sample-und-Holdvorgang, mit dem Unterschied, daß beim Rücksetzen des Kalibrationssignals die Schalter SZ1a, SZ1b statt der Schalter S1a, S1b geöffnet und geschlossen werden, und die Schalter S1a und S1b geöffnet bleiben. Dadurch wird statt der Differenzspannung an den Klemmen E+, E- die Differenzspannung an den Klemmen REF-, REF+ abgetastet und an den Ausgängen S+, S- bereitgestellt.

Beim Übergang aus dem Rücksetzmodus in einen der beiden Integrationsmodi werden zunächst die Schalter S4a, S4b geöffnet, bevor weitere Umstellungen an Schaltern erfolgen. In den Integrationsmodi bleiben die Schalter S10a, S10b noch von der Rücksetzphase her stets geschlossen und somit bleibt der Operationsverstärker OP stets über die Kondensatoren C2a, C2b gegengekoppelt. In den Integrationsmodi bleiben ferner die Schalter S6a, S6b, S9a, S9b stets offen, so daß die Kondensatoren C3a, C3b nicht an Ladungsumverteilungen teilnehmen. Hierdurch ist auch die Stellung der Schalter S5a, S5b, S7a, S7b, S8a, S8b während der Integrationsmodi im Grunde egal, solange die Knoten S+ und S- nicht gegen CVMO kurzgeschlossen werden, indem Schalter S7a, S7b, S8a, S8b eingeschaltet werden. Es empfiehlt sich, diesen verbotenen Schalterstand zu vermeiden, und insbesondere ist es günstig, S7a und S7b offen zu halten, um die Ausgänge des Operationsverstärkers nicht unnötig zu belasten.

Beim Übergang aus dem Rücksetzmodus in einen der beiden Integrationsmodi wird ferner nach dem Öffnen der Schalter S4a, S4b der Schalter S2 geöffnet und dann werden die Schalter SZ1a und SZ1b geschlossen. Hierdurch werden die eingangsseitigen Knoten der Kondensatoren C1a, C1b mit vorzugsweise aus niederohmigen Quellen stammenden Potentialen an den Klemmen REF-, REF+ verbunden, von denen angenommen wird, daß diese im Abtastzeitpunkt der Integration immer gleich bleiben. Ein Vorteil dieser Schalterstellung besteht darin, daß unerwünschte kapazitive Einkopplungen von Signalen an den Klemmen E+, E- über unvermeidliche parasitäre Kapazitäten der während der Integrationsmodi offenbleibenden Schalter S1a, S1b stark gedämpft werden.

Während der beiden Integrationsmodi werden lediglich die Schalter SZ3a, SZ3b, SZ4a, SZ4b, S3a, S3b, S4a, S4b bewegt.

Im Fall b), d.h. bei der schrittweisen Aufwärtsintegration (Aufintegrationsmodus) werden in einer ersten Phase die Schalter SZ4a, SZ4b, S3a, S3b geschlossen und somit wird das Potential an der Klemme LSB+ an die erste Platte des Kondensators C4a übertragen und das Potential an der Klemme LSB- an die erste Platte des Kondensators C4b. Die zweiten Platten der Kondensatoren C4a, C4b sind dabei über die Schalter S3a, S3b mit dem Bezugspotential VCMI verbunden. Schalter SZ3a, SZ3b bleiben geöffnet. In einer zweiten Phase werden zunächst die Schalter S3a, S3b geöffnet, und dann die Schalter S4a, S4b geschlossen. Dann werden die Schalter SZ4a, SZ4b geöffnet und der Schalter SZ2 geschlossen. Es erfolgt ein Ladungstransfer auf die Eingangsknoten IM, IP des Operationsverstärkers, und entsprechend steigt das Potential an dem Ausgangsknoten S+ um einen kleinen Schritt an, und sinkt das Potential an dem Ausgangsknoten S- um einen kleinen Schritt ab, wenn die Kondensatorverhältnisse zwischen C4a, C2a und C4b, C2b entsprechend klein sind, und auch die Spannungsdifferenz an LSB+, LSB- zweckmäßig gewählt wurde, beispielsweise genauso hoch wie eine Quantisierungsstufe des ADC, wobei dann das genannte Kondensatorverhältnis für eine weitere Unterteilung zuständig ist, die für den Kalibrationsmodus erwünscht ist, um das Kalibrationssignal hinreichend fein auflösen zu können. In der Praxis sollte die Stufenhöhe für gute Ergebnisse vorzugsweise ein Achtel der Quantisierungsstufe des ADC betragen. Eine Stufenhöhe in Höhe eines halben Quantisierungsschrittes ist als theoretisches Minimum anzusehen, unter dem die Kalibration nur noch wenig Sinn machen würde.

Beim Übergang zum nächsten Integrationsschritt werden die Schalter S4a, S4b zuerst geöffnet, dann der Schalter SZ2, und dann beginnt der Zyklus von vorne.

Im Fall c), d.h. bei der schrittweisen Abwärtsintegration (Abintegrationsmodus) werden in einer ersten Phase die Schalter SZ3a, SZ3b, S3a, S3b geschlossen und somit wird das Potential an der Klemme LSB- an die erste Platte des Kondensators C4a übertragen und das Potential an der Klemme LSB+ an die erste Platte des Kondensators C4b. Die zweiten Platten der Kondensatoren C4a, C4b sind dabei über die Schalter S3a, S3b mit dem Bezugspotential VCMI verbunden. Schalter SZ4a, SZ4b bleiben geöffnet. In einer zweiten Phase werden zunächst die Schalter S3a, S3b geöffnet, und dann die Schalter S4a, S4b geschlossen. Dann werden die Schalter SZ3a, SZ3b geöffnet und der Schalter SZ2 geschlossen. Es erfolgt ein Ladungstransfer auf die Eingangsknoten IM, IP des Operationsverstärkers, und entsprechend sinkt das Potential an dem Ausgangsknoten S+ um einen kleinen Schritt ab, und steigt das Potential an dem Ausgangsknoten S- um einen kleinen Schritt an.
Beim Übergang zum nächsten Integrationsschritt werden die Schalter S4a, S4b zuerst geöffnet, dann der Schalter SZ2, und dann beginnt der Zyklus von vorne.

Vermöge dieser Zusatzfunktionen, deren Realisierungsaufwand sehr gering ist, vor allem da die Kondensatoren C4a, C4b viel kleiner sind als die Kondensatoren der ursprünglichen Schaltung gemäß Figur 45, läßt sich eine Funktionseinheit schaffen, die in besonders aufwandssparender Weise das Mittel KSG zur Erzeugung des Kalibrationssignals und das Mittel US zur Umschaltung zwischen dem Normal- und dem Kalibrationsbetrieb enthält und mit der Sample-und-Hold-Funktion vereint.

Es sei betont, daß die beschriebene neuartige kalibrierende Sample-und-Hold-Stufe, nur ein mögliches Realisierungsbeispiel ist, da die bekannten Topologien von Sample-und-Hold-Schaltungen sehr variantenreich sind und nicht immer der Topologie von Figur 45 entsprechen. Ein Fachmann, der eine Sample-und-Hold-Schaltung realisieren kann, dürfte jedoch aufgrund des beschriebenen Ausführungsbeispiels in der Lage sein, seine Sample-und-Hold-Schaltung so zu erweitern, daß daraus eine kalibrierende Sample-und-Hold-Stufe entsteht.

Der Mehraufwand für die Realisierung der Referenzspannungsteilerketten-Kalibrierung ist bei dieser Variante sehr gering und fällt praktisch nicht ins Gewicht, wenn man davon ausgeht, daß der ADC bereits über die Mittel und das Verfahren zur Kalibration der Offsetspannungen der Differenzverstärker der Eingangsstufe verfügt. Der Nachteil dieser Variante ist jedoch, daß während des Aufbaus des Kalibrationssignals kein Normalbetrieb des ADC erfolgen kann, da die hierfür benötigte Sample-und-Hold-Funktion umgewidmet wurde. Wo dies nicht akzeptabel ist, kann die Erfindung nach Figur 42a, 42b mit einem separaten DAC realisiert werden.

Eine als Unteranspruch beanspruchte erfinderische kalibrierende Sample-und-Hold-Stufe KSH, die in besonders aufwandssparender Weise das Mittel KSG zur Erzeugung des Kalibrationsspannung und das Mittel US enthält und mit der Sample-und-Hold-Funktion vereint, ist gekennzeichnet durch eine (Sample-und-Hold-)Schaltung,
- deren gewöhnliche Funktion es ist, ein an ihren Eingangsklemmen anliegendes Eingangssignal abzutasten und nach der Abtastung an ihren Ausgangsklemmen ein Bild des Eingangssignals im Abtastzeitpunkt bereitzustellen, das durch Multiplikation mit einem Faktor und einer Addition oder Subtraktion eines konstanten Betrags aus dem Eingangssignal abgeleitet ist, wobei der Faktor auch gleich eins und der konstante Betrag auch gleich null sein kann,
- die mit schaltungstechnischen Mitteln ausgestattet ist, um neben der Abtastung des Eingangssignals als eine erste kennzeichnende weitere Funktion eine Rücksetzung auf eine definierte Ausgangsspannung erlauben, und
- die mit schaltungstechnischen Mitteln ausgestattet ist, um neben der Abtastung des Eingangssignals als eine zweite kennzeichnende weitere Funktion auch eine schrittweise Aufwärts- oder Abwärtsrampe zu erzeugen, deren Schritthöhe im wesentlichen konstant ist und betragsmäßig so gering, daß für einen Codewechsel des ADC mehr als zwei Schritte der Rampe erforderlich sind.

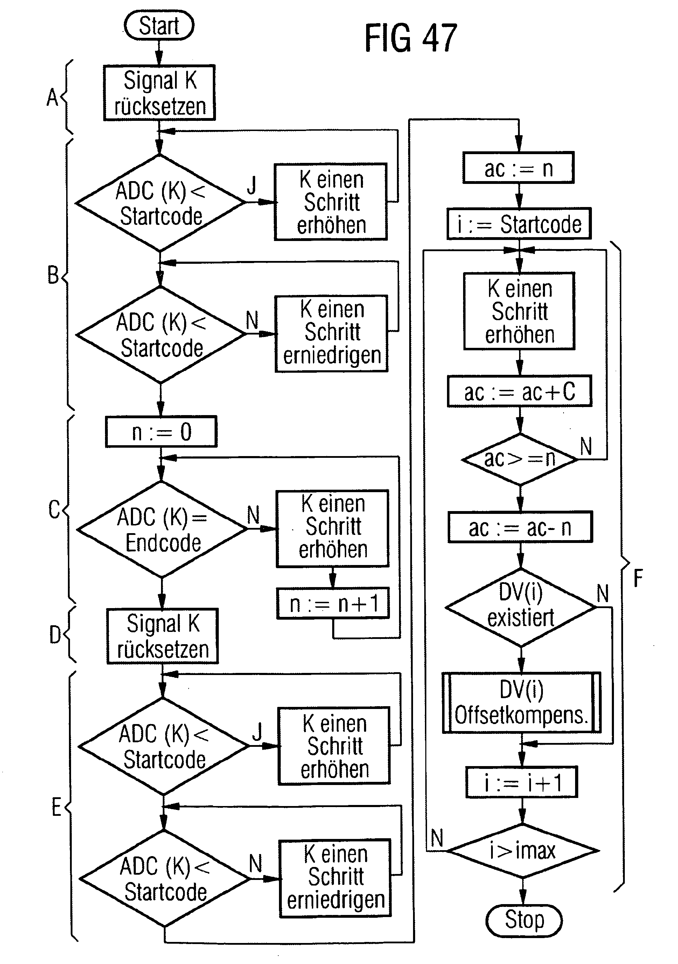

Das Steuerungsverfahren für eine kalibrierende Sample-und-Hold-Stufe KSH nach Figur 46 ist in Figur 47 als Flußdiagramm dargestellt. Prinzipiell ist dieses Steuerungsverfahren für alle denkbaren Kalibrationssignalquellen geeignet, die auf einem schrittweisen Integrationsprozeß basieren.

Insbesondere werden hierbei als praxisgerechte zulässige Mängel angenommen, daß weder der Nullpunkt nach dem Rücksetzen noch die Schritthöhe der einzelnen Auf- und Abintegrationsschritte bekannt sind. Das Steuerungsverfahren ist so ausgebildet, daß diese Mängel keinen schädlichen Einfluß auf die Genauigkeit der Kalibration haben.

Handelt es sich um eine kalibrierende Sample-und-Hold-Stufe mit hinreichend guten Eigenschaften, so daß diese angenommenen Mängel nicht zutreffen, kann das im folgenden offenbarte Verfahren vereinfacht werden, beispielsweise können bei einem hinreichend exakten Rücksetzvorgang des Kalibrationssignals auf den Startwert die Phasen B und E entfallen.

Das Steuerungsverfahren benötigt als zusätzliche Mittel ein Akkumulatorregister ac, ein Zählregister n, ein Indexregister i und ein Rechenwerk, welches feststellen kann, ob der Inhalt des Akkumulatorregisters ac größer oder gleich dem Inhalt des Zählregisters n ist, und welches vom Inhalt des Akkumulatorregisters den Inhalt des Zählregisters n subtrahieren kann. Die Vergleichs- und Subtraktionsfunktion kann zweckmäßig zusammengefaßt werden und der Unterschied besteht nur darin, ob das Ergebnis der Subtraktion in das Akkumulatorregister zurückgespeichert wird oder nicht. Das Rechenwerk muß es ferner ermöglichen, eine Konstante C, die fest verdrahtet sein kann, auf das Akkumulatorregister zu addieren und die Summe dort wieder abzulegen. Das Zählerregister n und das Indexregister i muß jeweils rücksetzbar und um eins erhöhbar, d.h. inkrementierbar sein.

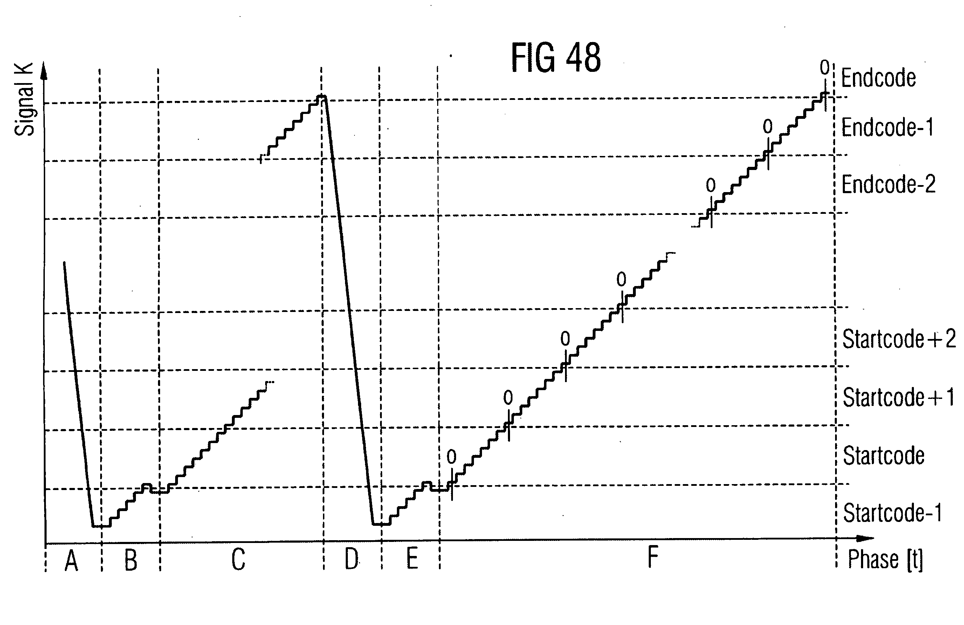

Das Steuerungsverfahren arbeitet wie nachfolgend unter Bezugnahme auf ein in Figur 47 gezeigtes Flußdiagramm und ein in Figur 48 gezeigtes Signaldiagramm erläutert wird.

Zunächst wird der Integrator und damit das Kalibrationssignal K rückgesetzt (Phase A). Falls der Rücksetzvorgang nicht exakt auf dem Codewechsel des ADC zwischen Startcode und Startcode - 1 zu liegen kommt, was in der Praxis in der Regel der Fall ist, wird in einer optionalen Phase B das Kalibrationssignal so lange schrittweise ab- bzw. aufintegriert, bis der ADC vom Startcode in den Startcode - 1 wechselt, wodurch der Anfangspunkt der Kalibration festgelegt wird.

Das Ergebnis der Umsetzung des Kalibrationssignals K durch den ADC ist im Flußdiagramm mit ADC(K) symbolisiert.

Als Startcode eignet sich der Code 0, d.h. das geringste Quantisierungsergebnis des ADC nur dann, wenn dieser über ein Underflowsignal verfügt, das den Startcode - 1 repräsentieren kann. Ist das nicht der Fall, wird als Startcode der Code 1 genommen. Prinzipiell eignet sich das Steuerungsverfahren aber für jeden Startcode, zumal es einige Anwendungen erlauben, nur einen Teil des Eingangsspannungsbereichs des ADC zu kalibrieren, während die Ränder dieses Bereichs ungenau sein dürfen, sogenannte Guardbands, in denen normalerweise kein Signal liegt, und ein Signal, welches diese berührt, würde zu einer automatischen Verstärkungsregelung führen, die das Signal außerhalb der Guardbands hält. Wegen solcher Anwendungen wurde das Steuerungsverfahren für beliebige Start- und Endcodes ausgelegt.

Nach Erreichen des Anfangspunkts der Kalibration durch die Phasen A und B wird das Zählerregister n rückgesetzt und dann wird in einer Phase C das Kalibrationssignal schrittweise erhöht, d.h. aufintegriert und der ADC betrieben, bis dieser den Endcode ausgibt. Die Zahl der hierzu erforderlichen Integrationsschritte wird durch Inkrementieren des Zählerregisters n gezählt. Der Codewechsel in den Endcode legt hier den Endpunkt der Kalibration fest. Bei einem ADC, der über ein Overflowsignal verfügt, kann dieses der Endcode sein. Ansonsten empfiehlt sich der höchste Ausgangscode des ADC, bei einem M-Bit-ADC ist dies der Code 2^{M} - 1. Das Steuerungsverfahren ist aber prinzipiell für jeden Endcode geeignet, solange dieser über dem Startcode liegt.

Bei einem mathematisch exakten Verfahren müßte vor der Phase D nun der Inhalt des Zählerregisters n um eins vermindert werden, aber bei hinreichend großen n, was in der Regel der Fall ist, da n vorzugsweise wesentlich größer ist als die Zahl der Quantisierungsschritte des ADC, kann diese Dekrementierung entfallen, sie ist daher im Flußdiagramm ebenfalls nicht vorhanden.

In einer Phase D wird nun das Kalibrationssignal K und damit der Integrator erneut rückgesetzt und in einer optionalen Phase E, die der Phase B funktional entspricht, wird wieder der Startcode angefahren. Das Indexregister wird auf den Startcode gesetzt. Das Akkumulatorregister ac wird auf den Wert des Zählerregisters n initialisiert.

In einer Phase F erfolgt nun für jeden Index i, der den ideal quantisierten Code des ADC repräsentiert, eine Erzeugung eines Kalibrationssignals durch eine hinreichende Zahl von Aufwärtsintegrationsschritten. Das Kalibrationssignal entspricht hierbei - so weit wie die Integrationsschrittweite erlaubt - dem idealen Umschaltpunkt des jeweiligen Vorverstärkers, d.h. dessen Gleichgewichtszustand an seinen Ausgängen. Das vorstehend (Figuren 1 bis 40) beschriebene Offsetkompensationsverfahren stellt diesen Gleichgewichtszustand ein und kompensiert somit in diesem Falle nicht nur den Offsetfehler des Vorverstärkers, sondern auch den Fehler der Referenzspannungsteilerketten-Anzapfung.

Festgestellt wird das Erreichen eines Werts des Kalibrationssignals, der einer idealen Quantisierungsstufe möglichst nahekommt, durch Addition einer Konstante C zu dem Akkumulationsregister ac. Gekoppelt daran erfolgt ein Aufwärtsintegrationsschritt, d.h. die Erhöhung des Kalibrationssignals um eine Stufe. Erst nach diesen beiden Schritten, deren zeitliche Folge egal ist, wird verglichen, ob der Inhalt des Akkumulationsregisters ac größer oder gleich ist als der Inhalt des Zählerregisters n. Es werden dann zwei Fälle unterschieden:
Fall 1, wenn der Vergleich ergibt, daß ac kleiner ist als n, Ausgang "N" des Verzweigungskastens, schreitet das Steuerverfahren sofort mit dem nächsten Erhöhen des Kalibrationssignals um einen Schritt und der Addition der Konstante C fort.
Fall 2, wenn der Vergleich ergibt, daß ac größer oder gleich n ist, unterer Ausgang des Verzweigungskastens, wird der Inhalt des Zählerregisters n von dem Inhalt des Akkumulationsregisters ac abgezogen und das Ergebnis in das Akkumulationsregister zurückgespeichert, und, falls der erreichten Quantisierungsschwelle entsprechend dem Inhalt des Indexregisters i ein offsetkompensierbarer Differenzverstärker zugeordnet ist, wird für diesen das unter Bezugnahme auf die Figuren 1 bis 40 beschriebene Offsetkompensationsverfahren durchgeführt, bei dem seine Ausgänge möglichst nahe an den Gleichgewichtszustand geführt werden. Die reale Quantisierungsschwelle, die durch diesen Differenzverstärker definiert ist, wird dadurch möglichst nahe an die ideale Quantisierungsschwelle kalibriert. Bei vielen ADC, insbesondere wenn diese Interpolationsmethoden benutzen, ist nicht jedem Index i ein Differenzverstärker in der Eingangsstufe zugeordnet, die Durchführung der Offsetkompensation entfällt dann eben für die nicht vorhandenen Differenzverstärker. Um festzustellen, ob für einen Ausgangscode i ein Differenzverstärker DV(i) existiert, enthält das Flußdiagramm einen Verzweigungskasten mit der Bedingung "DV(i) existiert", falls dies nicht zutrifft (Ausgang "N" der Verzweigung) , wird der Kasten mit dem Offsetkompensationsvorgang umgangen. Im Diagramm nach Figur 48 sind die Stellen, an denen ein Offsetkompensationsvorgang erfolgt, mit einem senkrechten Strich und einem darübergestellten O markiert.

Anschließend wird das Indexregister i um eins erhöht, um die nächste Quantisierungsschwelle vorzubereiten. Das Steuerverfahren schreitet mit dem nächsten Zyklus der Schleife in der Phase F fort, und so weiter, bis alle zu kalibrierenden Quantisierungsschwellen kalibriert sind. Die Abbruchbedingung ist erreicht, wenn der Index i größer ist als ein Index imax, der für den letzten zu kalibrierenden Differenzverstärker steht.

Die Konstante C ergibt sich dabei aus der Zahl der Quantisierungsschritte, die in der Phase C unter Inkrementierung des Zählerregisters n durchlaufen werden. Handelt es sich um den Bereich zwischen Underflow und Overflow, ist die Konstante C gleich 2^{M} zu setzen, bei einem 10-Bit-ADC mit M = 10 gilt also K = 1024. Beginnt Phase C dagegen mit dem Übergang zwischen Code 0 und Code 1 und endet mit dem Übergang zwischen Code 2^{M}-2 und Code 2^{M}-1, dann fehlt Code 0 und Code 2^{M}-1 in der Spanne, die das Zählerregister n überstreicht, und die Konstante C ist gleich 2^{M}-2 zu setzen. Für andere Spannen, die durch eine andere Wahl des zu kalibrierenden Codebereichs definiert werden, erfolgt die Belegung von C entsprechend.

Diese Steuerung der kalibrierenden SH-Stufe wird vorzugsweise in Form der erwähnten Register, des Rechenwerks und eines Schaltwerks realisiert, welches die Steuerung der Register, des Rechenwerks, und der Schalter in dem Funktionsblock übernimmt, der das Kalibrationssignal erzeugt, beispielsweise ein Funktionsblock nach Figur 46. Die digitalen Komponenten, Register, Rechenwerk und Steuerwerk können auch innerhalb der umfangreichen Steuereinheit der Differenzverstärker-Kalibrationsvorrichtung realisiert werden, und sind dann ein Teil eines größeren Ganzen.

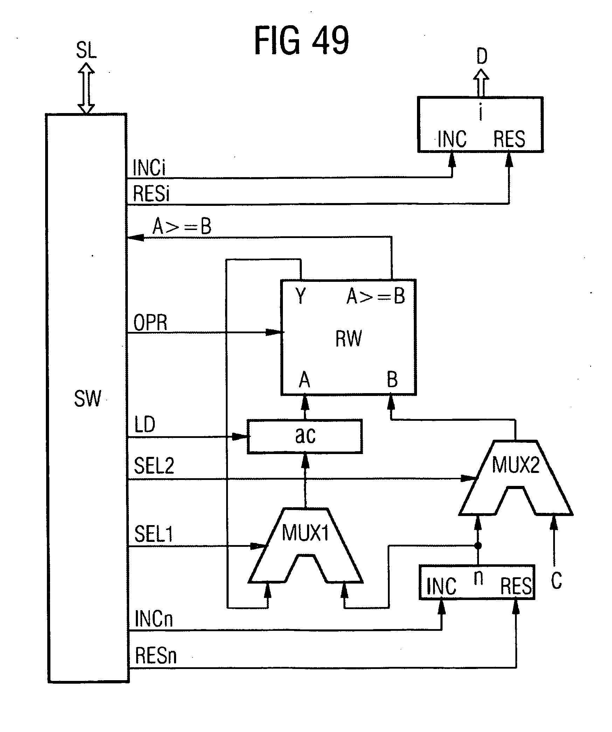

Figur 49 stellt das Blockschaltbild einer beispielhaften Realisierung des Steuerverfahrens dar. Neben den Registern ac, n, und i und der festverdrahteten Konstante C, die nicht mit dem Kalibrationssignal verwechselt werden sollte, befindet sich darin ein Rechenwerk RW, welches eine Subtraktion oder Addition seiner Eingänge A und B durchführen kann, wobei die Operation von einem Signal OPR ausgewählt wird. Bei einer Subtraktion stellt das Rechenwerk auch ein Ausgangssignal A>=B bereit, welches einem Steuerwerk SW zugeführt ist, in dem das Steuerverfahren nach Figur 47 implementiert ist, und welches über Steuerleitungen SL mit den Schaltern in der kalibrierenden Sample-und-Hold-Stufe und einem übergeordneten Steuerwerk, welches das gesamte Kalibrationsverfahren implementiert, in Verbindung steht. Datenleitungen D führen von dem Indexregister i ebenfalls zu dem übergeordneten Steuerwerk, damit dieses entscheiden kann, ob bei Erreichen eines bestimmten Quantisierungsschrittes gemäß Index i ein zu kalibrierender Differenzverstärker in der Eingangsstufe des ADC existiert oder nicht. Ein Ladesignal LD steuert die Übernahme von Daten in das Akkumulatorregister ac, wobei diese über einem Multiplexer MUX1 mittels des Signals SEL1 zwischen dem Ausgang Y des Rechenwerks oder dem Inhalt des Zählerregisters n ausgewählt werden. Ein weiterer Multiplexer MUX2 erlaubt mittels des Signals SEL2 die Auswahl des zweiten Operanden B zwischen dem Inhalt des Zählerregisters n und der Konstanten C. Das Zählerregister n und das Indexregister i sind jeweils mit einem Inkrementeingang INC und einen Rücksetzeingang RES ausgestattet und diese werden vom Steuerwerk SW über die Signale INCN, RESN, INCI, RESI bedient, wobei die Rücksetzung des Indexregisters auf den oben erläuterten Startwert erfolgt. Dieses Beispiel verdeutlicht, daß der Steueraufwand für die Erzeugung des Kalibrationssignals in einem Integrator trotz angenommener Mängel wie unsicheres Rücksetzen auf einen Anfangswert oder unbekannte Schritthöhe der Integration nicht sehr groß sein muß, und daß komplizierte Operationen wie Multiplikation und Division durch das angegebene Steuerverfahren vermieden werden können.

Das Ergebnis des oben beschriebenen Kalibrationsvorgangs ist ein ADC, der trotz Fehlern in der Referenzspannungsteilerkette eine optimal kleine differentielle und integrale Nichtlinearität DNL, INL aufweist. Die Gesamtspanne vom kleinsten bis zum größten Code unterliegt zwar bei diesem Verfahren immer noch dem natürlichen Fehler der Referenzspannungsteilerkette, da das Steuerverfahren der Kalibrationssignalerzeugung nur für eine gleichmäßige Unterteilung der Gesamtspanne sorgt, es verbleibt also ein kleiner Verstärkungsfehler des ADC, und ebenso ein Restoffset, der sich aus der Festlegung des Nullpunkts vor der Phase C ergibt, diese Fehler können aber mit dem Stand der Technik bekannten globalen Kompensationsmethoden beseitigt werden, etwa indem ein Bezugssignal und ein Bezugspegel digitalisiert wird und diese Werte werden im digitalen Signalprozessor nach dem ADC benutzt, um die erwähnten Restfehler herauszurechnen. In der Regel sind solche Zusatzmaßnahmen aber gar nicht erforderlich, da schnelle ADCs der erwähnten Typen hauptsächlich in Kommunikationssystemen verwendet werden, bei welchen die verbleibenden geringen Verstärkungsfehler und der Restoffset keine Rolle spielen, wogegen es sehr wohl auf eine optimale spektrale Leistungsfähigkeit des ADCs ankommt, die die erfindungsgemäße Vorrichtung und das Verfahren durch Optimierung der DNL und INL zu erzielen vermag.

Das soeben beschriebene Steuerungsverfahren für die kalibrierende Sample-und-Hold-Stufe kann auch in der Variante der Erfindung nach den Figuren 44a, 44b benutzt werden, um einen gewöhnlichen Integrator anzusteuern, der sich beispielsweise aus der Schaltung gemäß Figur 46 ergibt, wenn die für den Sample-und-Hold-Modus erforderlichen Schalter und Kondensatoren entfernt werden (S5a, S5b, S6a, S6b, S7a, S7b, S8a, S8b, C3a, C3b). Eine solche Schaltung, in den Figuren 44a, 44b als Block KSG eingesetzt, ist mit geringerem Aufwand zu realisieren als ein hochauflösender DAC nach [17], dafür allerdings auch wesentlich langsamer. Da aber bei einer Schaltungsanordnung nach den Figuren 44a, 44b der jeweils nächste Wert des Kalibrationssignals erzeugt werden kann, während der ADC regulär arbeitet, ist eine langsame Arbeitsweise der Kalibrationssignalquelle meist kein Hindernis. Vorstehend (Figuren 24 bis 40) wurde bereits ein besonders vorteilhaftes Speicherregister für Kalibrationsstellwerte offenbart, mit dem der gesamte ADC unter Einfluß eines einzigen globalen Signals taktweise in den Kalibrationsmodus versetzt werden kann. Bei einer Anordnung nach den Figuren 44a, 44b ist es hiermit möglich, das Kalibrationssignal erst dann dem Sample-und-Hold-Verstärker SH zuzuführen, wenn es eine neue Quantisierungsschwelle erreicht hat, und wenn der nächste Takt des ADC ein Kalibrationstakt ist. Das in diesem Schritt nicht quantisierte reguläre Eingangssignal des ADC kann z.B. durch eine Filteranordnung ersetzt werden, oder es wird, wie vorstehend (Figuren 1 bis 40) beschrieben, der ADC mit der doppelten Taktrate betrieben und jeder zweite Takt ist ein Kalibrationstakt, der auch ungenutzt verstreichen kann, wenn noch kein gültiges Kalibrationssignal vorliegt.

Durch die beschriebene Vorrichtung und das beschriebene Verfahren können Fehler der Referenzspannungsteilerkette von ADCs, und in besonders vorteilhaften Ausbildungen auch Fehler von Sample-und-Hold-Verstärkern des ADCs dadurch wegkalibriert werden, daß die Offsetfehler von Differenzverstärkern der Eingangsstufe des ADC derartig gestellt werden, daß diese die Fehler der Referenzspannungsteilerkette und/oder der Sample-und-Hold-Verstärker kompensieren.

Die Referenzspannung, deren Fehler kompensiert wird, muß nicht aus einer Referenspannungsteilerkette stammen. Durch die beschriebene Vorrichtung und das beschriebene Verfahren können Fehler in auf beliebige Art und Weise erzeugten Referenzspannungen kompensiert werden.

Selbstverständlich können die beschriebene Vorrichtung und das beschriebene Verfahren nicht nur in ADCs, sondern auch in beliebigen anderen Einrichtungen angewendet werden, bei welchen Bedarf besteht, Fehler in einer einem Differenzverstärker zugeführten Referenzspannung zu kompensieren.

Darüber hinaus kann die Kompensation der Referenzspannungs-fehler auch unter Verwendung von Vorrichtungen und Verfahren zur Differenzverstärker-Kalibration erfolgen, die sich von den vorliegend beschriebenen Vorrichtungen und Verfahren unterscheiden, also unter Verwendung beliebiger Vorrichtungen und Verfahren, die zur Differenzverstärker-Kalibration geeignet sind.

Die kompensierbaren Referenzspannungs-Fehler sind auch nicht auf das Referenzspannungspotential beschränkt. Auf die beschriebene Art und Weise können auch andere Fehler, beispielsweise Phasen-Fehler eliminiert werden.

Es folgt nun eine detaillierte Beschreibung zur Kompensierung von Fehlern in einer einer Verstärkerstufe vorgeschalteten Sample-und-Hold-Stufe.

Bei schnellen Analog/Digitalwandlern mit Abtastfrequenzen um einige 100 MHz und darüber ist die Verwendung von sogenannten "open-loop Sample-und-Hold-Stufen" bzw. "open-loop Track-und-Hold-Stufen" üblich, Beispiele hierfür finden sich in [19] und [20]. Solche Schaltungen ermöglichen zwar erst die notwendige hohe Abtastrate, leiden aber an verschiedenen Problemen, die das Signal verfälschen, insbesondere signalabhängiger Ladungsinjektion an den Abtastschaltern. [20] offenbart hierfür zwar eine Lösungmöglichkeit, diese ist aber vor allen in zeitgemäßen 0.12 µm CMOS-Prozessen nicht ausreichend, um eine genügend hohe Linearität zu erhalten, da schon alleine der Sourcefolger innerhalb der Stufe durch Kurzkanaleffekte und einen schlechten Ausgangsleitwert seiner Stromquelle eine erhebliche Nichtlinearität besitzt. In solchen Prozessen sind aufgrund der niedrigen Versorgungsspannung um 1.2 V herum auch closed-loop Sample-und-Hold-Stufen nur sehr schwierig mit hinreichender spektraler Reinheit zu realisieren, da die geringe Versorgungsspannung die Verwendung von Kaskoden weitgehend vereitelt. Es sieht so aus, aus müßten sich schnelle Analog/Digitalwandler, die in solchen modernsten Prozessen hergestellt werden, mit schlechten Eigenschaften der Sample-und-Hold bzw. Track-und-Hold-Stufen begnügen.

Ausgehend von der Beobachtung, daß bei hinreichender Bandbreite von Sample-und-Hold bzw. Track-und-Hold-Schaltung oftmals ein erheblicher Teil ihres Fehlers nicht von dynamischer Natur ist, also nicht frequenzabhängig, sondern statischer Natur ist, d.h. durch eine nichtlineare Gleichspannungskennlinie beschreibbar, wird eine Vorrichtung und ein Verfahren offenbart, wie diese statische Nichtlinearität einer Fehlerkorrektur unterworfen werden kann. Hierbei wird eine Vorrichtung und ein Verfahren zur Offsetkalibration herangezogen, das vorstehend, genauer gesagt insbesondere unter Bezugnahme auf die Figuren 1 bis 40 ausführlich beschrieben wurde.

Interessant ist anzumerken, daß der veröffentlichte Stand der Technik die Grundidee der beschriebenen Vorrichtung und des beschriebenen Verfahrens noch gar nicht erkannt zu haben scheint, nämlich daß ein Offsetkalibrationsverfahren innerhalb der Eingangsstufe von ADCs dazu herangezogen werden kann, eine solche nichtlineare Kennlinie in die Quantisierungsschwellen einzuprogrammieren, daß sowohl eine nichtlineare Kennlinie von dem Quantisierer vorgeschalteten Stufen kompensiert wird, als auch die Offsetspannungen des Quantisierers. Die vorgeschalteten Stufen brauchen hierzu nur in das Offsetkompensationsverfahren mit einbezogen werden. Genau dies wird aber bei [19] und [20] nicht getan, obwohl es möglich gewesen wäre. Statt dessen trennen Nagaraj et al. die offsetkompensierbaren Eingangsstufen ihres Quantisierers während der Autozerophase von dem Sample und Hold ab und können dessen statische Nichtlinearitätskennlinie daher auch nicht kompensieren.

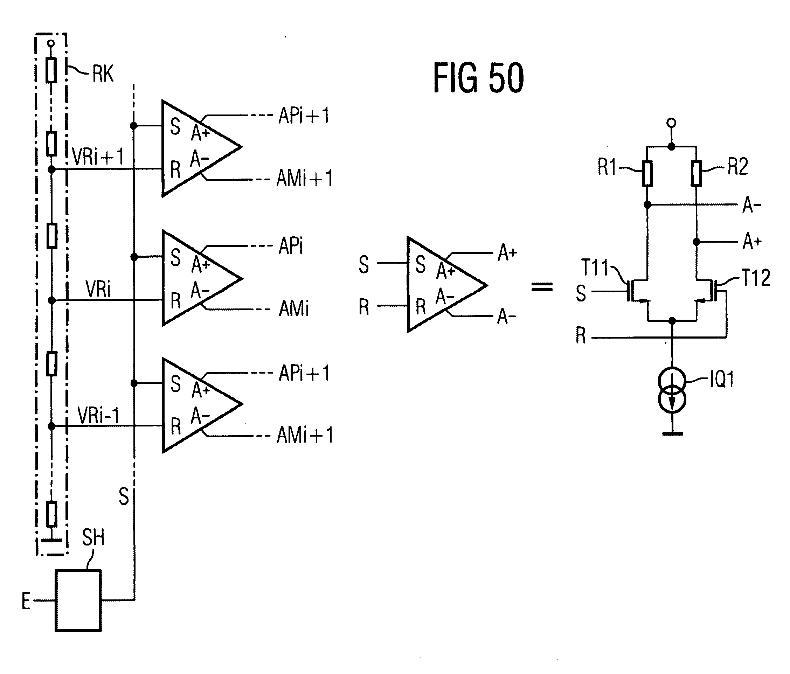

In Figur 50 wird ein Ausschnitt aus einer bekannten Eingangsstufe für schnelle ADCs, beispielsweise für Flash- oder Foldingwandler, dargestellt. Aus einer Referenzspannungsteilerkette RK entspringen Referenzpotentiale VRi-1, VRi, VRi+1, die jeweils auf einen ersten Eingang R eines zugeordneten Differenzverstärkers führen. An jeweils einem zweiten Eingang wird den Differenzverstärkern ein durch eine Sample-und-Hold-Stufe SH abgetastetes Eingangssignal E des ADC zugeführt. Aufgabe der Differenzverstärker ist der Vergleich des abgetasteten Eingangssignals mit dem jeweiligen Referenzpotential. Die Ausgänge der Differenzverstärker APi+l, AMi+1, APi, AMi, APi-1, AMi-1 führen entweder auf Komparatoren (bei einem Flash-ADC) oder auf Faltungsstufen (bei einem Folding-ADC). Im Idealfall sind die Potentiale an den Ausgängen APj, AMj der Differenzverstärkers, dann, wenn die abgetastete Eingangsspannung mit dem jeweiligen Referenzpotential übereinstimmt, gleich groß. Dieser Zustand wird als "Gleichgewicht" des Differenzverstärkers bezeichnet, seine differentielle Ausgangsspannung, die sich aus der Potentialdifferenz APj-AMj ergibt, ist dann Null.

In Figur 50 ist auch die Innenschaltung eines Differenzverstärkers ist in Figur 1 ebenfalls beispielhaft dargestellt. Ein Differentialpaar aus Transistoren T11, T12 mit einem Signaleingang S und einem Referenzeingang R ist mit seinen Drainanschlüssen an Lastwiderstände R1, R2 und den Ausgangsklemmen A+, A- des Differenzverstärkers angeschlossen. Der zweite Anschluß der Lastwiderstände R1, R2 ist mit einer Klemme VDD verbunden, an der eine Versorgungsspannung zugeführt wird. Sind die Lastwiderstände nicht genau gleich, oder haben die Transistoren des Differentialpaars einen Offset, dann ergibt sich ein Offsetfehler des Differenzverstärkers, d.h. sein Gleichgewichtszustand ist um einen kleinen Betrag gegenüber dem Ideal verschoben. Das Referenzpotential oder die Eingangsspannung E müßte nun um diesen Betrag angehoben bzw. abgesenkt werden, um den Gleichgewichtszustand einzustellen.

Vorstehend (Figuren 24 bis 40) wurden bereits Vorrichtungen und Verfahren beschrieben, mit denen die Offsetfehler der Differenzverstärker durch ein Selbstkalibrationsverfahren minimiert werden können. Wird nun die Sample-und-Hold-Stufe in den Offsetkompensationsvorgang mit einbezogen, lassen sich auch statische Nichtlinearitätsfehler dieser Stufe herauskalibrieren. Dies beruht auf der Überlegung, daß ein statischer Nichtlinearitätsfehler sich auf eine systematische Verteilung der Offsetspannungen der Differenzverstärker der Eingangsstufe des ADC abbilden läßt. Werden diese nun während der Offsetkompensation so gestellt, daß dieser systematische Fehler aufgehoben wird, wozu nur geeignete Stellmittel mit hinreichend großen und dabei genügend fein abgestuften Stellbereich erforderlich sind, dann wird durch das Offsetkompensationsverfahren nicht nur der eigentliche Offset der Differenzverstärker beseitigt, sondern auch der statische Nichtlinearitätsfehler der Sample-und-Hold-Stufe.

Die Grundidee der Erfindung wurde bereits in den Figuren 16 und 18 dargestellt, und im Text ausführlich beschrieben. Auch die Fehlerkorrektur einer Sample-und-Hold-Stufe durch Einbeziehen derselben in das Offsetkalibrationsverfahren wurde bereits beschrieben, siehe Figur 23 und die darauf bezugnehmende Beschreibung. Hier wurde jedoch von einer Anordnung der Abtastschalter - und damit der Sample-und-Hold-Stufe - nach den Differenzverstärkern der Eingangsstufe ausgegangen, wie in [16]. Dies stellt aber nur einen Sonderfall dar, denn dieselbe Vorrichtung und dasselbe Verfahren zur Offsetkalibration eignet sich für die Fehlerkorrektur von Sample-und-Hold-Stufen unabhängig von ihrer Lage in der Schaltung des ADC, solange die von einer Referenzspannungsteilerkette über einen Multiplexer abgezapften Referenzpotentiale der Sample-und-Hold-Stufe zugeführt werden.

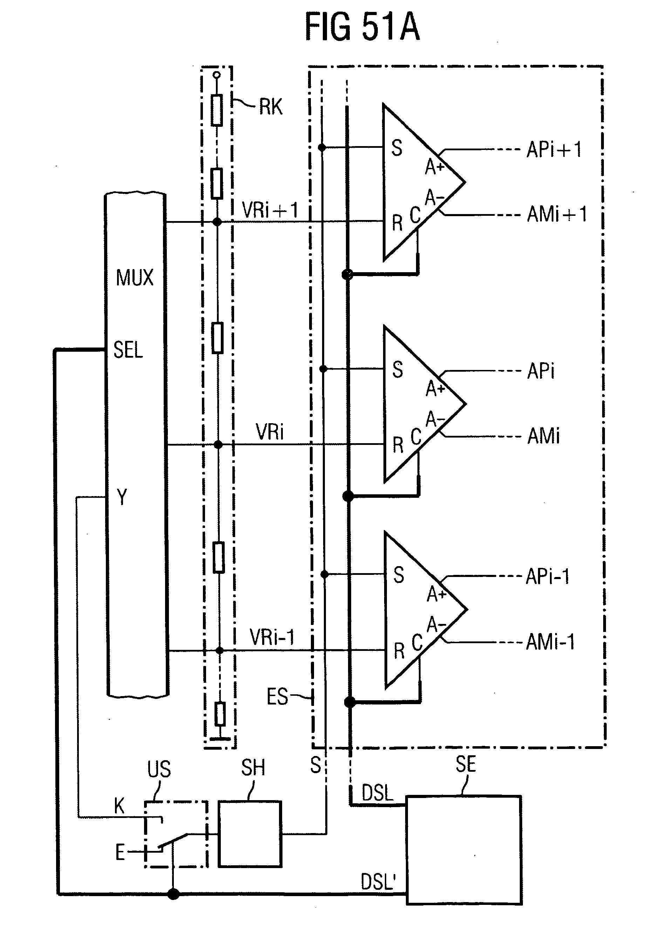

Ein erstes Ausführungsbeispiel einer Vorrichtung zur Kompensierung von Fehlern in der Sample-und-Hold-Stufe ist in Figur 51a dargestellt. Gegenüber von Figur 50 wurde ein Multiplexer MUX hinzugefügt, mit dem eine Steuereinheit SE über Steuer- und Datenleitungen DSL', die auf Steuereingänge SEL des Multiplexers wirken, ein Referenzpotential auswählen und in einem Kalibrationsmodus als Signal K über ein Umschaltmittel US der Sample-und-Hold-Stufe SH zuführen kann. Im Normalbetrieb des ADC, also nicht im Kalibrationsmodus, wird der Sample-und-Hold-Stufe SH das reguläre Eingangssignal E des ADC zugeführt. Das Umschaltmittel kann auch Bestandteil der Sample-und-Hold-Stufe sein. Das Ausgangssignal S der Sample-und-Hold-Stufe führt auf die Signaleingänge der Differenzverstärker in der Eingangsstufe des ADC (Block ES). Die aus der Referenzspannungsteilerkette RS stammenden Referenzpotentiale sind wie gewöhnlich dem jeweiligen Referenzeingang der Differenzverstärker zugeführt. Die Differenzverstärker verfügen über Mittel zur Veränderung der Offsetspannung, wobei diese Mittel von der Steuereinheit SE über Daten- und Steuerleitungen gestellt werden können.

Das Verfahren zur Fehlerkorrektur von Sample-und-Hold-Stufen setzt hierauf auf. Die Steuereinheit wählt in einem Offsetkalibrationsmodus nacheinander die einzelnen Differenzverstärker der Eingangsstufe aus, wählt über den Multiplexer MUX als Kalibrationssignal das dem Differenzverstärker zugeordnete Referenzspannungspotential aus, führt dieses über das Umschaltmittel der Sample-und-Hold-Stufe zu, und führt nach der erfolgten Abtastung den Offsetkalibrationsvorgang für den angewählten Differenzverstärker durch. Das Verfahren schreitet fort, bis alle Differenzverstärker abgearbeitet sind. Das Ergebnis ist ein Quantisierer, bei dem die Offsetspannungen in der Eingangsstufe so gestellt sind, daß sie den statischen Fehlern der Sample-und-Hold-Stufe entgegengesetzt aber betragsmäßig möglichst gleich sind. Die Genauigkeit des Verfahrens ist lediglich durch die Feinheit der Offseteinstellung beschränkt. Es entsteht ein ADC, der trotz statischer Fehler in der Sample-und-Hold-Stufe und trotz statistisch oder systematisch bedingter unvermeidbarer anfänglicher Offsetfehler in den einzelnen Differenzstufen nahezu ideale Quantisierungsstufen aufweist. Der Erfolg des Verfahrens ist im wesentlichen durch die Auflösung des Offsetkalibrationsvorgangs, durch Rauschen und durch die statische Natur des Fehlers der Sample-und-Hold-Stufe bestimmt. Es sei bereits an dieser Stelle darauf hingewiesen, daß zur Offsetkalibration nicht eine der vorstehend beschriebenen Vorrichtungen oder der vorstehend beschriebenen Verfahren verwendet werden müssen. Es können auch beliebige andere Offsetkompensationsmethoden verwendet werden, bei welchen während der Offsetkompensation die Eingänge der Differenzverstärker auf Referenzpotentiale umgeschaltet werden, also beispielsweise unter Verwendung einer Autozeroschleife nach [19] arbeitende Offsetkompensationsmethoden.

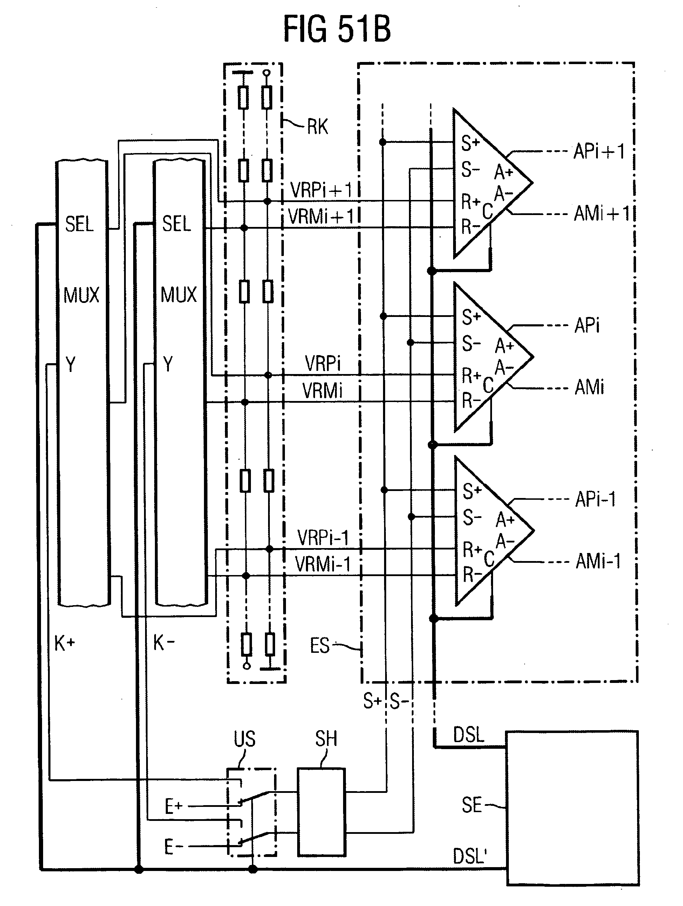

Figur 51b zeigt das in der Figur 51a gezeigte Ausführungsbeispiel für den Fall, daß Differenzverstärker mit differentiellen Eingängen verwendet werden, was wegen der Gleichtaktunterdrückung für viele Anwendungen vorteilhaft ist.

Statt nur eines Referenzpotentials VRj wird hier jedem Differenzverstärker ein Paar von Referenzpotentialen VRPj, VRMj zugeführt. Diese können aus zwei gegenläufigen Referenzspannungsteilerketten stammen, was den Verdrahtungsaufwand in der Praxis oftmals senken kann, oder sie können auch aus ein und derselben Referenzspannungsteilerkette entnommen werden. Wichtig für eine gute Gleichtaktunterdrückung ist, daß der arithmetische Mittelwert eines Paars von Referenzpotentialen VRPj, VRMj dem arithmetischen Mittelwert des differentiellen Eingangssignals S+, S- entspricht. Die selbe Regel gilt für das differentielle Eingangssignal E+, E- des ADC, und die von den beiden Multiplexern stammenden Kalibrationspotentiale K+, K-. Die Arbeitsweise dieser Schaltung und des Kalibrationsverfahrens entspricht dem der Figur 51a.

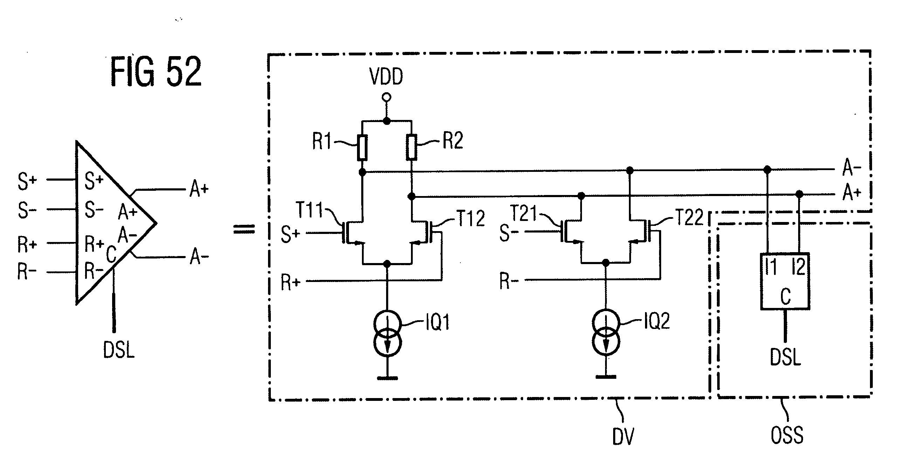

Figur 52 zeigt beispielhaft die Schaltung eines für die Eingangsstufe nach Figur 51b geeigneten Differenzverstärkers mit stellbarer Offsetspannung.

Ein erstes Differentialpaar aus Transistoren T11, T12 mit einem Signaleingang S+ und einem Referenzeingang R+ ist mit seinen Drainanschlüssen an Lastwiderstände R1, R2 und den Ausgangsklemmen A+, A- des Differenzverstärkers angeschlossen. Der zweite Anschluß der Lastwiderstände R1, R2 ist mit einer Klemme VDD verbunden, an der eine Versorgungsspannung zugeführt wird.

Ein zweites Differentialpaar aus Transistoren T21, T22 mit einem Signaleingang S- und einem Referenzeingang R- ist gegensinnig an dieselben Lastwiderstände R1, R2 angeschlossen.

Die Sourceanschlüsse der Differentialpaare sind mit Stromquellen IQ1, IQ2 verbunden. Die Eingänge S+ aller Differenzverstärker sind auf einer höheren Schaltungsebene (siehe Figur 51b), Figur 2b, untereinander verbunden, ebenso die Eingänge S-, und bilden dort den voll differentiellen Eingang S+, S- der voll differentiellen Eingangsstufe.

Den Referenzeingängen R+, R- wird jeweils ein aus einem oder zwei Referenzspannungsteilerketten RK stammendes voll differentielles Referenzpotential zugeführt. Die Summe zweier auf einen Differenzverstärker führenden Referenzpotentiale an R+, R- ist, um eine möglichst gute Gleichtaktunterdrückung zu erhalten, vorzugsweise so groß wie die Summe der Potentiale an S+, S-.

Das Mittel zum Stellen der Offsetspannung befindet sich in einem Block OSS. An seinen zwei Ausgängen I1, I2, die an die Ausgänge des Differenzverstärkers angeschlossen sind, wird je ein über die Daten- und Steuerleitungen DSL einstellbarer Strom aus den Lastwiderständen RI, R2 herausgezogen. Je nachdem, ob an I1 oder I2 mehr Strom herausgezogen wird, kann das Gleichgewicht des Differenzverstärkers in jede Richtung verschoben werden. Die Stromstärke bestimmt dabei das Ausmaß der Verschiebung. Mögliche praktische Realisierungen von Mitteln zum Stellen der Offsetspannung sind vorstehend bereits beschrieben worden, ebenso die weiteren Elemente und Mittel einer Vorrichtung, um ein geeignetes Offsetkompensationsverfahren in einem ADC mit geringem Aufwand zu realisieren.

Werden in Fig. 52 die Transistoren T21, T22 und die Stromquelle IQ2 gestrichen, und wird Eingang S+ mit S und Eingang R+ mit R bezeichnet, ergibt sich die für eine Ausführung nach Figur 51a geeignete Variante des Differenzverstärkers mit stellbarer Offsetspannung.

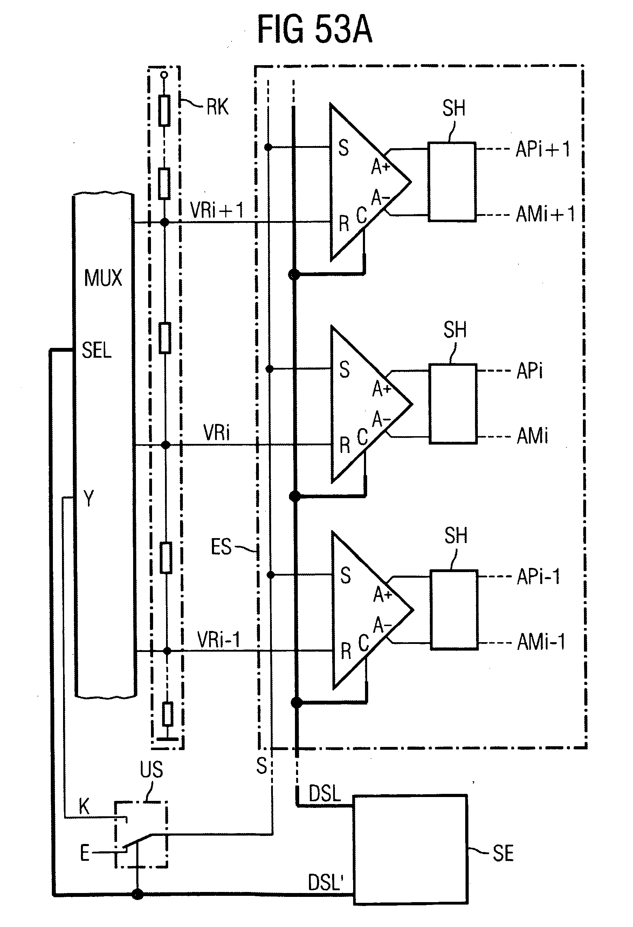

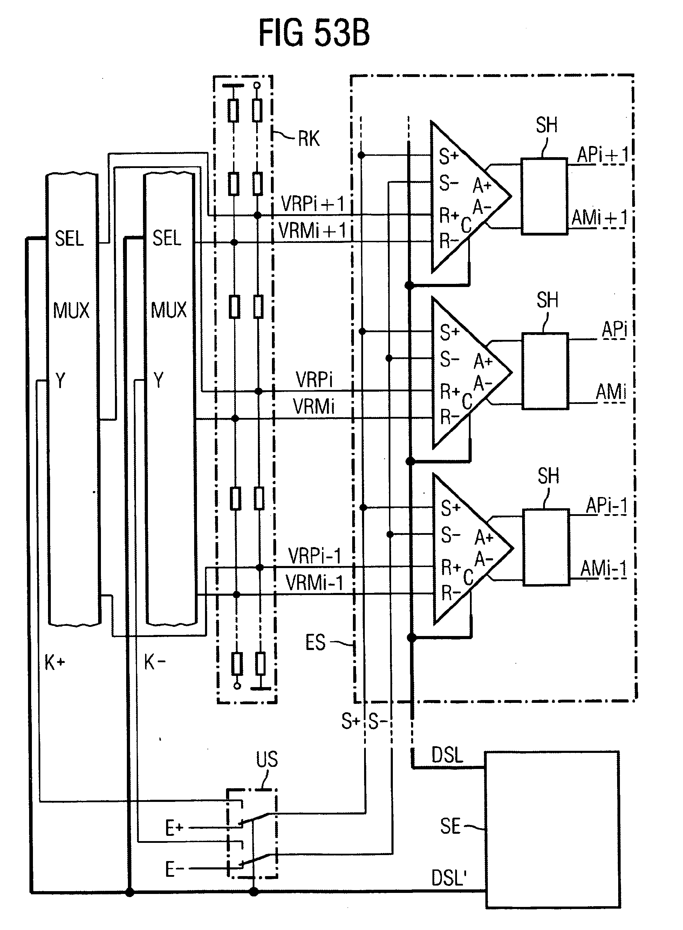

Figur 53a zeigt ein Ausführungsbeispiel, bei welchem sich die Sample-und-Hold-Stufe nicht vor den Differenzverstärkern der Eingangsstufe des ADC befindet, sondern wie in [16] hinter diesen. In diesem Fall ist der Ausgang des Umschaltmittels US direkt mit dem Eingangssignal S der Eingangsstufe ES verbunden. An dem oben beschriebenen Verfahren zur Fehlerkorrektur ändert sich aber nichts. Es ist allerdings zu bemerken, daß die Bandbreite der Differenzverstärker in diesem Fall - je nach geforderter Auflösung des ADC - erheblich größer sein muß als im Falle einer Ausführung nach Fig. 51a, da ansonsten dynamische (frequenzabhängige) Fehler dominieren, die die beschriebene Vorrichtung und das beschriebene Verfahren nicht kompensieren kann. Das in der Figur 53 gezeigte Ausführungsbeispiel entspricht der Ausführung eines ADC nach Fig. 16 und Fig. 23 und ist lediglich etwas übersichtlicher gezeichnet und beschriftet.

Figur 53b zeigt die zweite Ausführung der Erfindung für den Fall eines differentiellen Eingangs. Diese Ausführung entspricht genau der Ausführung eines ADC nach Fig. 18 und Fig. 23.

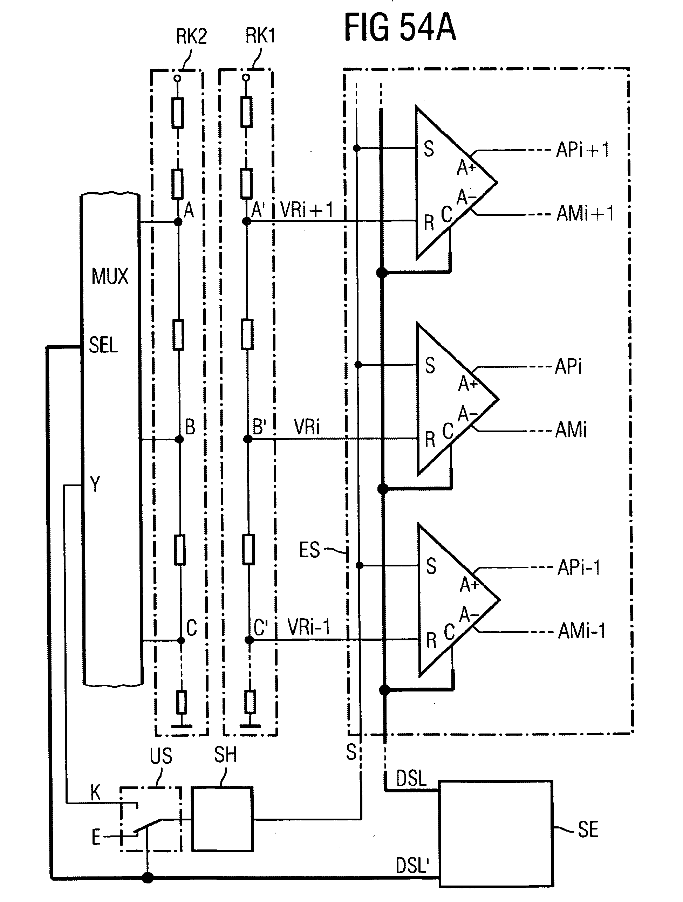

Figur 54a zeigt eine Anordnung mit zwei Referenzspannungsteilerketten, nämlich
- einer relativ hochohmigen Referenzspannungsteilerkette (RK2) aus nicht salizidiertem Polysilizium, mit der sich mit geringem Flächenaufwand in der Praxis Genauigkeiten um 12 Bit erreichen lassen, und
- einer niederohmigen Referenzspannungsteilerkette (RK1) aus salizidiertem Polysilizium oder Metall, die zwar ungenauer ist, aber die erforderlichen kleinen Zeitkonstanten der Eingangsstufe ermöglicht.

Werden während der Kalibration die Referenzpotentiale aus der hochohmigen, genauen Referenzspannungsteilerkette entnommen, können die Fehler der niederohmigen, ungenauen Referenzspannungsteilerkette mit herauskalibriert werden. Ebenso wie die Fehler der Sample-und-Hold-Stufe.

In Figur 54a ist diese Variante für Differenzverstärker mit singulärem Eingang dargestellt. RK1 ist die niederohmige, ungenauere Referenzspannungsteilerkette, die die Referenzpotentiale VRi+1, VRi, VRi-1 für die Eingangsstufe des ADC liefert. RK2 ist die hochohmige, genauere Referenzspannungsteilerkette, die die Referenzpotentiale an den Multiplexer MUX liefert, die während der Kalibration verwendet werden. Das Potential am Knoten A ist dabei im wesentlichen gleich dem Potential am Knoten A', nur ist das Potential an A eben das genauere und dient als Referenzpotential während des Kalibrationsvorgangs. Ebenso ist das Potential an Knoten B im wesentlichen gleich dem Potential an B', C and C', usw.

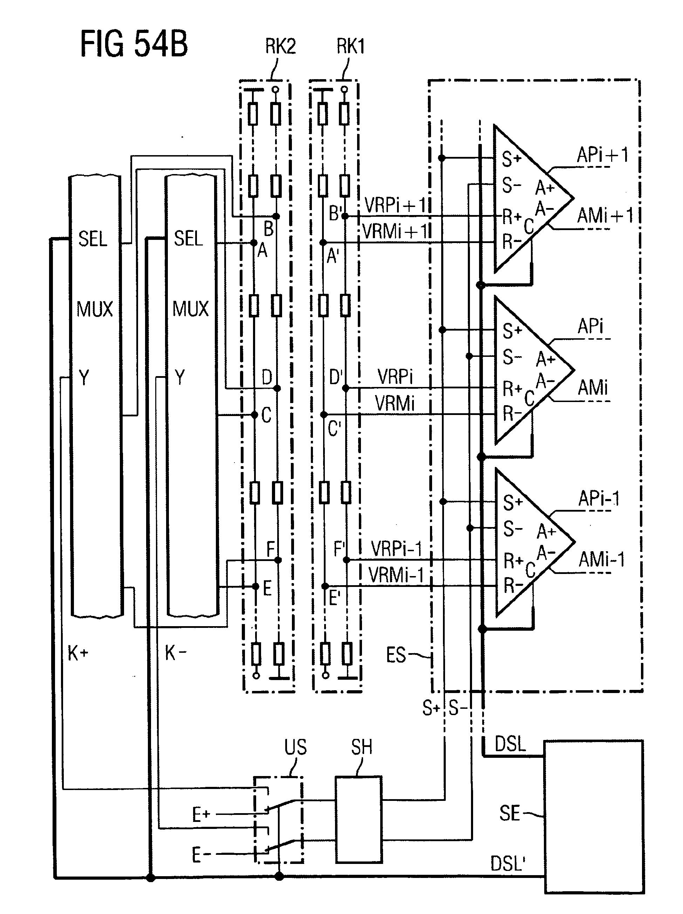

In Figur 54b ist diese Variante für Differenzverstärker mit differentiellem Eingang dargestellt.

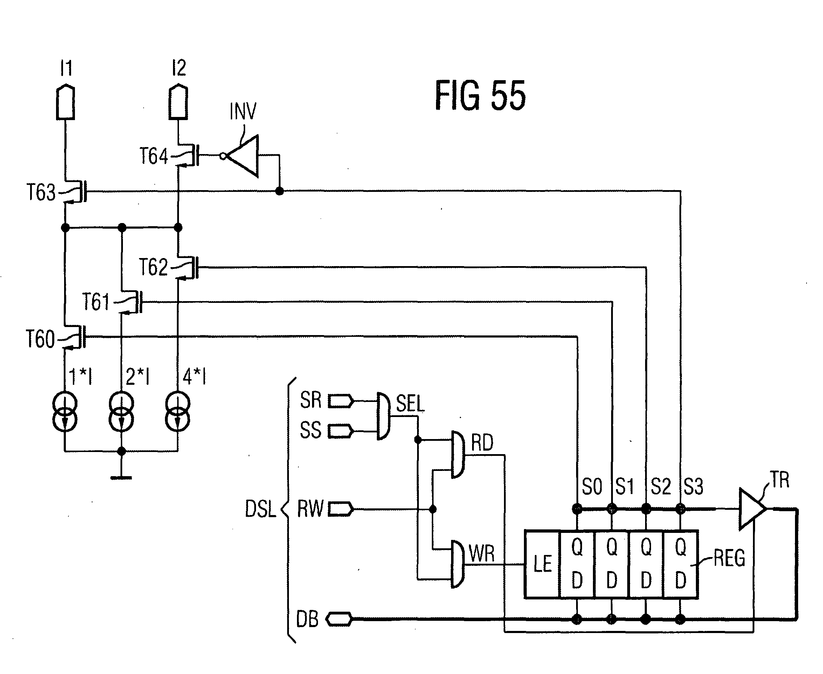

Figur 55 zeigt der Vollständigkeit halber nochmals eine mögliche schaltungstechnische Realisierung für das Mittel zur Stellung der Offsetspannung in Block OSS der Figur 52. Es handelt sich um die bevorzugte Variante einer digitalen Speicherung der Stellwerte.

Diese werden hier in einem 4 Bit umfassenden Register REG abgelegt, welches über einen Datenbus DB gelesen und beschrieben werden kann. Zwei Selektionssignale SR und SS, für Reihen und Spalten in einer Matrix, erzeugen das Signal SEL für die jeweiligen Differenzverstärker, die vorzugsweise in einer Matrix angeordnet ist. Ein Schreib/Lesesteuerungssignal RW, (Lesen bei RW = 1 und Schreiben bei RW = 0) ist mit dem Signal SEL so verknüpft, daß ein Lesesignal WR und ein Schreibsignal RD entsteht. Das Lesesignal RD schaltet die Ausgänge des Registers SO, SI, S2, S3 über einen Bustreiber TR auf den Datenbus DB auf. Das Schreibsignal steuert den Eingang LE des Registers, "Latch Enable", welches vorzugsweise als D-Latch ausgeführt ist. Die Steuersignale SR, SS, RW und der Datenbus DB sind auf den höheren Schaltungsebenen (siehe Figuren 51a, 51b, 52, 53a, 53b, 54a, 54b) zu den Steuer- und Datenleitungen DSL zusammengefaßt. Über diese kann die Steuereinheit SE einen Differenzverstärker auswählen und den Stellwert im Register lesen und schreiben.

Der analoge Schaltungsteil des Mittels besteht hier aus gewichteten Stromquellen 1*I, 2*I, 4*I, die über als Schalter wirkende n-Kanal-MOS-Transistoren T60, T61, T62, deren Gates an den Ausgängen SO, S1, S2 angeschlossen sind, kombiniert werden können. Auf diese Weise ist hier das Stellen von 8 unterschiedlichen Stromstufen möglich. Ein Inverter INV und zwei weitere als Schalter wirkende Transistoren T63, T64 erlauben es, unter Kontrolle durch den Registerausgang S4, den Strom wahlweise aus der Klemme I1 oder der Klemme I2 abzuleiten. Dies bewirkt die Verschiebung des Gleichgewichtszustands des Differenzverstärkers.

Durch die vorstehend beschriebenen Vorrichtungen und Verfahren können Fehler der Sample-und-Hold Stufe von ADCs, und in einer Untervariante auch Fehler von niederohmigen Referenzspannungsteilerketten des ADC dadurch wegkalibriert werden, daß die Offsetfehler von Differenzverstärkern der Eingangsstufe des ADC derartig gestellt werden, daß diese die Fehler der Sample-und-Hold-Verstärker und/oder der niederohmigen Referenzspannungsteilerkette kompensieren. Hierzu sind vor allem die vorstehend (Figuren 1 bis 40) beschriebenen Vorrichtungen und Verfahren geeignet, durch welche die Offsetfehler der Differenzverstärker stellbar gemacht und anhand einer Gleichgewichtsbedingung an ihren Ausgängen auf einen Sollwert kalibriert werden können. Es können aber auch viele andere Offsetkompensationsverfahren verwendet werden, beispielsweise Autozeroschleifen.

Durch die beschriebenen Vorrichtungen und die beschriebenen Verfahren lassen sich die Kalibrierung von Verstärkerstufen und die Kompensierung von Fehlern in Verstärkerstufen vorgeschalteten Komponenten auf verblüffend einfache Weise schnell und genau durchführen.

### Literatur

[1] R. E. J. van de Grift, I. W. J. M. Rutten, M. van der Veen, "An 8-bit Video ADC Incorporating Folding and Interpolation Techniques", IEEE Journal of Solid State Circuits, Vol. SC-22, No. 6, December 1987, pp. 944-953
[2] B. Nauta, A. G. W. Venes, "A 70-MS/s 110-mW 8-b CMOS Folding and Interpolating A/D Converter", IEEE Journal of Solid State Circuits, Vol.30, No. 12, December 1995, pp. 1302-1308
[3] K. Bult, A. Buchwald, J. Laskowski, "A 170mW 10b 50Msample/s CMOS ADC in 1 mm2", IEEE International Solid State Circuits Conference ISSCC 1997, paper 8.3
[4] K. Bult, U.S. Pat. 5835048
[5] K. Kattman, J. Barrow, "A Technique for Reducing Differential Non-Linearity Errors in Flash A/D Converters", IEEE International Solid State Circuits Conference ISSCC 1991, Digest of Technical Papers, pp. 170-171, February 1991
[6] U.S. Pat. 5955978
[7] U.S. Pat. 4947168
[8] U.S. Pat. 5047772
[9] U.S. Pat. 5784016
[10] U.S. Pat. 4983969
[11] P. Vorenkamp, R. Roovers, "A 12-b, 60-Msample/s Cascaded Folding and Interpolating ADC", IEEE Journal of Solid State Circuits, Vol.32, No. 12, December 1997, pp. 1876-1886
[12] M. Dwarakanath, D. Marsh, "Operational Amplifier with Offset Compensation", US Pat. 4306196
[13] E. Vittoz, H. Oguey, "Amplifier with Input Drift Voltage Compensation", US Pat. 4628274
[14] P. Ferguson, G. Burra, M. Mueck",Calibrating the DC Offset of Amplifiers", US Pat. 5789974
[15] M.-J. Choe, B.-S. Song, K. Bacrania",A 13b 40 Msample/s CMOS Pipelined Folding ADC with Background Offset Trimming", 2000 IEEE International Solid-State Circuits Conference, Paper MP 2.2
[16] A.Venes, R.van de Plassche",An 80-Mhz, 80-mW, 8-b CMOS Folding A/D Converter with Distributed Track-and-Hold Preprocessing", IEEE Journal of Solid-State Circuits, Vol. 31, No. 12, December 1996
[17] M. Pelgrom, M. Roorda, "An Algorithmic 15-bit CMOS Digital-to-Analog Converter", IEEE Journal of Solid State Circuits, Vol. 23, No. 6, December 1988, pp. 1402
[18] T-H. Shu, K. Bacrania, R. Gokhale, "A 10b 40-Msampe/s BICMOS A/D Converter", IEEE Journal of Solid State Circuits, Vol. 31, No. 10, October 1996, pp. 1507
[19] K. Nagaraj, et al., "A 700Msample/s 6b Read Channel A/D Converter with 7b Servo Mode", IEEE International Solid State Circuits Conference ISSCC2000, Paper WP26.1
[20] K. Nagaraj, "MOS Sample and Hold Circuit", US.Pat. 6052000

## Patentansprüche

1. Vorrichtung zur Kompensation von Fehlern in einer Referenzspannung (VRx), die an einen ersten Eingangsanschluß (R) eines den ersten Eingangsanschluß und einen zweiten Eingangsanschluß (S) aufweisenden Differenzverstärkers angelegt wird, **gekennzeichnet durch**
- Mittel (KSG, US; KSH) zur Erzeugung eines Kalibrationssignals, das keine oder nur vernachlässigbar geringe Abweichungen von der Größe und/oder von dem Verlauf aufweist, die bzw. den die Referenzspannung (VRx) aufweisen sollte, und Anlegen desselben an den zweiten Eingangsanschluß (S) des Differenzverstärkers, und
- eine Vorrichtung (SE) zu einer Kalibrierung des Differenzverstärkers, **durch** welche bei am ersten Eingangsanschluß (R) anliegender Referenzspannung (VRx) und bei am zweiten Eingangsanschluß (S) anliegendem Kalibrationssignal die Offsetspannung des Differenzverstärkers so gestellt wird, daß sich am Ausgang des Differenzverstärkers ein Gleichgewichtszustand einstellt.

2. Vorrichtung nach Anspruch 1,
**dadurch gekennzeichnet,**
**daß** die an den ersten Eingangsanschluß (R) angelegte Referenzspannung (VRx) und das an den zweiten Eingangsanschluß (S) angelegte Kalibrationssignal durch verschiedene Einrichtungen erzeugt werden.

3. Vorrichtung nach einem der vorhergehenden Ansprüche,
**dadurch gekennzeichnet,**
**daß** das Kalibrationssignal durch eine abgewandelte, aber nach wie vor als Sample-und-Hold-Stufe verwendbare Sample-und-Hold-Stufe (SH) erzeugt wird.

4. Vorrichtung nach Anspruch 1 oder 2,
**dadurch gekennzeichnet,**
**daß** das Kalibrationssignal und die Referenzspannung (VRx) durch verschiedene Spannungsteiler erzeugt werden.

5. Verfahren zur Kompensation von Fehlern in einer Referenzspannung (VRx), die an einen ersten Eingangsanschluß (R) eines den ersten Eingangsanschluß und einen zweiten Eingangsanschluß (S) aufweisenden Differenzverstärkers angelegt wird,
**dadurch gekennzeichnet,**
- **daß** ein Kalibrationssignal, das keine oder nur vernachlässigbar geringe Abweichungen von der Größe und/oder von dem Verlauf aufweist, die bzw. den die Referenzspannung (VRx) aufweisen sollte, erzeugt und an den zweiten Eingangsanschluß (S) des Differenzverstärkers angelegt wird, und
- **daß** bei am ersten Eingangsanschluß (R) des Differenzverstärkers anliegender Referenzspannung (VRx) und bei am zweiten Eingangsanschluß (S) des Differenzverstärkers anliegendem Kalibrationssignal die Offsetspannung des Differenzverstärkers so gestellt wird, daß sich am Ausgang des Differenzverstärkers ein Gleichgewichtszustand einstellt.

6. Verfahren nach Anspruch 5,
**dadurch gekennzeichnet,**
**daß** die an den ersten Eingangsanschluß (R) angelegte Referenzspannung (VRx) und das an den zweiten Eingangsanschluß (S) angelegte Kalibrationssignal durch verschiedene Einrichtungen erzeugt werden.

7. Verfahren nach Anspruch 5 oder 6,
**dadurch gekennzeichnet,**
**daß** das Kalibrationssignal durch eine abgewandelte, aber nach wie vor als Sample-und-Hold-Stufe verwendbare Sample-und-Hold-Stufe (SH) erzeugt wird.

8. Verfahren nach Anspruch 5 oder 6,
**dadurch gekennzeichnet,**
**daß** das Kalibrationssignal und die Referenzspannung (VRx) durch verschiedene Spannungsteiler erzeugt werden.

9. Verfahren nach Anspruch 5,
**dadurch gekennzeichnet,**
**daß** zum Bringen des Differenzverstärkers in den Gleichgewichtszustand ein Verfahren zur Selbstkalibrierung einer Verstärkerstufe (Vx) verwendet wird, welches die Schritte
- Schaffen von für eine Kalibrierung der Verstärkerstufe zweckmäßigen Bedingungen,
- Vergleichen von von der Verstärkerstufe ausgegebene Signalen oder von innerhalb der Verstärkerstufe auftretenden elektrischen Größen miteinander oder mit zugeordneten Referenzwerten, und
- Verändern der zu kalibrierenden Eigenschaften der Verstärkerstufe in Abhängigkeit vom Ergebnis des Vergleichs
umfaßt.

10. Verfahren nach Anspruch 9,
**dadurch gekennzeichnet,**
**daß** die für die Kalibrierung zweckmäßigen Bedingungen Bedingungen sind, unter welchen die von der Verstärkerstufe (Vx) stammenden Signale, die miteinander oder mit den zugeordneten Referenzwerten zu vergleichen sind, ein Vergleichsergebnis bewirken, anhand dessen zweifelsfrei feststellbar ist, ob und/oder wie genau die Verstärkerstufe kalibriert ist.

11. Verfahren nach Anspruch 9 oder 10,
**dadurch gekennzeichnet,**
**daß** das Schaffen der für die Kalibrierung zweckmäßigen Bedingungen die Einstellung umfaßt, ob und gegebenenfalls welche Signale den Eingangsanschlüssen der zu kalibrierenden Verstärkerstufe (Vx) zugeführt werden.

12. Verfahren nach Anspruch 11,
**dadurch gekennzeichnet,**
**daß** die zu kalibrierende Verstärkerstufe (Vx) wenigstens einen Eingangsanschluß aufweist, und daß von den vorhandenen Eingangsanschlüssen wenigstens einem Eingangsanschluß eine Umschaltvorrichtung (9, 10, 11) vorgeschaltet ist, wobei der Umschaltvorrichtung verschiedene Signale zugeführt werden, und wobei durch die Umschaltvorrichtung bestimmbar ist, welches der ihr zugeführten Signale an die Eingangsanschlüsse der zu kalibrierenden Verstärkerstufe weitergeleitet wird.

13. Verfahren nach Anspruch 11 oder 12,
**dadurch gekennzeichnet,**
**daß** die zu kalibrierende Verstärkerstufe (Vx) wenigstens zwei Eingangsanschlüsse aufweist, und daß die vorhandenen Eingangsanschlüsse während der Kalibrierung der Verstärkerstufe zumindest teilweise miteinander verbunden werden.

14. Verfahren nach Anspruch 11,
**dadurch gekennzeichnet,**
**daß** das Schaffen der für die Kalibrierung zweckmäßigen Bedingungen unter Verwendung einer der zu kalibrierenden Verstärkerstufe (Vx) vorgeschalteten Verstärkerstufe erfolgt.

15. Verfahren nach einem der Ansprüche 9 bis 14,
**dadurch gekennzeichnet,**
**daß** das Schaffen der für die Kalibrierung zweckmäßigen Bedingungen eine Umkonfigurierung der zu kalibrierenden Verstärkerstufe (Vx) umfaßt.

16. Verfahren nach Anspruch 15,
**dadurch gekennzeichnet,**
**daß** das Schaffen der für die Kalibrierung zweckmäßigen Bedingungen eine Veränderung der Verschaltung der in der zu kalibrierenden Verstärkerstufe (Vx) enthaltenen Komponenten umfaßt.

17. Verfahren nach einem der Ansprüche 9 bis 16,
**dadurch gekennzeichnet,**
**daß** die Veränderung der zu kalibrierenden Eigenschaften der Verstärkerstufe (Vx) ein Hinzuschalten oder Wegschalten und/oder ein Aktivieren oder Deaktivieren und/oder ein Verändern der Eigenschaften von Elementen umfaßt, die mit innerhalb der Verstärkerstufe liegenden Stellen oder mit Ein- oder Ausgabeanschlüssen der Verstärkerstufe in Verbindung stehen oder in Verbindung gebracht werden können.

18. Verfahren nach einem der Ansprüche 9 bis 16,
**dadurch gekennzeichnet,**
**daß** die Veränderung der zu kalibrierenden Eigenschaften der Verstärkerstufe (Vx) eine Veränderung der Größe von innerhalb und/oder außerhalb der Verstärkerstufe fließenden Strömen umfaßt.

19. Verfahren nach einem der Ansprüche 9 bis 18,
**dadurch gekennzeichnet,**
**daß** die Veränderung der zu kalibrierenden Eigenschaften der Verstärkerstufe (Vx) eine Veränderung des zeitlichen Verlaufes von innerhalb und/oder außerhalb der Verstärkerstufe fließenden Strömen umfaßt.

20. Verfahren nach einem der Ansprüche 9 bis 19,
**dadurch gekennzeichnet,**
**daß** die Zuführung der von der Verstärkerstufe (Vx) ausgegebenen Signale und/oder der innerhalb der Verstärkerstufe auftretenden elektrischen Größen zu einer den Vergleich durchführenden Vergleichereinheit (6; 9, 10, VE, COMP) über dritte Mittel (18, US) erfolgt.

21. Verfahren nach Anspruch 20,
**dadurch gekennzeichnet,**
**daß** die dritten Mittel (18, US) eine oder mehrere Umschalteinrichtungen enthalten, durch welche festlegbar ist, ob und gegebenenfalls welche Signale der Vergleichereinheit (6; 9, 10, VE, COMP) zugeführt werden.

22. Verfahren nach Anspruch 20 oder 21,
**dadurch gekennzeichnet,**
**daß** zumindest Teile der dritten Mittel (18, US) durch eine oder mehrere Verstärkerstufen gebildet werden, die der zu kalibrierenden Verstärkerstufe (Vx) nachgeschaltet sind.

23. Verfahren nach einem der Ansprüche 20 bis 22,
**dadurch gekennzeichnet,**
**daß** Vorkehrungen getroffen werden, um die dritten Mittel (18, US) kalibrieren zu können.

24. Verfahren nach einem der Ansprüche 9 bis 23,
**dadurch gekennzeichnet,**
**daß** zum Schaffen von für die Kalibration geeigneten Bedingungen vorgesehene erste Mittel (9, 10, 11; 16a, US), zum Verändern der zu kalibrierenden Eigenschaften der Verstärkerstufe (Vx) vorgesehene zweite Mittel (13; 17a, 17b), und zur Auswahl und zur Zuführung der zu vergleichenden Werte vorgesehene dritte Mittel (18, US) durch eine Steuereinrichtung (20; 14) gesteuert werden.

25. Verfahren nach einem der Ansprüche 9 bis 24,
**dadurch gekennzeichnet,**
**daß** die Steuereinrichtung (20; 14) den ersten, zweiten und dritten Mitteln zugeordnete Speichereinrichtungen (3) beschreibt, und daß die ersten, zweiten und dritten Mittel abhängig vom Inhalt der ihnen zugeordneten Speichereinrichtungen (3) arbeiten.

26. Verfahren nach Anspruch 25,
**dadurch gekennzeichnet,**
**daß** Speichereinrichtungen (3) digitale Speichereinrichtungen sind.

27. Verfahren nach einem der Ansprüche 9 bis 26,
**dadurch gekennzeichnet,**
**daß** die zu kalibrierenden Eigenschaften der Verstärkerstufe (Vx) den Offset, den Verstärkungsfaktor, den Frequenzgang, und/oder den Phasengang der Verstärkerstufe umfassen.

28. Verfahren nach einen der Ansprüche 9 bis 27,
**dadurch gekennzeichnet,**
**daß** die zu kalibrierende Verstärkerstufe (Vx) eine Verstärkerstufe eines Analog/Digital-Wandlers ist.

29. Verfahren nach Anspruch 28,
**dadurch gekennzeichnet,**
**daß** der Analog/Digital-Wandler ein Folding-Analog/DigitalWandler ist.

30. Verfahren nach Anspruch 28,
**dadurch gekennzeichnet,**
**daß** der Analog/Digital-Wandler ein Flash-Analog/DigitalWandler ist.

31. Verfahren nach einem der Ansprüche 9 bis 30,
**dadurch gekennzeichnet,**
**daß** die zu kalibrierende Verstärkerstufe (Vx) ein Differenzverstärker ist.

32. Verfahren nach einem der Ansprüche 9 bis 31,
**dadurch gekennzeichnet,**
**daß** die zu kalibrierende Verstärkerstufe (Vx) eine Verstärkerstufe einer Gruppe von Verstärkerstufen ist.

33. Verfahren nach Anspruch 32,
**dadurch gekennzeichnet,**
**daß** die Gruppe von Verstärkerstufen eine Verstärkerstufen-Kette ist.

34. verfahren nach Anspruch 32,
**dadurch gekennzeichnet,**
**daß** die Gruppe von Verstärkerstufen ein Verstärkerstufen-Baum ist.

35. Verfahren nach einen der Ansprüche 32 bis 34,
**dadurch gekennzeichnet,**
**daß** für mehrere oder alle Verstärkerstufen (Vx) der Gruppe von Verstärkerstufen nur eine einzige Vergleichereinheit (6; 9, 10, VE, COMP) vorgesehen ist.

36. Verfahren nach einem der Ansprüche 32 bis 35,
**dadurch gekennzeichnet,**
**daß** die Verstärkerstufen (Vx) der Gruppe von Verstärkerstufen einzeln nacheinander kalibriert werden.

37. Verfahren nach Anspruch 36,
**dadurch gekennzeichnet,**
**daß** die Verstärkerstufen (Vx) der Gruppe von Verstärkerstufen der Reihe nach vom hinteren Ende des Baumes oder der Kette her kalibriert werden.

38. Verfahren nach einem der Ansprüche 9 bis 37,
**dadurch gekennzeichnet,**
**daß** bei der Kalibration einer Verstärkerstufe (Vx) mit der Kalibration einer in der Verstärkerstufe enthaltenen Stromquelle begonnen wird.

39. Verfahren nach Anspruch 20,
**dadurch gekennzeichnet,**
**daß** vor der Kalibrierung einer Verstärkerstufe (Vx) die als dritte Mittel verwendete Einrichtung kalibriert wird.

## Claims

1. Apparatus for compensating for errors in a reference voltage (VRx) which is applied to a first input connection (R) of a differential amplifier which has the first input connection and a second input connection (S),
**characterized by**
- means (KSG, US; KSH) for producing a calibration signal, which has no or only negligibly small differences from the magnitude and/or from the form which the reference voltage (VRx) should have, and applying said calibration signal to the second input connection (S) of the differential amplifier, and
- an apparatus (SE) for calibrating the differential amplifier, which apparatus, when a reference voltage (VRx) is applied to the first input connection (R) and when a calibration signal is applied to the second input connection (S), sets the offset voltage of the differential amplifier such that the output of the differential amplifier produces an equilibrium state.

2. Apparatus according to Claim 1,
**characterized**
**in that** the reference voltage (VRx) applied to the first input connection (R) and the calibration signal applied to the second input connection (S) are produced by different devices.

3. Apparatus according to one of the preceding claims,
**characterized**
**in that** the calibration signal is produced by a sample-and-hold stage (SH) which has been modified but which can continue to be used as a sample-and-hold stage.

4. Apparatus according to Claim 1 or 2,
**characterized**
**in that** the calibration signal and the reference voltage (VRx) are produced by different voltage dividers.

5. Method for compensating for errors in a reference voltage (VRx) which is applied to a first input connection (R) of a differential amplifier which has the first input connection and a second input connection (S),
**characterized**
- **in that** a calibration signal, which has no or only negligibly small differences from the magnitude and/or from the form which the reference voltage (VRx) is supposed to have, is produced and is applied to the second input connection (S) of the differential amplifier, and
- **in that**, when a reference voltage (VRx) is applied to the first input connection (R) of the differential amplifier and when a calibration signal is applied to the second input connection (S) of the differential amplifier, the offset voltage of the differential amplifier is set such that the output of the differential amplifier produces an equilibrium state.

6. Method according to Claim 5,
**characterized**
**in that** the reference voltage (VRx) applied to the first input connection (R) and the calibration signal applied to the second input connection (S) are produced by different devices.

7. Method according to Claim 5 or 6,
**characterized**
**in that** the calibration signal is produced by a sample-and-hold stage (SH) which has been modified but which can continue to be used as a sample-and-hold stage.

8. Method according to Claim 5 or 6,
**characterized**
**in that** the calibration signal and the reference voltage (VRx) are produced by different voltage dividers.

9. Method according to Claim 5,
**characterized**
**in that** the differential amplifier is put into the equilibrium state using a method for self-calibration of an amplifier stage (Vx) which comprises the steps of
- providing conditions which are expedient for calibration of the amplifier stage,
- comparing signals which are output by the amplifier stage or electrical variables which occur within the amplifier stage with one another or with associated reference values, and
- altering the properties of the amplifier stage which is to be calibrated on the basis of the result of the comparison.

10. Method according to Claim 9,
**characterized**
**in that** the conditions which are expedient for the calibration are conditions under which the signals originating from the amplifier stage (Vx) which need to be compared with one another or with the associated reference values bring about a comparison result which can be used to establish beyond doubt whether and/or how accurately the amplifier stage is calibrated.

11. Method according to Claim 9 or 10,
**characterized**
**in that** the provision of the conditions which are expedient for the calibration involves setting whether and possibly which signals are supplied to the input connections of the amplifier stage (Vx) which is to be calibrated.

12. Method according to Claim 11,
**characterized**
**in that** the amplifier stage (Vx) which is to be calibrated has at least one input connection, and in that at least one input connection from the available input connections has a changeover apparatus (9, 10, 11) connected upstream of it, wherein the changeover apparatus is supplied with different signals, and wherein the changeover apparatus can determine which of the signals supplied to it is forwarded to the input connections of the amplifier stage which is to be calibrated.

13. Method according to Claim 11 or 12,
**characterized**
**in that** the amplifier stage (Vx) which is to be calibrated has at least two input connections, and in that at least some of the available input connections are connected to one another during the calibration of the amplifier stage.

14. Method according to Claim 11,
**characterized**
**in that** the conditions which are expedient for the calibration are provided using an amplifier stage which is connected upstream of the amplifier stage (Vx) which is to be calibrated.

15. Method according to one of Claims 9 to 14,
**characterized**
**in that** the provision of the conditions which are expedient for the calibration involves reconfiguration of the amplifier stage (Vx) which is to be calibrated.

16. Method according to Claim 15,
**characterized**
**in that** the provision of the conditions which are expedient for the calibration involves alteration of the interconnection of the components contained in the amplifier stage (Vx) which is to be calibrated.

17. Method according to one of Claims 9 to 16,
**characterized**
**in that** the alteration of the properties of the amplifier stage (Vx) which is to be calibrated involves addition or removal and/or activation or deactivation and/or alteration of the properties of elements which are connected or can be connected to positions situated within the amplifier stage or to input or output connections of the amplifier stage.

18. Method according to one of Claims 9 to 16,
**characterized**
**in that** the alteration of the properties of the amplifier stage (Vx) which is to be calibrated involves alteration of the magnitude of currents flowing inside and/or outside the amplifier stage.

19. Method according to one of Claims 9 to 18,
**characterized**
**in that** the alteration of the properties of the amplifier stage (Vx) which is to be calibrated involves alteration of the wave form of currents flowing inside and/or outside the amplifier stage.

20. Method according to one of Claims 9 to 19,
**characterized**
**in that** the signals which are output by the amplifier stage (Vx) and/or the electrical variables which occur within the amplifier stage are supplied to a comparator unit (6; 9, 10 VE, COMP) performing the comparison by a third means (18, US).

21. Method according to Claim 20,
**characterized**
**in that** the third means (18, US) contain one or more changeover devices which can stipulate whether and possibly which signals are supplied to the comparator unit (6; 9, 10, VE, COMP).

22. Method according to Claim 20 or 21,
**characterized**
**in that** at least portions of the third means (18, US) are formed by one or more amplifier stages which are connected downstream of the amplifier stage (Vx) which is to be calibrated.

23. Method according to one of Claims 20 to 22,
**characterized**
**in that** provisions are made to allow the third means (18, US) to be calibrated.

24. Method according to one of Claims 9 to 23,
**characterized**
**in that** first means (9, 10, 11; 16a, US) provided for providing conditions which are suitable for the calibration, second means (13; 17a, 17b) provided for altering the properties of the amplifier stage (Vx) which is to be calibrated, and third means (18, US) provided for selecting and supplying the values which are to be compared are controlled by a control device (20; 14).

25. Method according to one of Claims 9 to 24,
**characterized**
**in that** the control device (20; 14) writes to memory devices (3) associated with the first, second and third means, and in that the first, second and third means operate on the basis of the content of their associated memory devices (3).

26. Method according to Claim 25,
**characterized**
**in that** memory devices (3) are digital memory devices.

27. Method according to one of Claims 9 to 26,
**characterized**
**in that** the properties of the amplifier stage (Vx) which is to be calibrated comprise the offset, the gain factor, the frequency response and/or the phase response of the amplifier stage.

28. Method according to one of Claims 9 to 27,
**characterized**
**in that** the amplifier stage (Vx) which is to be calibrated is an amplifier stage of an analogue/digital converter.

29. Method according to Claim 28,
**characterized**
**in that** the analogue/digital converter is a folding analogue/digital converter.

30. Method according to Claim 28,
**characterized**
**in that** the analogue/digital converter is a flash analogue/digital converter.

31. Method according to one of Claims 9 to 30,
**characterized**
**in that** the amplifier stage (Vx) which is to be calibrated is a differential amplifier.

32. Method according to one of Claims 9 to 31,
**characterized**
**in that** the amplifier stage (Vx) which is to be calibrated is an amplifier stage from a group of amplifier stages.

33. Method according to Claim 32,
**characterized**
**in that** the group of amplifier stages is an amplifier stage line.

34. Method according to Claim 32,
**characterized**
**in that** the group of amplifier stages is an amplifier stage tree.

35. Method according to one of Claims 32 to 34,
**characterized**
**in that** only a single comparator unit (6; 9, 10, VE, COMP) is provided for a plurality of or all amplifier stages (Vx) from the group of amplifier stages.

36. Method according to one of Claims 32 to 35,
**characterized**
**in that** the amplifier stages (Vx) from the group of amplifier stages are calibrated individually in succession.

37. Method according to Claim 36,
**characterized**
**in that** the amplifier stages (Vx) from the group of amplifier stages are calibrated in order from the rear end of the tree or the line.

38. Method according to one of Claims 9 to 37,
**characterized**
**in that** the calibration of an amplifier stage (Vx) starts with the calibration of a current source contained in the amplifier stage.

39. Method according to Claim 20,
**characterized**
**in that** the device used as third means is calibrated before an amplifier stage (Vx) is calibrated.

## Revendications

1. Dispositif de compensation des défauts dans une tension de référence (VRx) qui est appliquée à une première borne d'entrée (R) d'un amplificateur différentiel qui présente la première borne d'entrée et une deuxième borne d'entrée (S), **caractérisé par**
- des moyens (KSG, US ; KSH) pour générer un signal de calibrage qui ne présente aucun écart, ou seulement des écarts négligemment faibles, par rapport à la grandeur et/ou au tracé que devrait présenter la tension de référence (VRx), et pour appliquer celui-ci à la deuxième borne d'entrée (S) de l'amplificateur différentiel, et
- un dispositif (SE) pour effectuer un calibrage de l'amplificateur différentiel, par le biais duquel la tension d'offset de l'amplificateur différentiel, avec la tension de référence (VRx) appliquée à la première borne d'entrée (R) et avec le signal de calibrage appliqué à la deuxième borne d'entrée (S), est réglée de manière à obtenir un état d'équilibre à la sortie de l'amplificateur différentiel.

2. Dispositif selon la revendication 1, **caractérisé en ce que** la tension de référence (VRx) appliquée à la première borne d'entrée (R) et le signal de calibrage appliqué à la deuxième borne d'entrée (S) sont générés par des dispositifs différents.

3. Dispositif selon l'une des revendications précédentes, **caractérisé en ce que** le signal de calibrage est généré par un étage échantillonneur-bloqueur (SH) modifié, mais toujours utilisable comme étage échantillonneur-bloqueur.

4. Dispositif selon la revendication 1 ou 2, **caractérisé en ce que** le signal de calibrage et la tension de référence (VRx) sont générés par des diviseurs de tension différents.

5. Procédé de compensation des défauts dans une tension de référence (VRx) qui est appliquée à une première borne d'entrée (R) d'un amplificateur différentiel qui présente la première borne d'entrée et une deuxième borne d'entrée (S), **caractérisé en ce**
- **qu'**un signal de calibrage qui ne présente aucun écart, ou seulement des écarts négligemment faibles, par rapport à la grandeur et/ou au tracé que devrait présenter la tension de référence (VRx) est généré et appliqué à la deuxième borne d'entrée (S) de l'amplificateur différentiel, et
- **que** la tension d'offset de l'amplificateur différentiel, avec la tension de référence (VRx) appliquée à la première borne d'entrée (R) de l'amplificateur différentiel et avec le signal de calibrage appliqué à la deuxième borne d'entrée (S) de l'amplificateur différentiel, est réglée de manière à obtenir un état d'équilibre à la sortie de l'amplificateur différentiel.

6. Procédé selon la revendication 5, **caractérisé en ce que** la tension de référence (VRx) appliquée à la première borne d'entrée (R) et le signal de calibrage appliqué à la deuxième borne d'entrée (S) sont générés par des dispositifs différents.

7. Procédé selon la revendication 5 ou 6, **caractérisé en ce que** le signal de calibrage est généré par un étage échantillonneur-bloqueur (SH) modifié, mais toujours utilisable comme étage échantillonneur-bloqueur.

8. Procédé selon la revendication 5 ou 6, **caractérisé en ce que** le signal de calibrage et la tension de référence (VRx) sont générés par des diviseurs de tension différents.

9. Procédé selon la revendication 5, **caractérisé en ce que** l'amplificateur différentiel est amené à l'état d'équilibre en utilisant un procédé d'auto-calibrage d'un étage amplificateur (Vx) qui comprend les étapes suivantes :
- Réalisation des conditions appropriées pour un calibrage de l'étage amplificateur,
- Comparaison des signaux délivrés par l'étage amplificateur ou des grandeurs électriques produites à l'intérieur de l'étage amplificateur entre eux ou avec des valeurs de référence associées, et
- Modification des caractéristiques de calibrage de l'étage amplificateur en fonction du résultat de la comparaison.

10. Procédé selon la revendication 9, **caractérisé en ce que** les conditions appropriées pour le calibrage sont des conditions sous lesquelles les signaux émanant de l'étage amplificateur (Vx), lesquels sont à comparer entre eux ou avec les valeurs de référence associées, produisent un résultat de comparaison au moyen duquel il est possible de déterminer de manière certaine si et/ou avec quelle précision l'étage amplificateur est calibré.

11. Procédé selon la revendication 9 ou 10, **caractérisé en ce que** la réalisation des conditions appropriées pour le calibrage comprend le réglage de l'acheminement ou non, et le cas échéant de quels signaux aux bornes d'entrée de l'étage amplificateur (Vx) à calibrer.

12. Procédé selon la revendication 11, **caractérisé en ce que** l'étage amplificateur (Vx) à calibrer présente au moins une borne d'entrée et qu'un dispositif d'inversion (9, 10, 11) est branché avant au moins une borne d'entrée parmi les bornes d'entrée présentes, des signaux différents étant acheminés au dispositif d'inversion et le dispositif d'inversion permettant de déterminer lequel des signaux qui lui sont acheminés est transmis aux bornes d'entrée de l'étage amplificateur à calibrer.

13. Procédé selon la revendication 11 ou 12, **caractérisé en ce que** l'étage amplificateur (Vx) à calibrer présente au moins deux bornes d'entrée et que les bornes d'entrée présentes sont au moins partiellement reliées entre elles pendant le calibrage de l'étage amplificateur.

14. Procédé selon la revendication 11, **caractérisé en ce que** la réalisation des conditions appropriées pour le calibrage s'effectue en utilisant un étage amplificateur branché avant l'étage amplificateur (Vx) à calibrer.

15. Procédé selon l'une des revendications 9 à 14, **caractérisé en ce que** la réalisation des conditions appropriées pour le calibrage comprend une reconfiguration de l'étage amplificateur (Vx) à calibrer.

16. Procédé selon la revendication 15, **caractérisé en ce que** la réalisation des conditions appropriées pour le calibrage comprend une modification de la connexion des composants qui se trouvent dans l'étage amplificateur (Vx) à calibrer.

17. Procédé selon l'une des revendications 9 à 16, **caractérisé en ce que** la modification des caractéristiques à calibrer de l'étage amplificateur (Vx) comprend un rattachement ou une déconnexion et/ou une activation ou une désactivation et/ou une modification des caractéristiques des éléments qui sont en liaison ou qui peuvent être amenés en liaison avec des points qui se trouvent à l'intérieur de l'étage amplificateur ou avec des bornes d'entrée ou de sortie de l'étage amplificateur.

18. Procédé selon l'une des revendications 9 à 16, **caractérisé en ce que** la modification des caractéristiques à calibrer de l'étage amplificateur (Vx) comprend une modification de la grandeur des courants qui circulent à l'intérieur et/ou à l'extérieur de l'étage amplificateur.

19. Procédé selon l'une des revendications 9 à 18, **caractérisé en ce que** la modification des caractéristiques à calibrer de l'étage amplificateur (Vx) comprend une modification du tracé dans le temps des courants qui circulent à l'intérieur et/ou à l'extérieur de l'étage amplificateur.

20. Procédé selon l'une des revendications 9 à 19, **caractérisé en ce que** l'acheminement des signaux délivrés par l'étage amplificateur (Vx) et/ou des grandeurs électriques produites à l'intérieur de l'étage amplificateur à une unité de comparaison (6 ; 9, 10, VE, COMP) qui réalise la comparaison s'effectue par le biais de troisièmes moyens (18, US).

21. Procédé selon la revendication 20, **caractérisé en ce que** les troisièmes moyens (18, US) contiennent un ou plusieurs dispositifs d'inversion qui permettent de définir si des signaux, et le cas échéant lesquels sont acheminés à l'unité de comparaison (6 ; 9, 10, VE, COMP).

22. Procédé selon la revendication 20 ou 21, **caractérisé en ce qu'**au moins des parties des troisièmes moyens (18, US) sont formées par un ou plusieurs étages amplificateurs qui sont branchés après l'étage amplificateur (Vx) à calibrer.

23. Procédé selon l'une des revendications 20 à 22, **caractérisé en ce que** des dispositions sont prises pour pouvoir calibrer les troisièmes moyens (18, US).

24. Procédé selon l'une des revendications 9 à 23, **caractérisé en ce que** les premiers moyens (9, 10, 11 ; 16a, US) prévus pour la réalisation des conditions appropriées pour le calibrage, les deuxièmes moyens (13 ; 17a, 17b) prévus pour modifier les propriétés à calibrer de l'étage amplificateur (Vx) et les troisièmes moyens (18, US) prévus pour sélectionner et pour acheminer les valeurs à comparer sont commandés par un dispositif de commande (20 ; 14).

25. Procédé selon l'une des revendications 9 à 24, **caractérisé en ce que** le dispositif de commande (20 ; 14) écrit dans des dispositifs de mémorisation (3) associés aux premiers, deuxièmes et troisièmes moyens et que les premiers, deuxièmes et troisièmes moyens fonctionnent en fonction du contenu des dispositifs de mémorisation (3) qui leurs sont associés.

26. Procédé selon la revendication 25, **caractérisé en ce que** les dispositifs de mémorisation (3) sont des dispositifs de mémorisation numériques.

27. Procédé selon l'une des revendications 9 à 26, **caractérisé en ce que** les caractéristiques à calibrer de l'étage amplificateur (Vx) comprennent l'offset, le facteur d'amplification, la réponse en fréquence et/ou l'alignement de phase de l'étage amplificateur.

28. Procédé selon l'une des revendications 9 à 27, **caractérisé en ce que** l'étage amplificateur (Vx) à calibrer est un étage amplificateur d'un convertisseur analogique/numérique.

29. Procédé selon la revendication 28, **caractérisé en ce que** le convertisseur analogique/numérique est un convertisseur analogique/numérique à pliage.

30. Procédé selon la revendication 28, **caractérisé en ce que** le convertisseur analogique/numérique est un convertisseur analogique/numérique flash.

31. Procédé selon l'une des revendications 9 à 30, **caractérisé en ce que** l'étage amplificateur (Vx) à calibrer est un amplificateur différentiel.

32. Procédé selon l'une des revendications 9 à 31, **caractérisé en ce que** l'étage amplificateur (Vx) à calibrer est un étage amplificateur d'un groupe d'étages amplificateurs.

33. Procédé selon la revendication 32, **caractérisé en ce que** le groupe d'étages amplificateurs est une chaîne d'étages amplificateurs.

34. Procédé selon la revendication 32, **caractérisé en ce que** le groupe d'étages amplificateurs est une arborescence d'étages amplificateurs.

35. Procédé selon l'une des revendications 32 à 34, **caractérisé en ce qu'**une seule unité de comparaison (6 ; 9, 10, VE, COMP) est prévue pour plusieurs ou la totalité des étages amplificateurs (Vx) du groupe d'étages amplificateurs.

36. Procédé selon l'une des revendications 32 à 35, **caractérisé en ce que** les étages amplificateurs (Vx) du groupe d'étages amplificateurs sont calibrés individuellement les uns après les autres.

37. Procédé selon la revendication 36, **caractérisé en ce que** les étages amplificateurs (Vx) du groupe d'étages amplificateurs sont calibrés dans l'ordre en commençant par l'arrière de l'arborescence ou de la chaîne.

38. Procédé selon l'une des revendications 9 à 37, **caractérisé en ce que** le calibrage d'un étage amplificateur (Vx) commence par le calibrage d'une source de courant qui se trouve dans l'étage amplificateur.

39. Procédé selon la revendication 20, **caractérisé en ce que** le dispositif utilisé comme troisièmes moyens est calibré avant le calibrage d'un étage amplificateur (Vx).
